# EUROPEAN PATENT APPLICATION

(11) **EP 4 614 574 A1**
(43) Date of publication of application: **10.09.2025**
(21) Application number: 23885849.2
(22) Date of filing: 02.11.2023
(51) Int. Cl.: H01L 27/146, H04N 25/70, H04N 25/771

(54) **IMAGING ELEMENT AND ELECTRONIC DEVICE**

(30) Priority: 02.11.2022 JP 2022176008
(71) Applicant: Sony Semiconductor Solutions Corporation, Atsugi-shi, Kanagawa 243-0014 (JP)
(72) Inventor: ASAYAMA, Shinobu, Atsugi-shi, Kanagawa 243-0014 (JP); NARAMURA, Takuro, Atsugi-shi, Kanagawa 243-0014 (JP); FUKUI, Ryo, Atsugi-shi, Kanagawa 243-0014 (JP); ITO, Tomomi, Atsugi-shi, Kanagawa 243-0014 (JP); UCHIDA, Tetsuya, Atsugi-shi, Kanagawa 243-0014 (JP); KAWAMURA, Tomohiko, Atsugi-shi, Kanagawa 243-0014 (JP); UESAKA, Yusuke, Atsugi-shi, Kanagawa 243-0014 (JP); YAGAMI, Takanori, Atsugi-shi, Kanagawa 243-0014 (JP); NISHIMURA, Yutaka, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/039586
(87) International publication number: WO 2024/096095

(57) **Abstract**

The present technology relates to an imaging element and electronic equipment which allow suppression of the occurrence of a white spot or a dark current.

An imaging element includes a photoelectric conversion portion which converts light to charge, an accumulation portion which temporarily accumulates the charge, and a transfer portion which transfers charge to the accumulation portion. The imaging element includes also an inter-pixel isolation portion which establishes isolation between pixels, an element isolation portion which isolates elements, and a plurality of transistors disposed to surround the transfer portion in plan view. In plan view, in each of the plurality of transistors, a region in which at least one side overlaps with the inter-pixel isolation portion exists and a side opposite the one side includes a region overlapping with the element isolation portion. The present technology can be applied to, for example, an imaging element having a plurality of accumulation portions.

## Description

### [Technical Field]

The present technology relates to an imaging element and electronic equipment and relates to, for example, an imaging element and electronic equipment configured to allow achievement of an image with higher quality.

### [Background Art]

In general, imaging elements such as a CMOS (Complementary Metal Oxide Semiconductor) image sensor and a CCD (Charge Coupled Device) are widely used for digital still cameras, digital video cameras, and the like. Improvement in characteristics of the imaging elements is desired and, for example, enlargement of the dynamic range is desired. PTL 1 has proposed enlarging the dynamic range by inclusion of a plurality of accumulation capacitive elements which accumulate charge which has overflowed from a photodiode.

Further, an imaging element (image sensor) including a mechanism which switches the conversion efficiency of floating diffusion (FD) disposed in each pixel has been proposed (refer to PTL 2). In a technology according to PTL 2, on the basis of a general CMOS (Complementary Metal Oxide Semiconductor) image sensor, a gate which switches first FD and second FD with higher capacitance than the first FD is disposed. Moreover, PTL 2 includes a description regarding the following. In the case of switching to high conversion efficiency, the gate is turned OFF to minimize the parasitic capacitance to the first FD. In contrast, in the case of switching to low conversion efficiency, the gate is turned ON and the first FD and the second FD are connected to maximize the parasitic capacitance.

### [Citation List]

### [Patent Literature]

[PTL 1]
   JP 2006-245522A
[PTL 2]
   JP 2014-112580A

### [Summary]

### [Technical Problem]

In recent years, miniaturization of pixels has been advanced. Thus, a region in which transistors configuring one pixel are disposed has also become small, and it has been becoming difficult to dispose the transistors with sizes with which characteristics of the transistors can be sufficiently obtained.

The present technology is made in view of such a situation and allows miniaturization of pixels without lowering of characteristics of transistors.

### [Solution to Problem]

An imaging element of an aspect of the present technology is an imaging element including a photoelectric conversion portion that converts light to charge, an accumulation portion that temporarily accumulates the charge, and a transfer portion that transfers charge to the accumulation portion. The imaging element includes also an inter-pixel isolation portion that establishes isolation between pixels, an element isolation portion that isolates elements, and a plurality of transistors disposed to surround the transfer portion in plan view. In plan view, in each of the plurality of transistors, a region in which at least one side overlaps with the inter-pixel isolation portion exists and a side opposite the one side includes a region overlapping with the element isolation portion.

Electronic equipment of an aspect of the present technology is electronic equipment including an imaging element. The imaging element includes a photoelectric conversion portion that converts light to charge, an accumulation portion that temporarily accumulates the charge, and a transfer portion that transfers charge to the accumulation portion. The imaging element includes also an inter-pixel isolation portion that establishes isolation between pixels, an element isolation portion that isolates elements, and a plurality of transistors disposed to surround the transfer portion in plan view. In plan view, in each of the plurality of transistors, a region in which at least one side overlaps with the inter-pixel isolation portion exists and a side opposite the one side includes a region overlapping with the element isolation portion. The electronic equipment includes also a processing section that processes a signal from the imaging element.

The imaging element of the aspect of the present technology includes the photoelectric conversion portion which converts light to charge, the accumulation portion which temporarily accumulates the charge, and the transfer portion which transfers charge to the accumulation portion. The imaging element includes also the inter-pixel isolation portion which establishes isolation between pixels, the element isolation portion which isolates elements, and the plurality of transistors disposed to surround the transfer portion in plan view. In the imaging element, in plan view, in each of the plurality of transistors, the region in which at least one side overlaps with the inter-pixel isolation portion exists and the side opposite the one side includes the region overlapping with the element isolation portion.

In the electronic equipment of the aspect of the present technology, the imaging element is included.

It is to be noted that an electronic apparatus may be an independent apparatus or be an internal block included in one apparatus.

### [Brief Description of Drawings]

[FIG. 1]

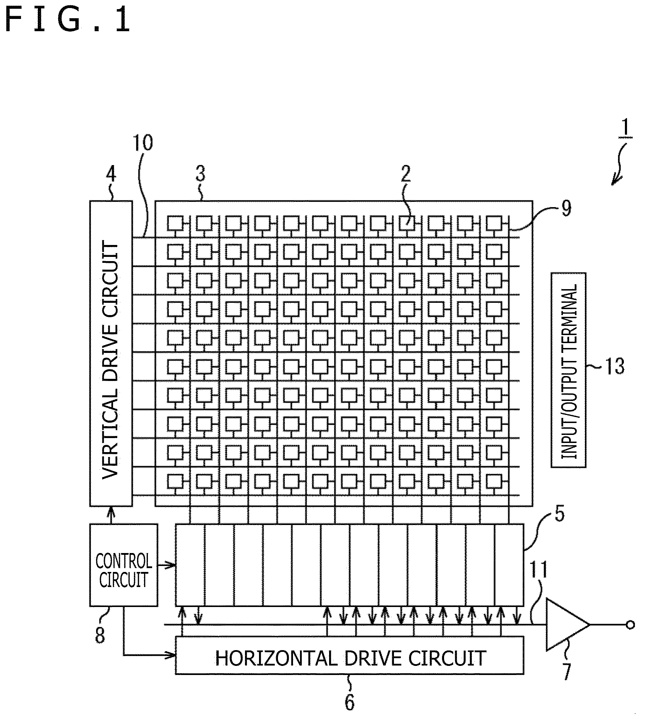

   FIG. 1 is a view depicting a configuration example of an embodiment of an imaging apparatus to which the present technology is applied.
[FIG. 2]

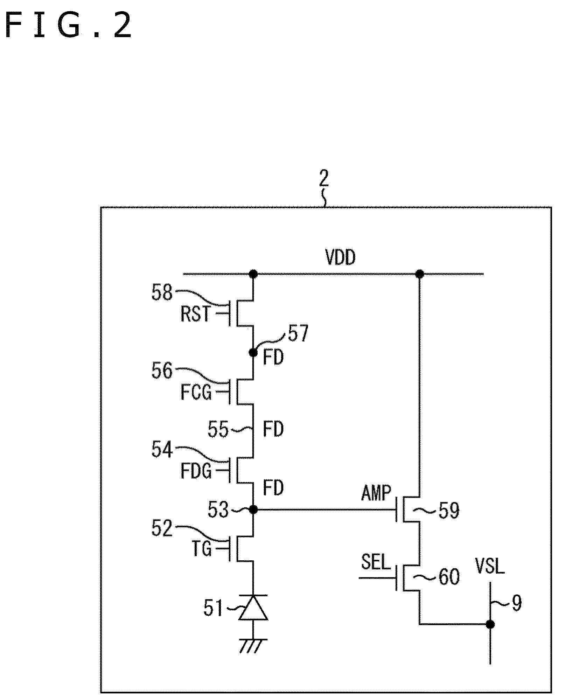

   FIG. 2 is a view depicting a circuit configuration example of a pixel.
[FIG. 3]

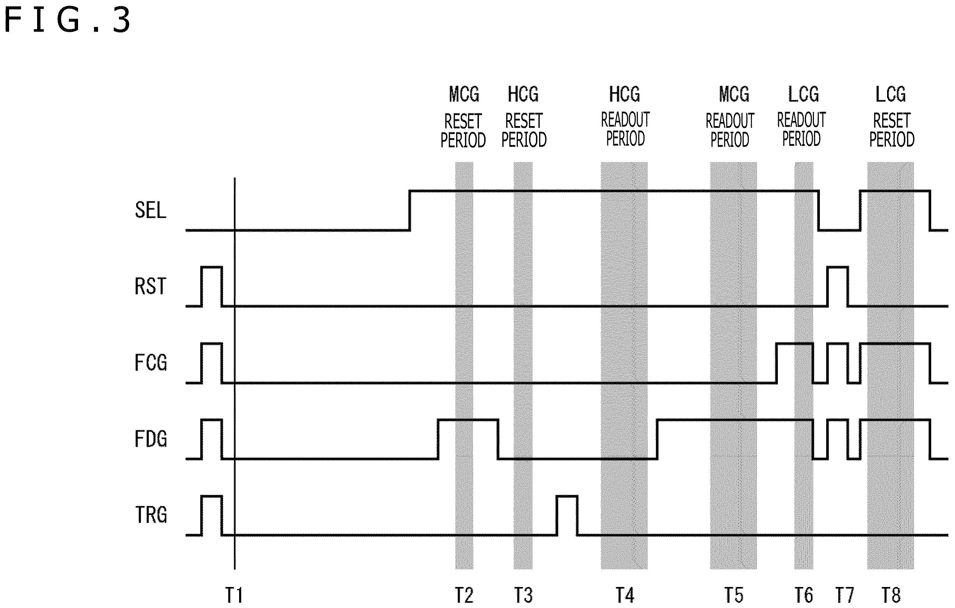

   FIG. 3 is a view for explaining operation of the pixel.
[FIG. 4]

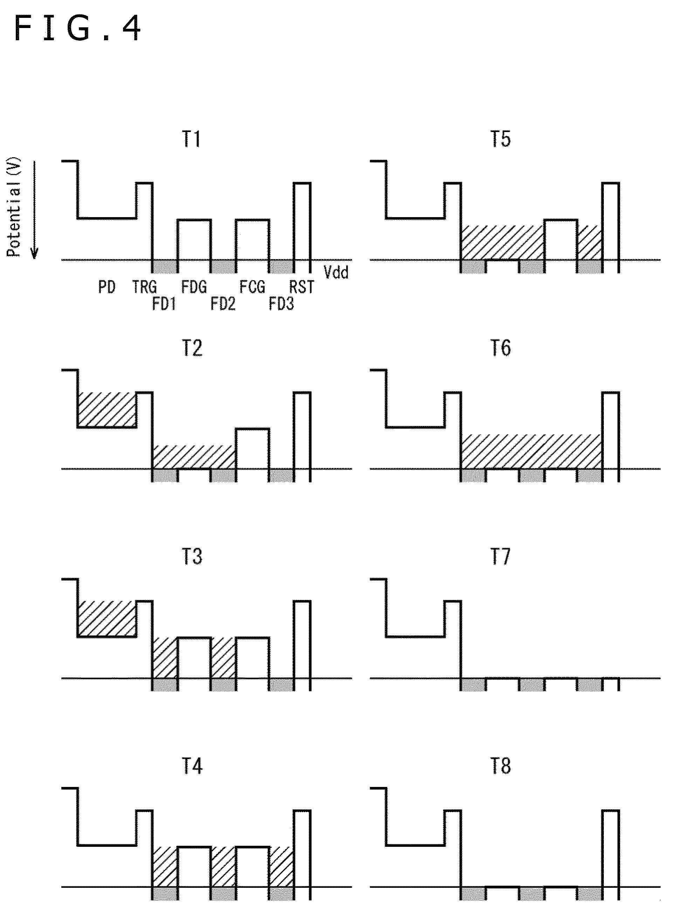

   FIG. 4 is a view for explaining the operation of the pixel.
[FIG. 5]

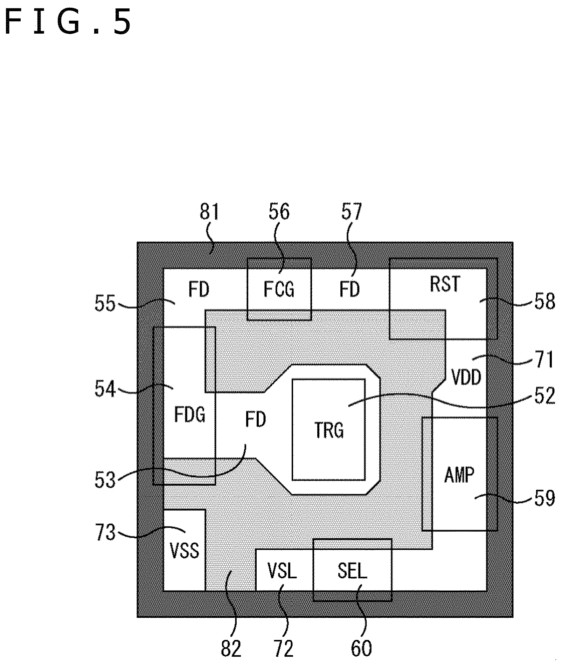

   FIG. 5 is a view depicting a planar configuration example of the pixel in a first embodiment.
[FIG. 6]

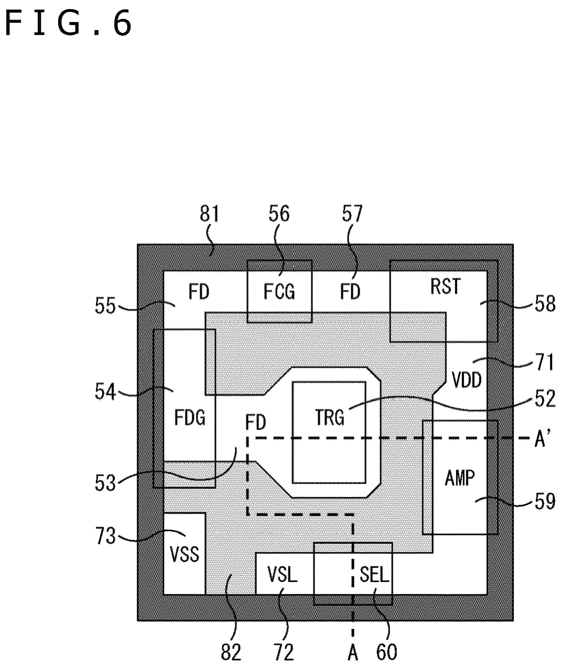

   FIG. 6 is a view depicting a planar configuration example of the pixel in the first embodiment.
[FIG. 7]

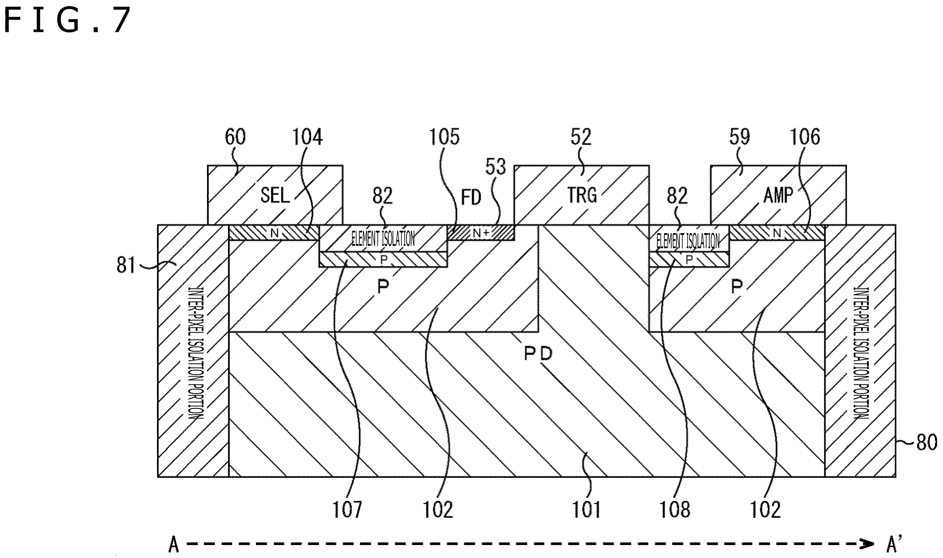

   FIG. 7 is a view depicting a sectional configuration example of the pixel in the first embodiment.
[FIG. 8]

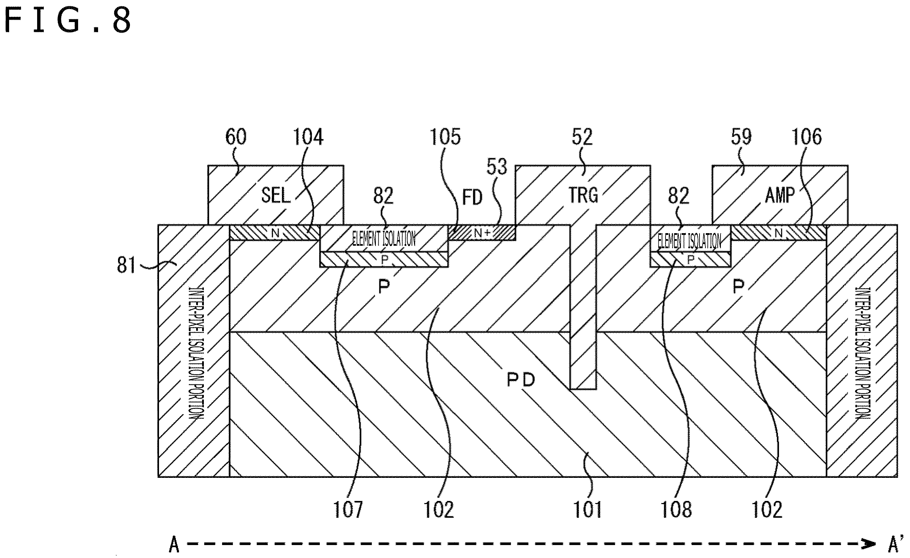

   FIG. 8 is a view depicting a sectional configuration example of the pixel in the first embodiment.
[FIG. 9]

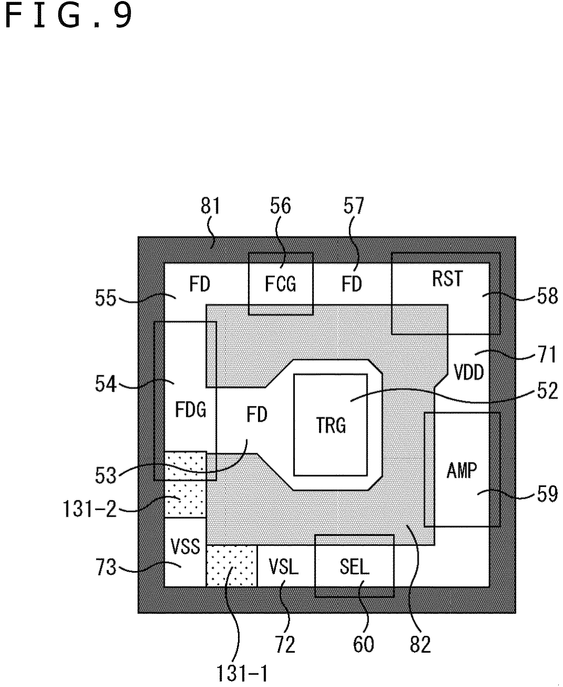

   FIG. 9 is a view depicting a planar configuration example of the pixel in a second embodiment.
[FIG. 10]

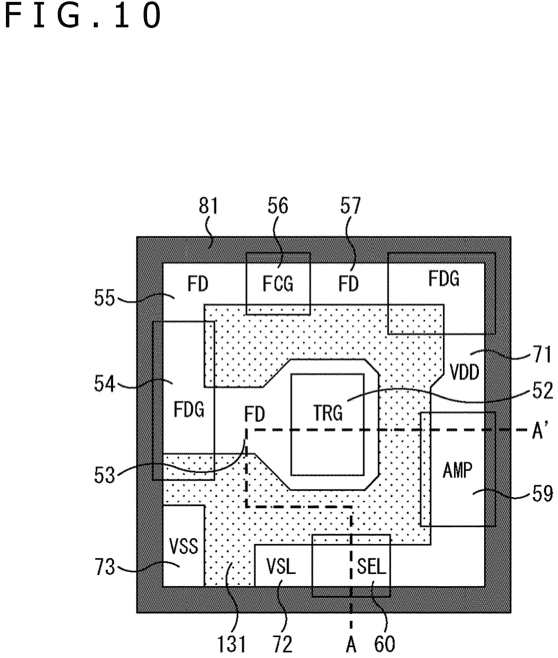

   FIG. 10 is a view depicting a planar configuration example of the pixel in a third embodiment.
[FIG. 11]

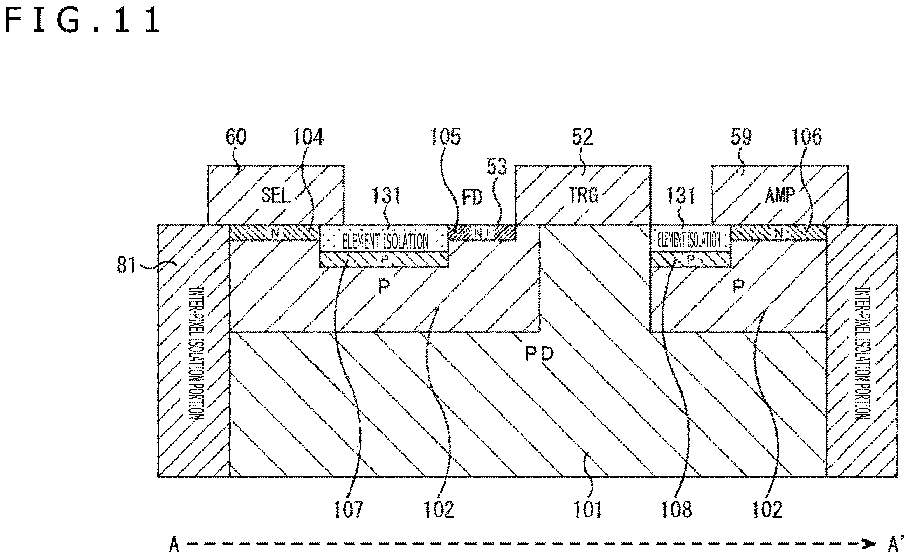

   FIG. 11 is a view depicting a sectional configuration example of the pixel in the third embodiment.
[FIG. 12]

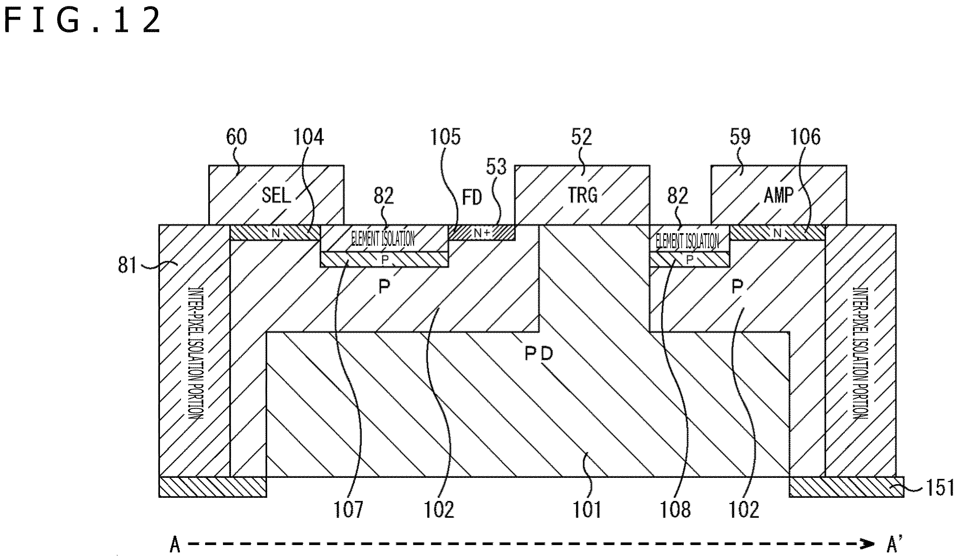

   FIG. 12 is a view for explaining a position of contacts.
[FIG. 13]

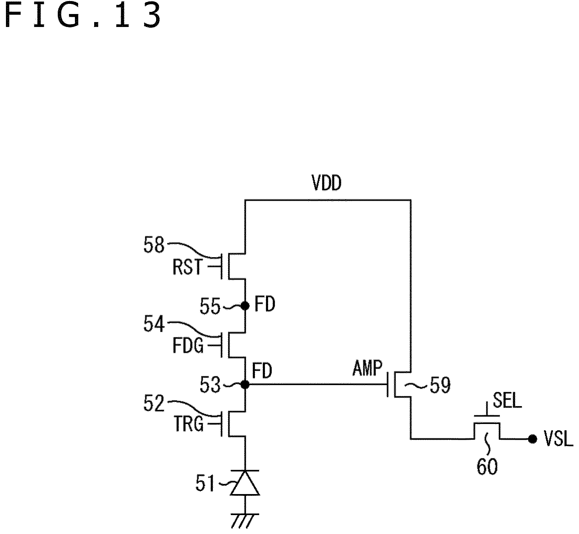

   FIG. 13 is a view depicting a circuit configuration example of the pixel in a fourth embodiment.
[FIG. 14]

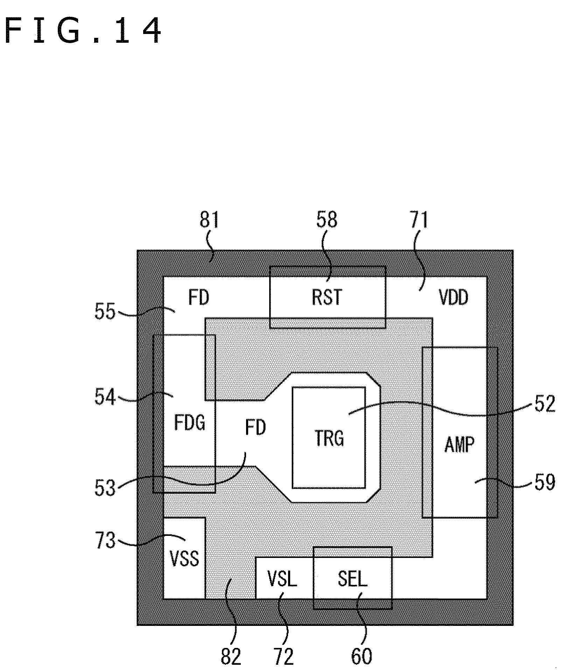

   FIG. 14 is a view depicting a planar configuration example of the pixel in the fourth embodiment.
[FIG. 15]

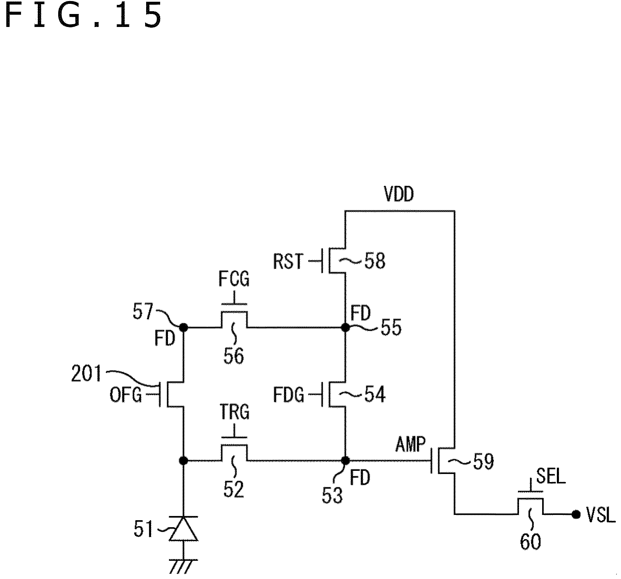

   FIG. 15 is a view depicting a circuit configuration example of the pixel in a fifth embodiment.
[FIG. 16]

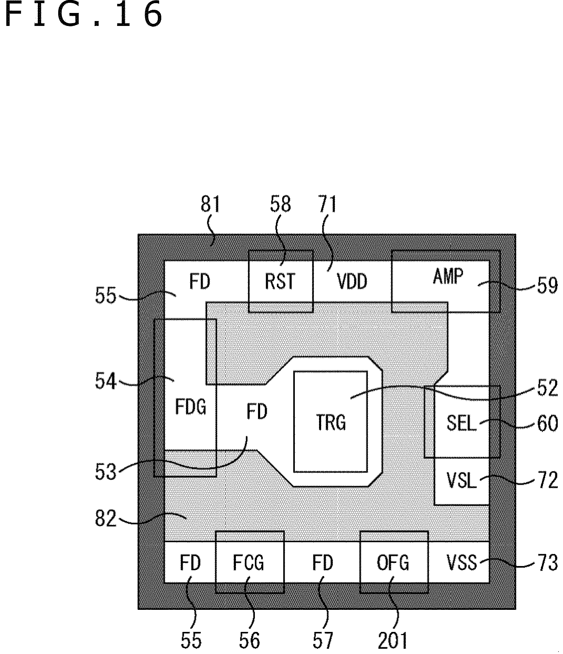

   FIG. 16 is a view depicting a planar configuration example of the pixel in the fifth embodiment.
[FIG. 17]

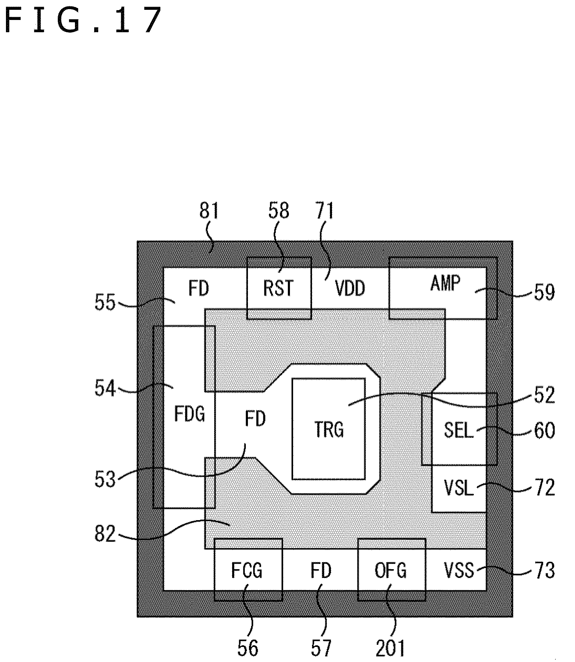

   FIG. 17 is a view depicting a planar configuration example of the pixel in the fifth embodiment.
[FIG. 18]

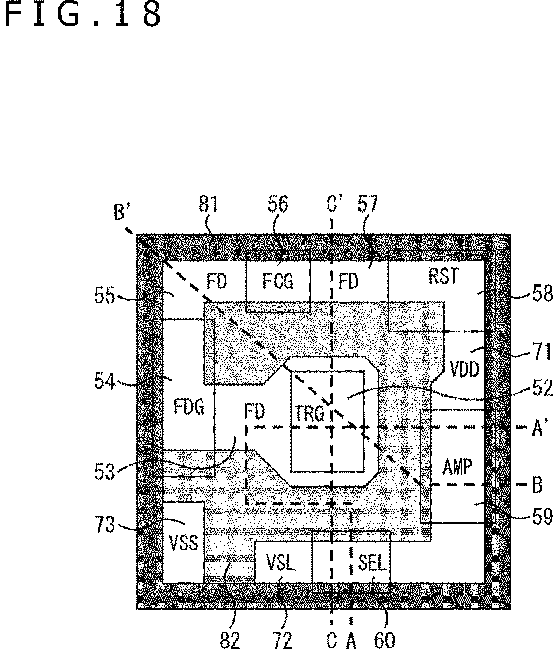

   FIG. 18 is a view depicting a planar configuration example of the pixel.
[FIG. 19]

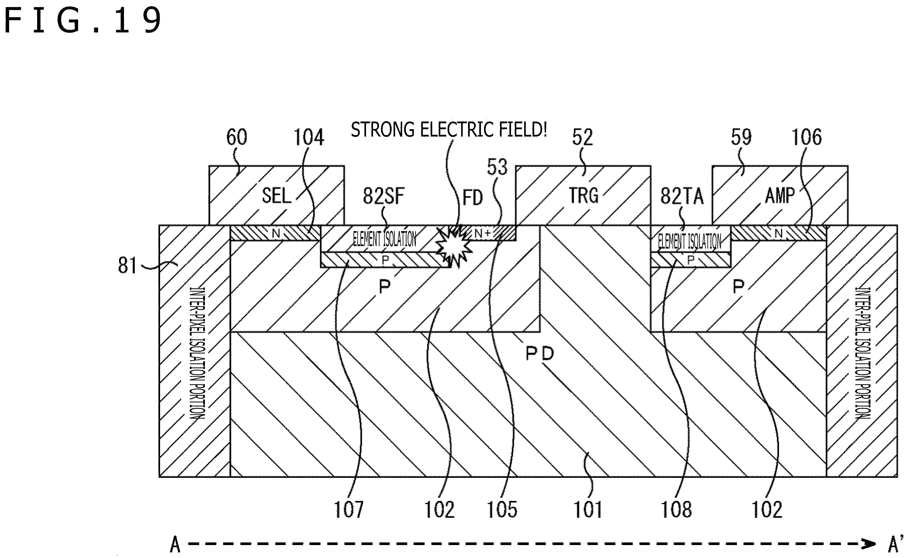

   FIG. 19 is a view for explaining a place at which a strong electric field occurs.
[FIG. 20]

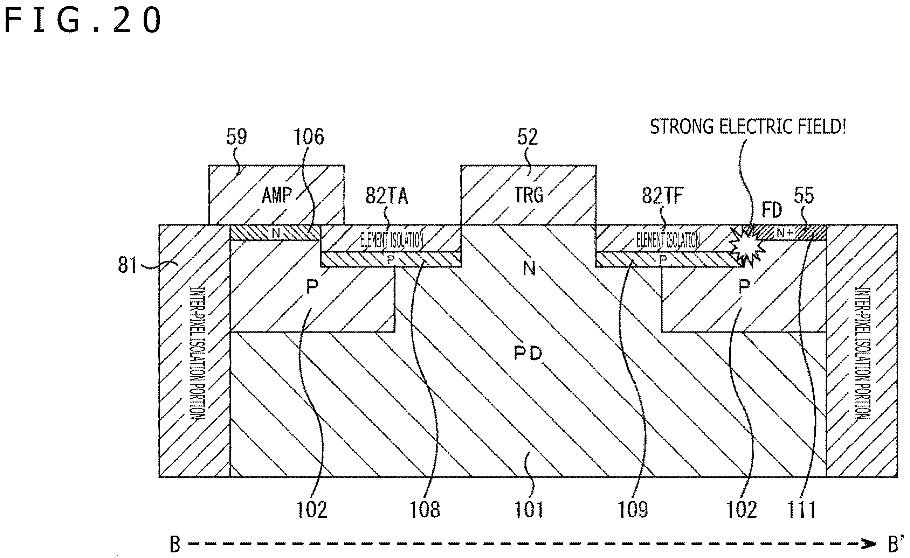

   FIG. 20 is a view for explaining a place at which a strong electric field occurs.
[FIG. 21]

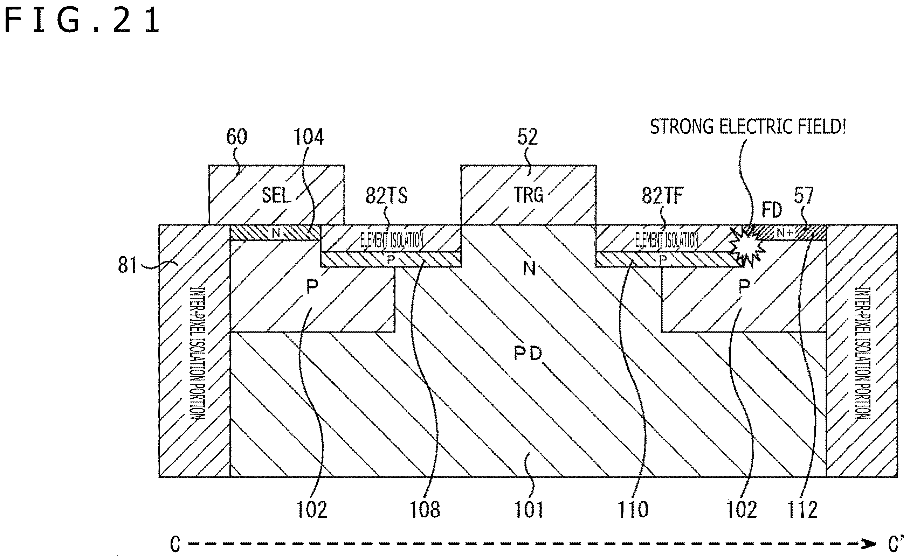

   FIG. 21 is a view for explaining a place at which a strong electric field occurs.
[FIG. 22]

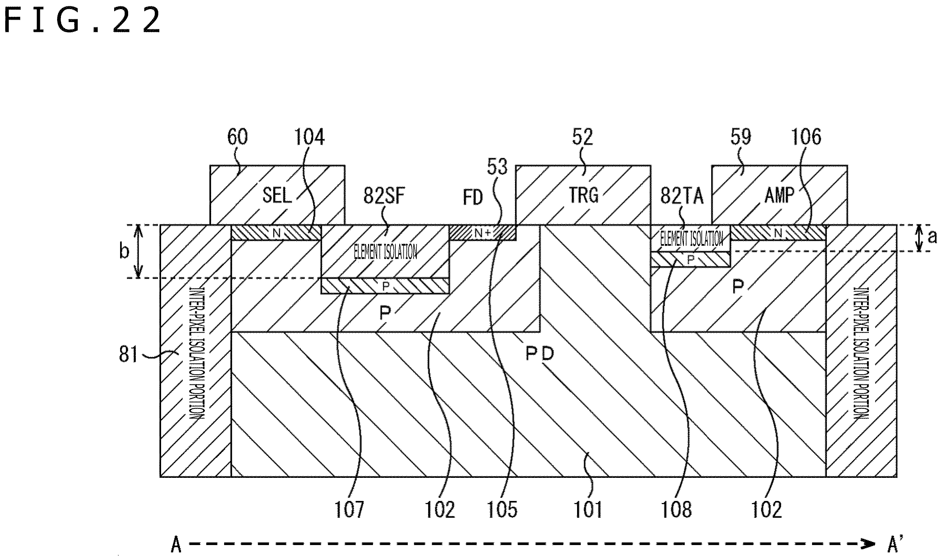

   FIG. 22 is a view depicting a sectional configuration example of the pixel in a sixth embodiment.
[FIG. 23]

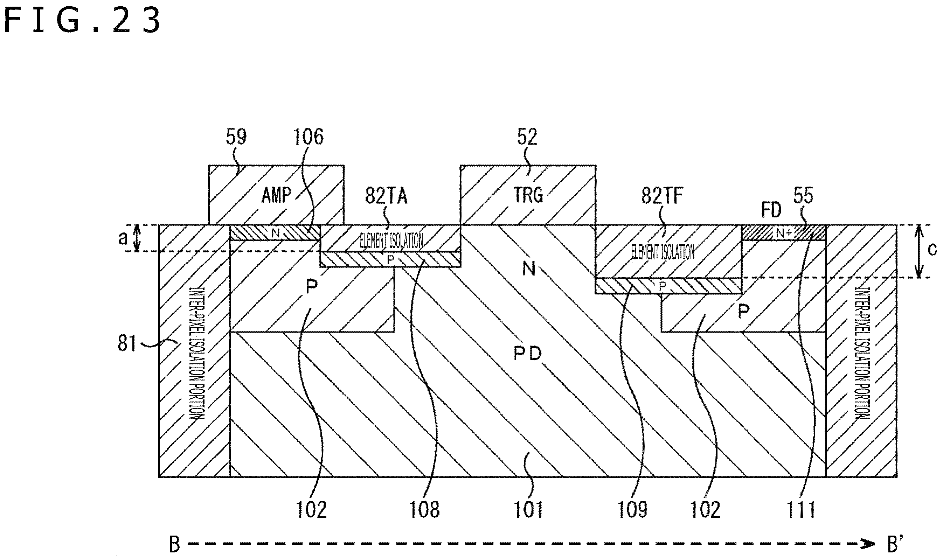

   FIG. 23 is a view depicting a sectional configuration example of the pixel in the sixth embodiment.
[FIG. 24]

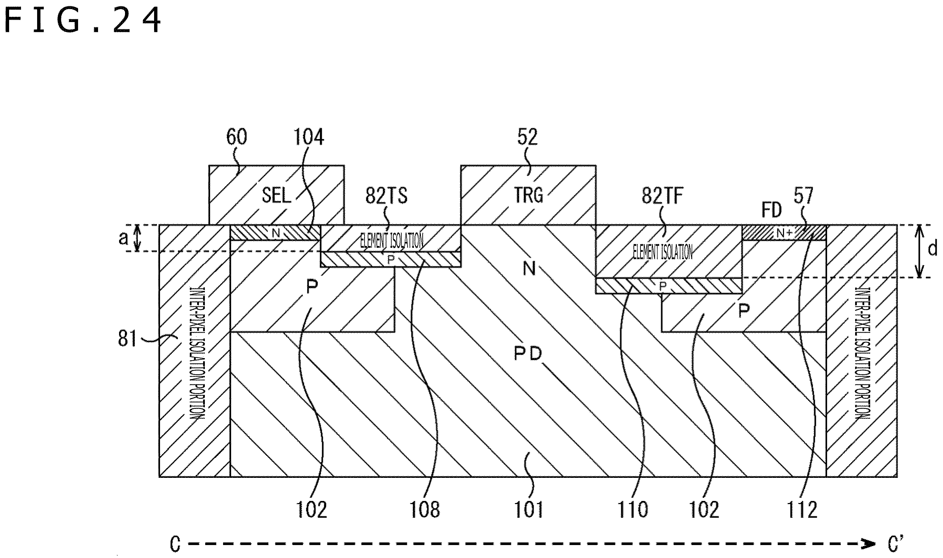

   FIG. 24 is a view depicting a sectional configuration example of the pixel in the sixth embodiment.
[FIG. 25]

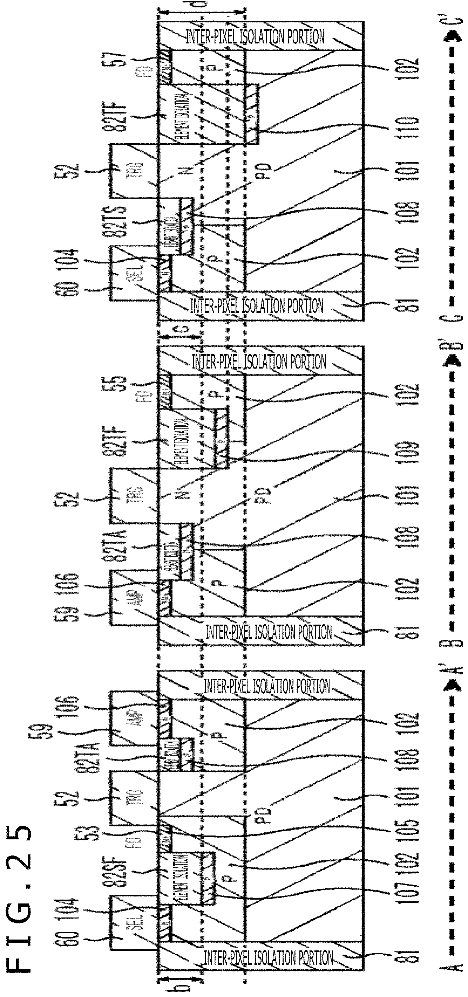

   FIG. 25 is a view for explaining a depth of element isolation portions.
[FIG. 26]

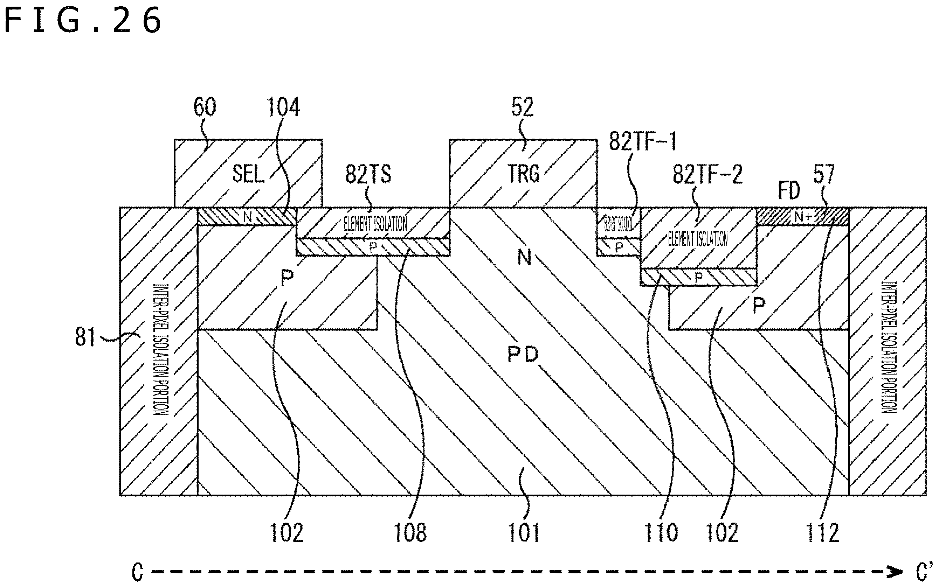

   FIG. 26 is a view depicting a sectional configuration example of the pixel in a seventh embodiment.
[FIG. 27]

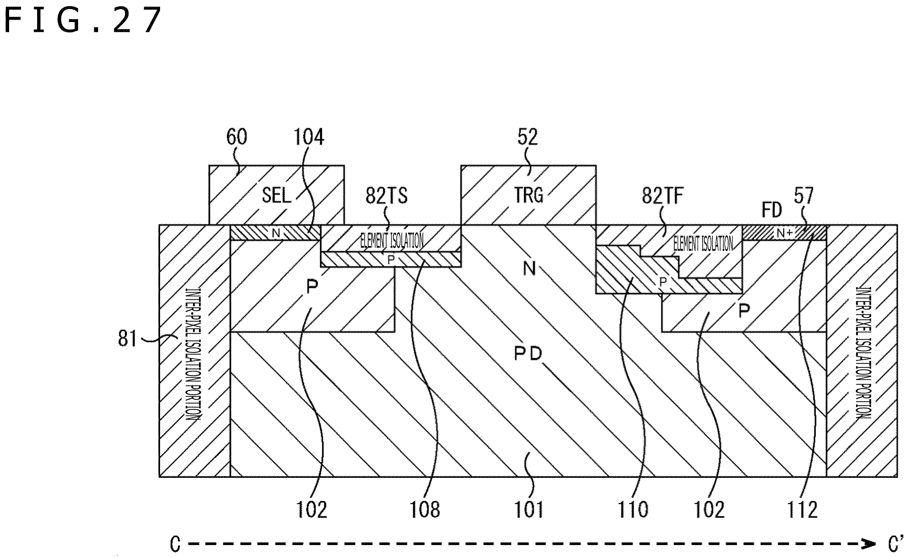

   FIG. 27 is a view depicting a sectional configuration example of the pixel in the seventh embodiment.
[FIG. 28]

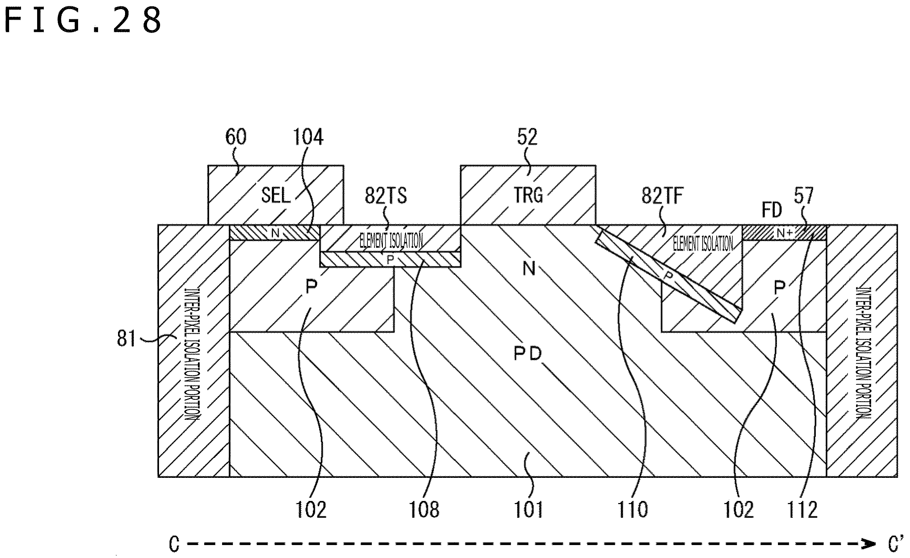

   FIG. 28 is a view depicting a sectional configuration example of the pixel in the seventh embodiment.
[FIG. 29]

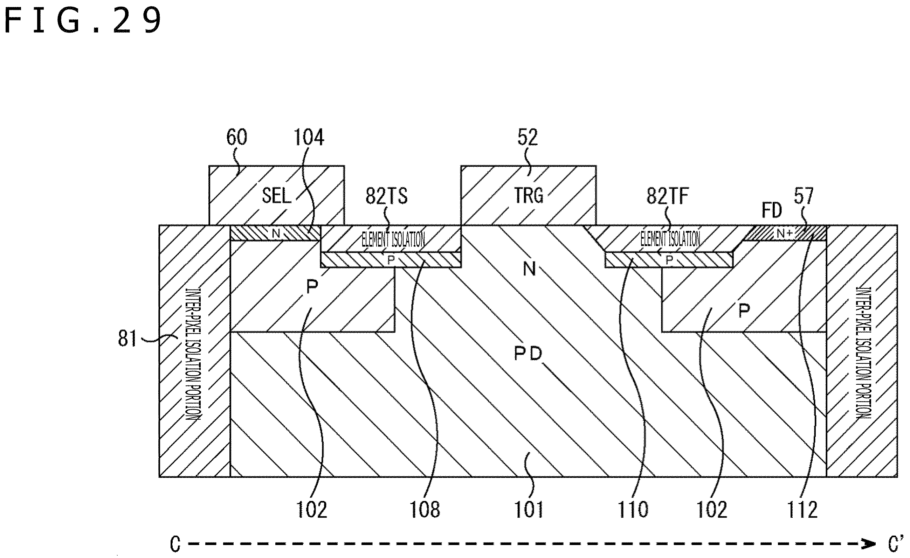

   FIG. 29 is a view depicting a sectional configuration example of the pixel in an eighth embodiment.
[FIG. 30]

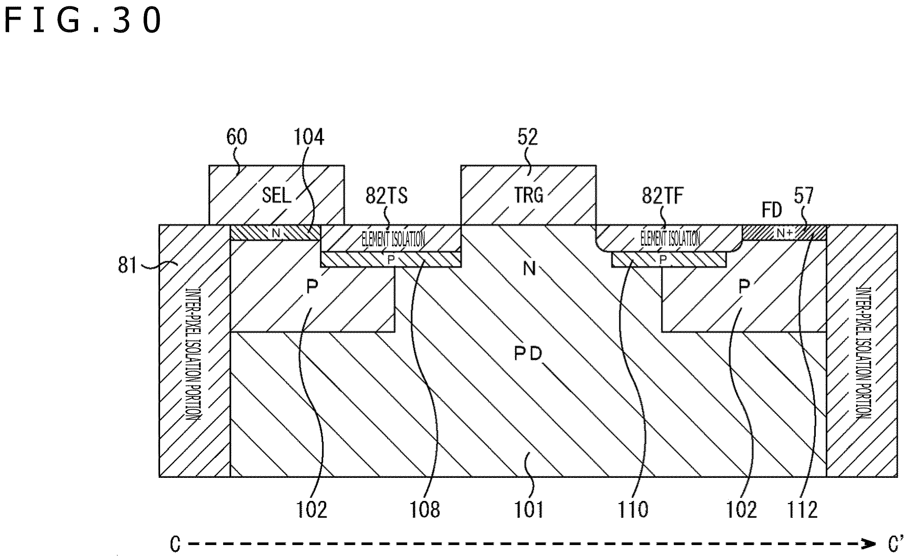

   FIG. 30 is a view depicting a sectional configuration example of the pixel in the eighth embodiment.
[FIG. 31]

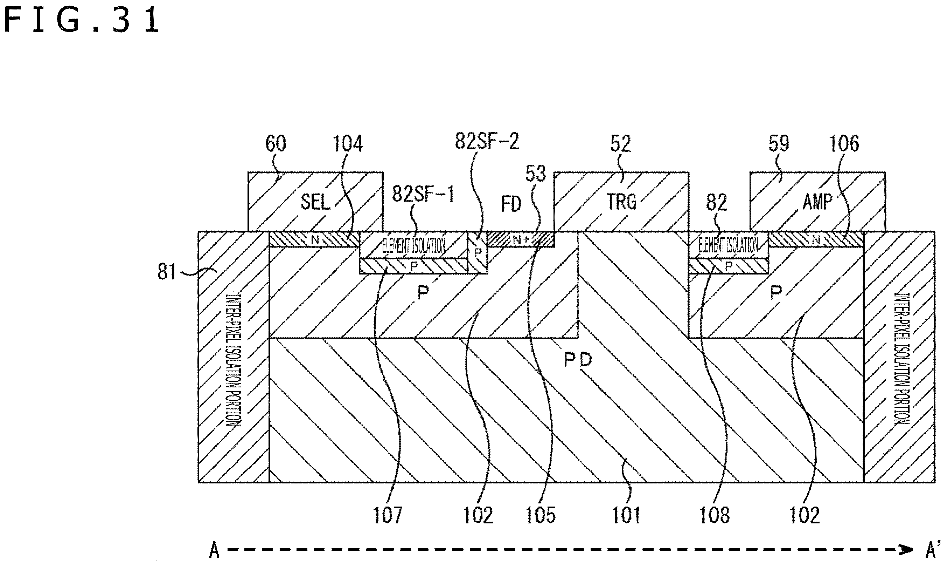

   FIG. 31 is a view depicting a sectional configuration example of the pixel in a ninth embodiment.
[FIG. 32]

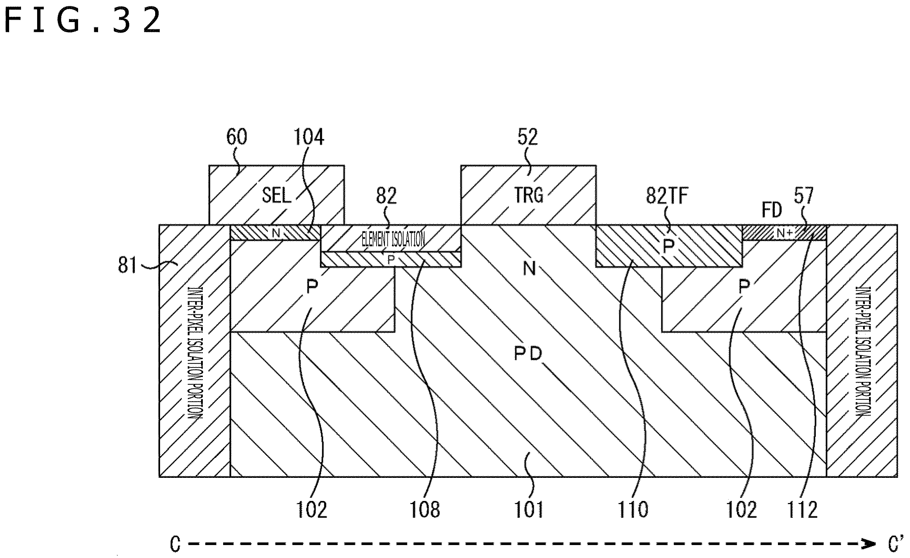

   FIG. 32 is a view depicting a sectional configuration example of the pixel in the ninth embodiment.
[FIG. 33]

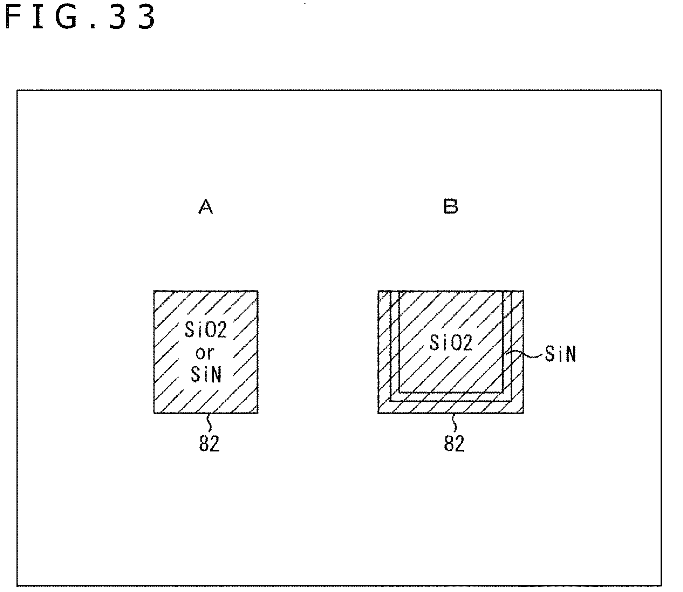

   FIG. 33 depicts views for explaining configurations of the element isolation portion.
[FIG. 34]

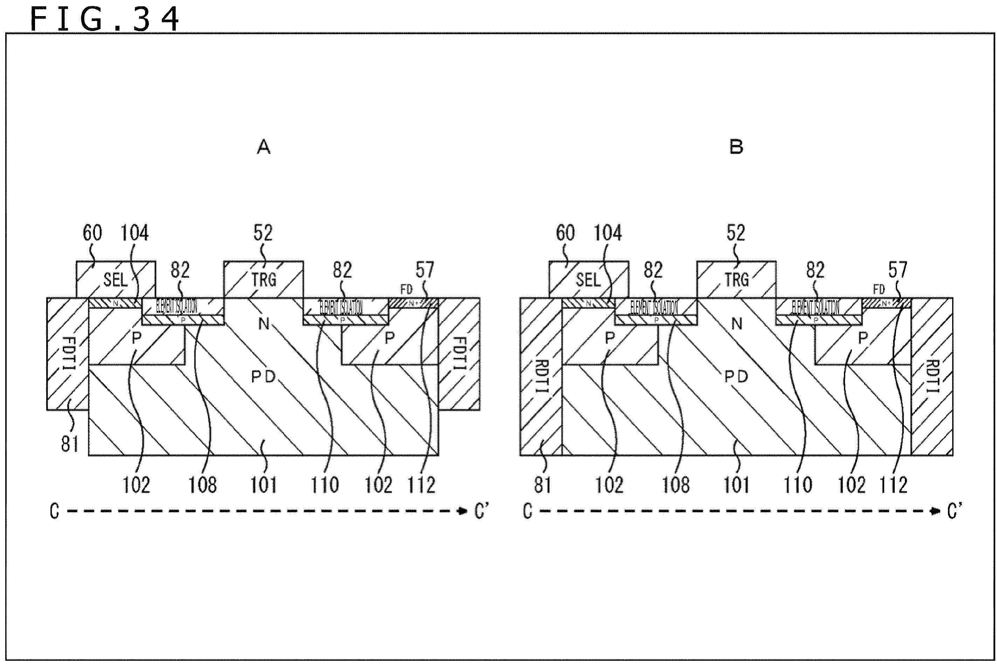

   FIG. 34 depicts views for explaining configurations of an inter-pixel isolation portioni
[FIG. 35]

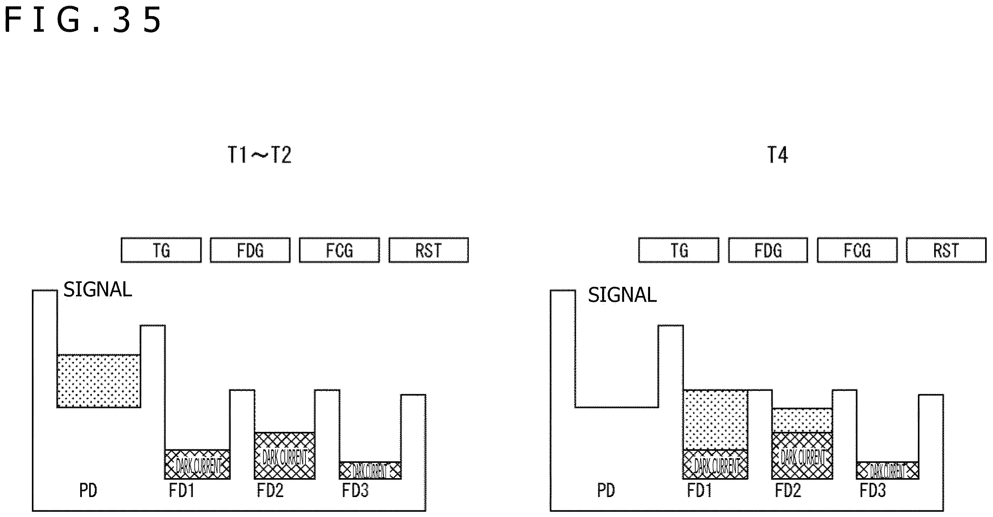

   FIG. 35 depicts views for explaining an influence of a dark current.
[FIG. 36]

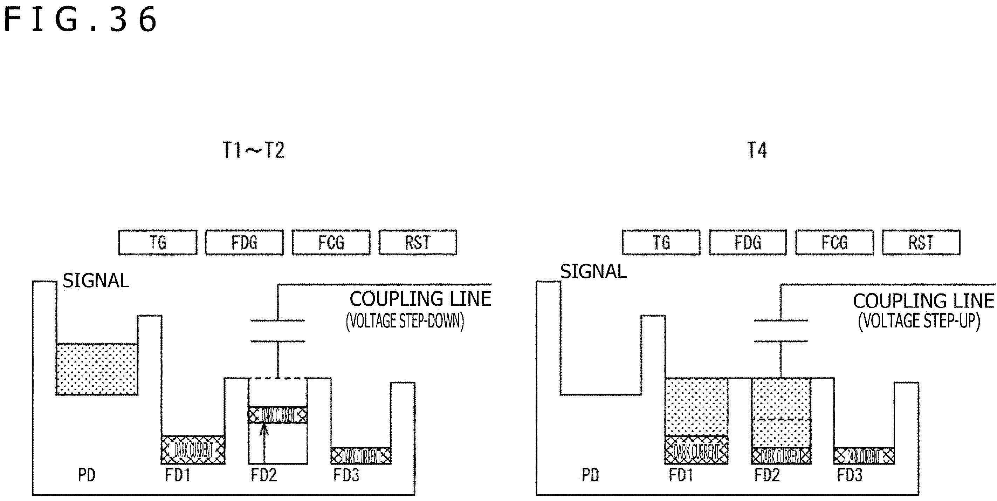

   FIG. 36 depicts views for explaining a way of suppression of the dark current.
[FIG. 37]

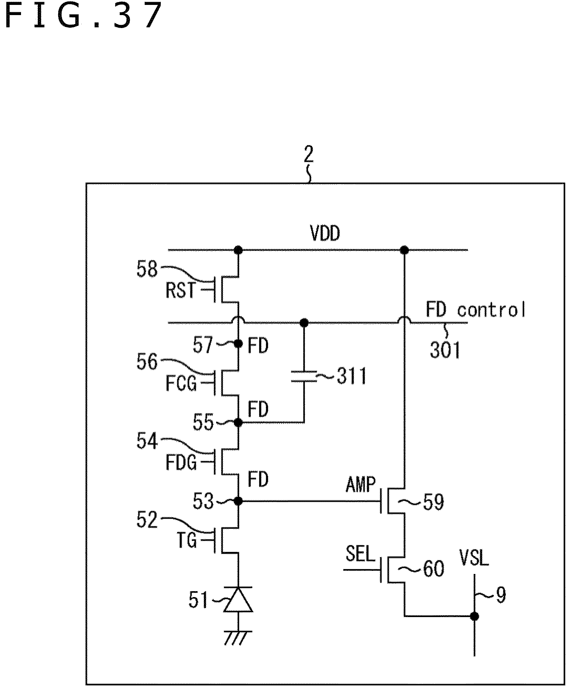

   FIG. 37 is a view depicting a circuit configuration example of the pixel in a tenth embodiment.
[FIG. 38]

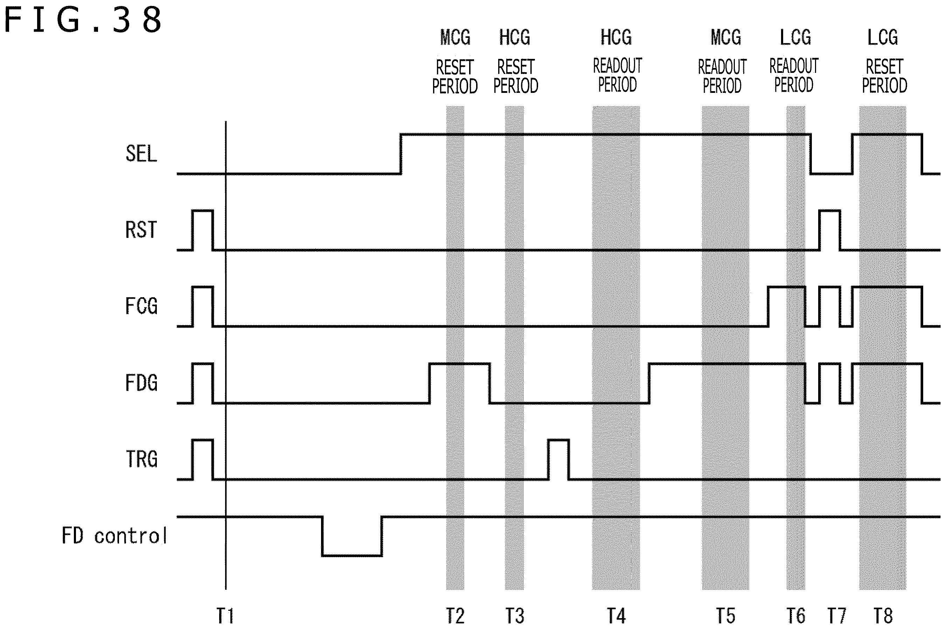

   FIG. 38 depicts views for explaining operation of the pixel.
[FIG. 39]

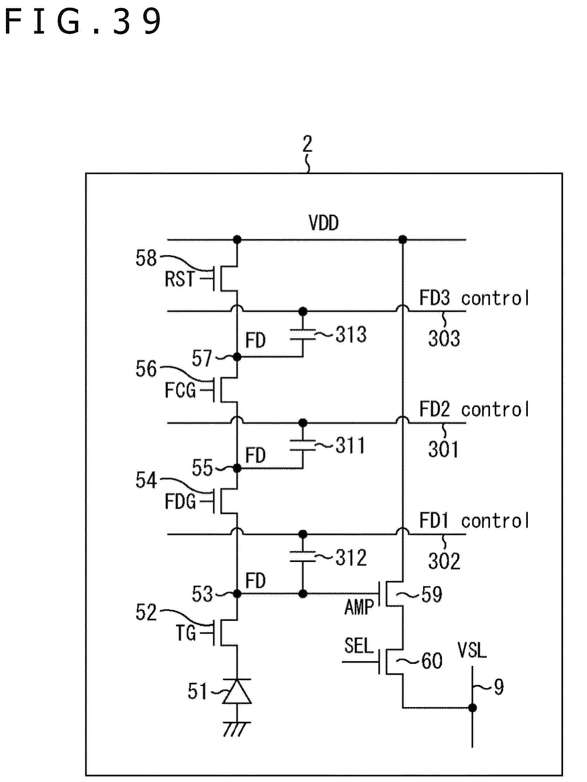

   FIG. 39 is a view depicting another circuit configuration example of the pixel in the tenth embodiment.
[FIG. 40]

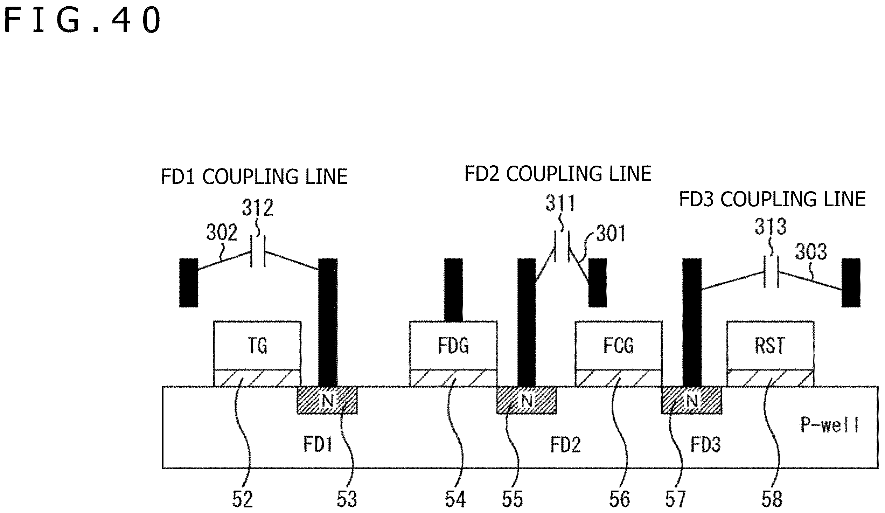

   FIG. 40 is a view depicting a sectional configuration example of the pixel in the tenth embodiment.
[FIG. 41]

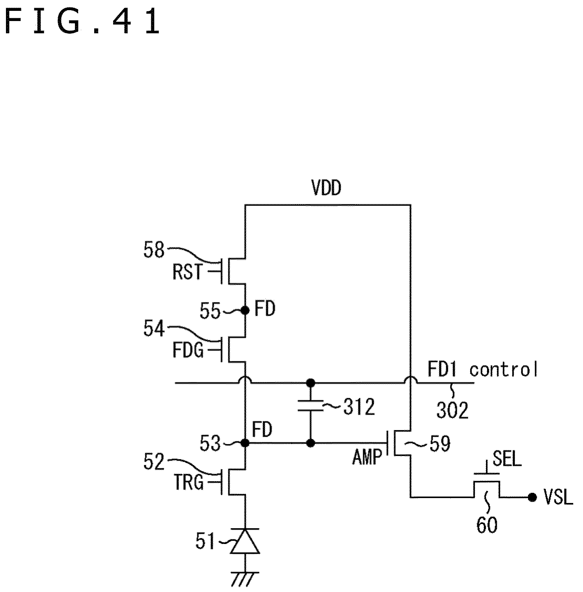

   FIG. 41 is a view depicting a circuit configuration example of the pixel in an eleventh embodiment.
[FIG. 42]

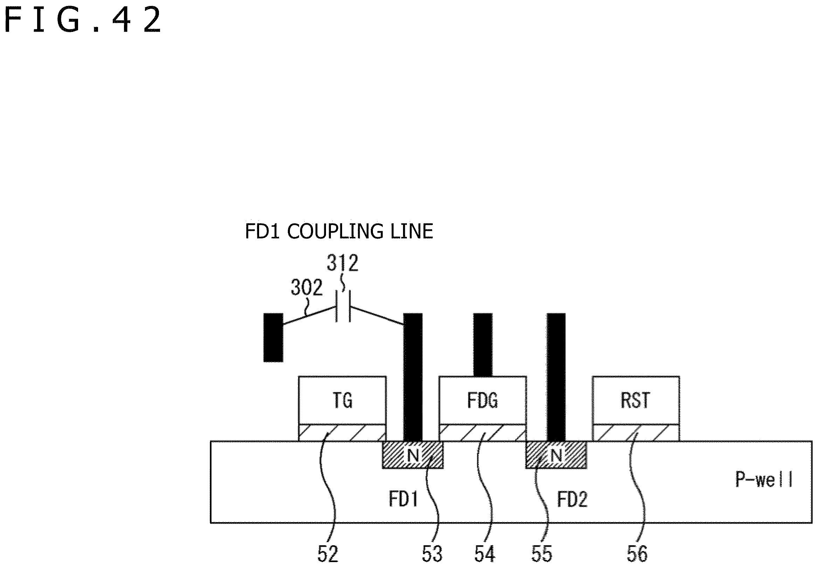

   FIG. 42 is a view depicting a sectional configuration example of the pixel in the eleventh embodiment.
[FIG. 43]

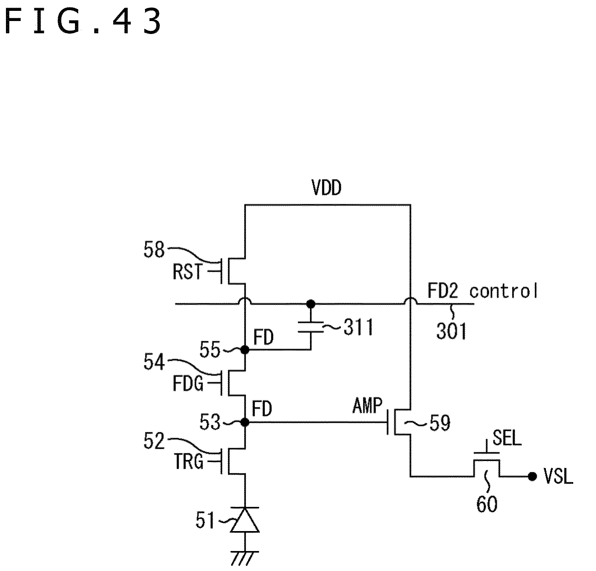

   FIG. 43 is a view depicting another circuit configuration example of the pixel in the eleventh embodiment.
[FIG. 44]

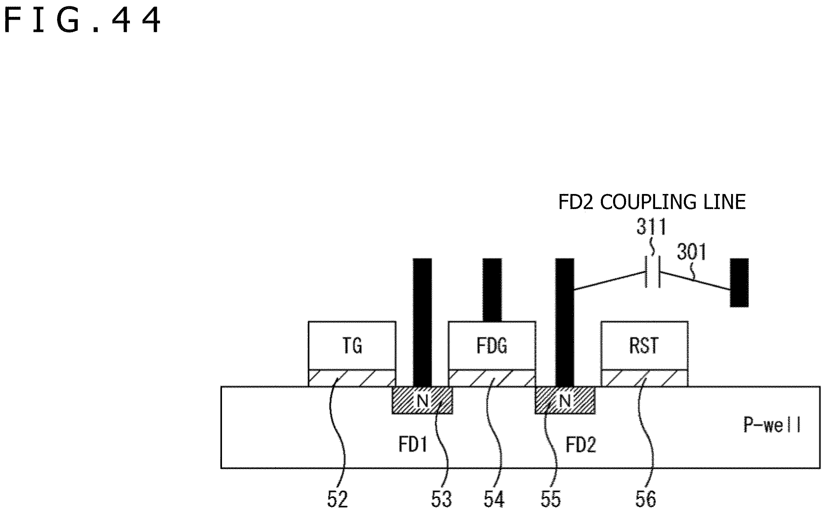

   FIG. 44 is a view depicting another sectional configuration example of the pixel in the eleventh embodiment.
[FIG. 45]

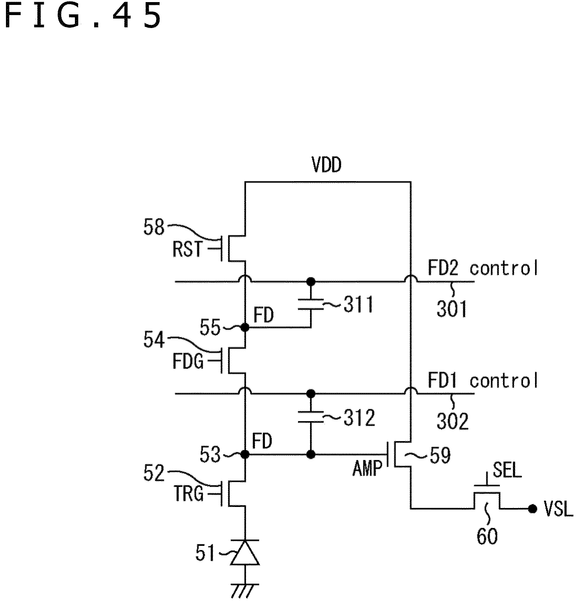

   FIG. 45 is a view depicting another circuit configuration example of the pixel in the eleventh embodiment.
[FIG. 46]

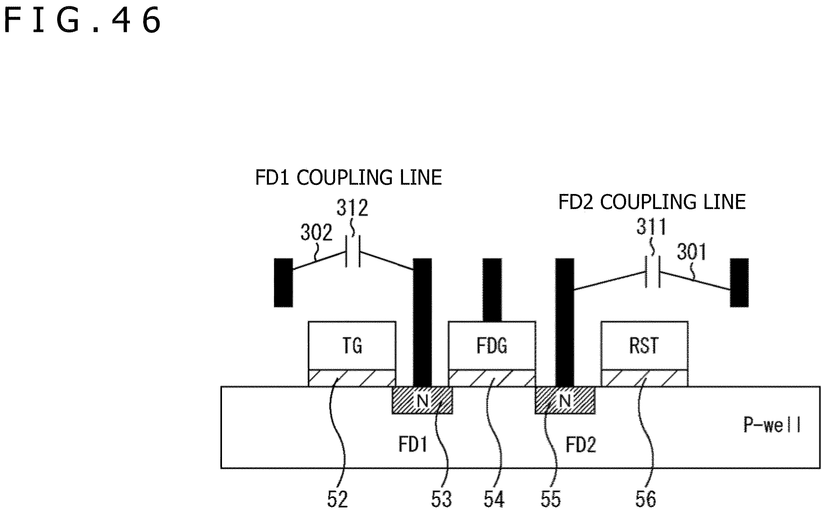

   FIG. 46 is a view depicting another sectional configuration example of the pixel in the eleventh embodiment.
[FIG. 47]

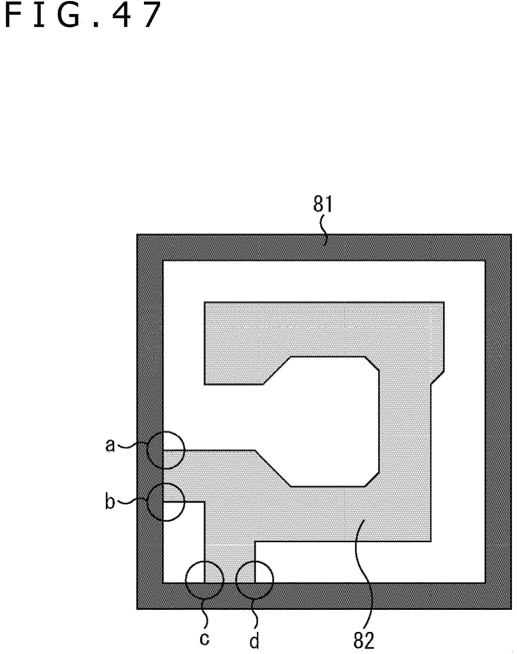

   FIG. 47 depicts views for explaining places at which the dark current is likely to occur.
[FIG. 48]

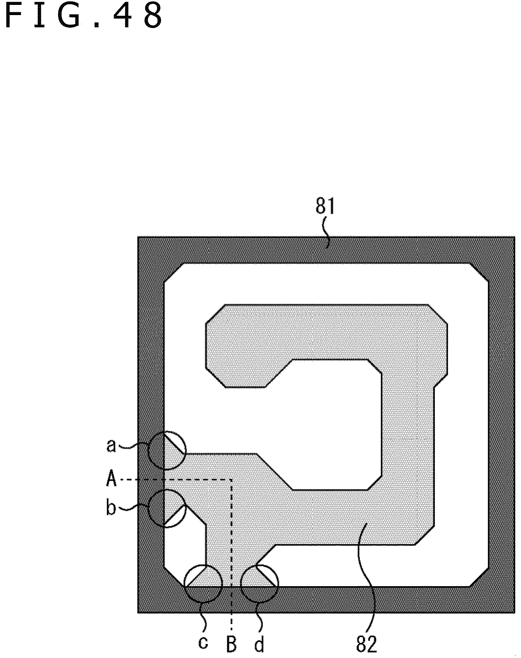

   FIG. 48 is a view depicting another planar configuration example of the pixel in a twelfth embodiment.
[FIG. 49]

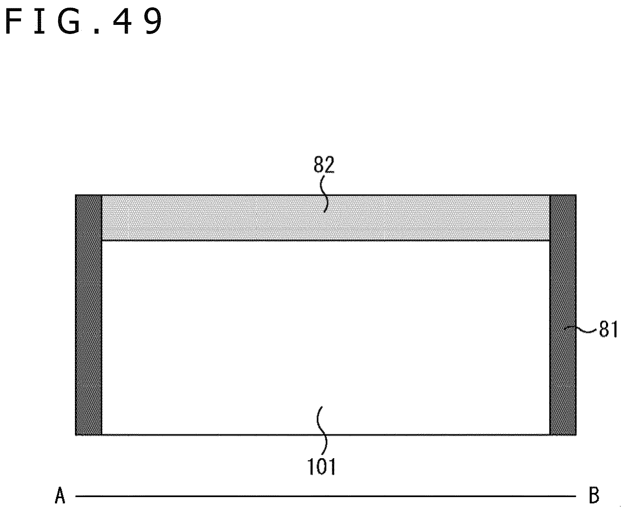

   FIG. 49 is a view depicting another sectional configuration example of the pixel in the twelfth embodiment.
[FIG. 50]

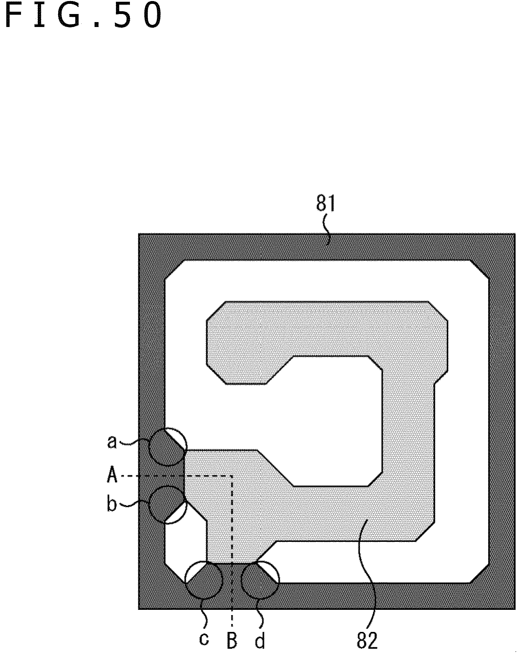

   FIG. 50 is a view depicting another planar configuration example of the pixel in the twelfth embodiment.
[FIG. 51]

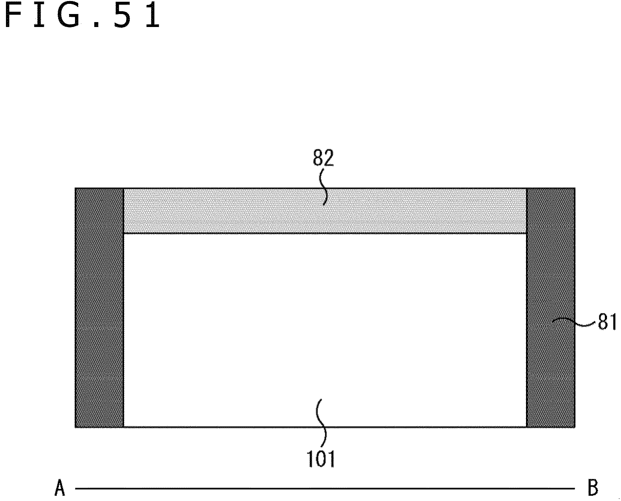

   FIG. 51 is a view depicting another sectional configuration example of the pixel in the twelfth embodiment.
[FIG. 52]

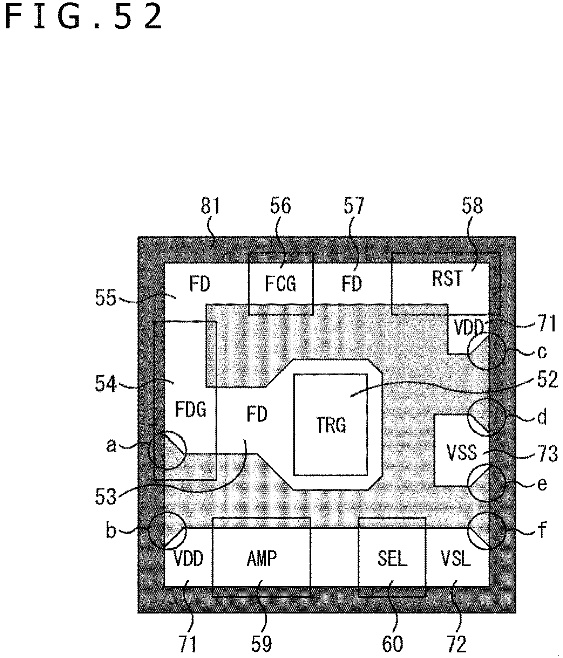

   FIG. 52 is a view depicting another planar configuration example of the pixel in a thirteenth embodiment.
[FIG. 53]

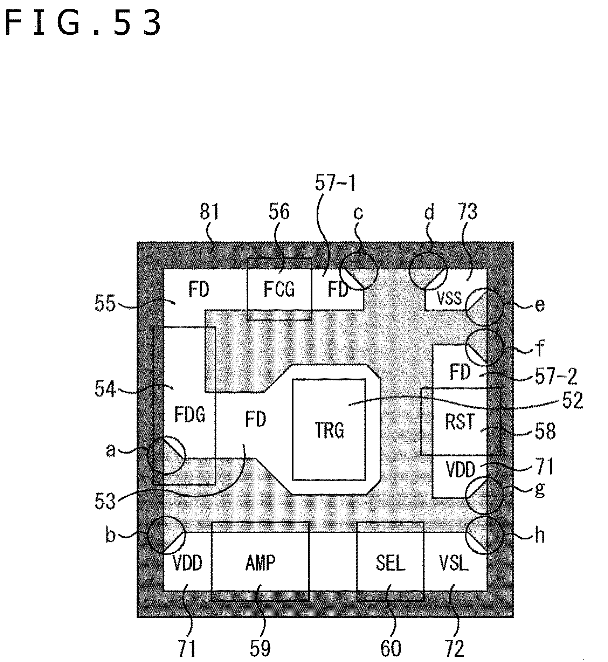

   FIG. 53 is a view depicting another planar configuration example of the pixel in a fourteenth embodiment.
[FIG. 54]

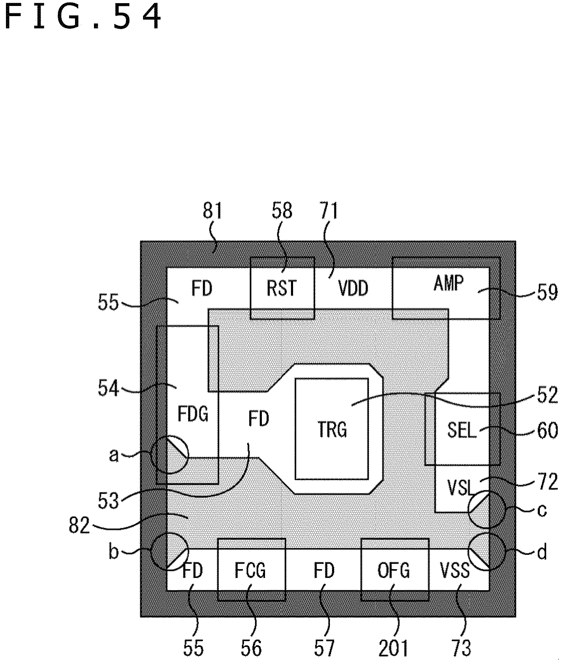

   FIG. 54 is a view depicting a planar configuration example of the pixel in the case in which the fifth embodiment and the twelfth embodiment are combined.
[FIG. 55]

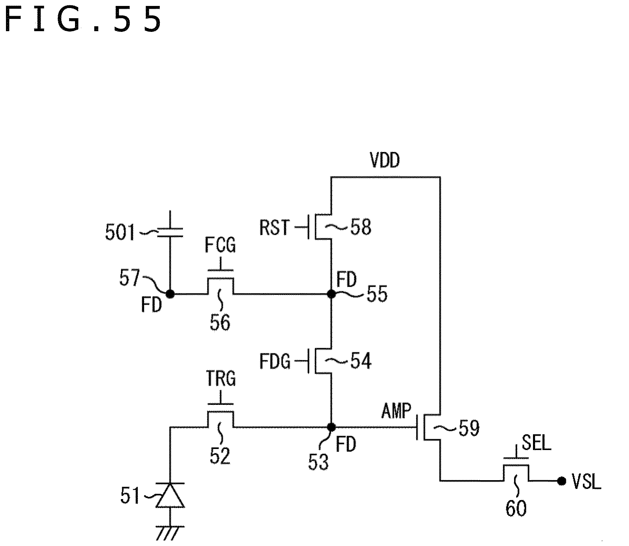

   FIG. 55 is a view depicting another circuit configuration example of the pixel in a fifteenth embodiment.
[FIG. 56]

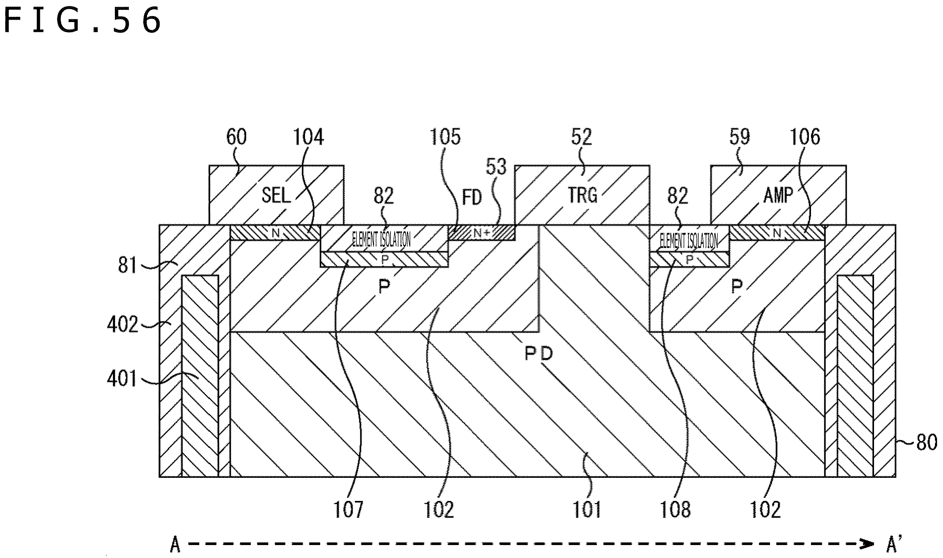

   FIG. 56 is a view depicting another sectional configuration example of the pixel in a sixteenth embodiment.
[FIG. 57]

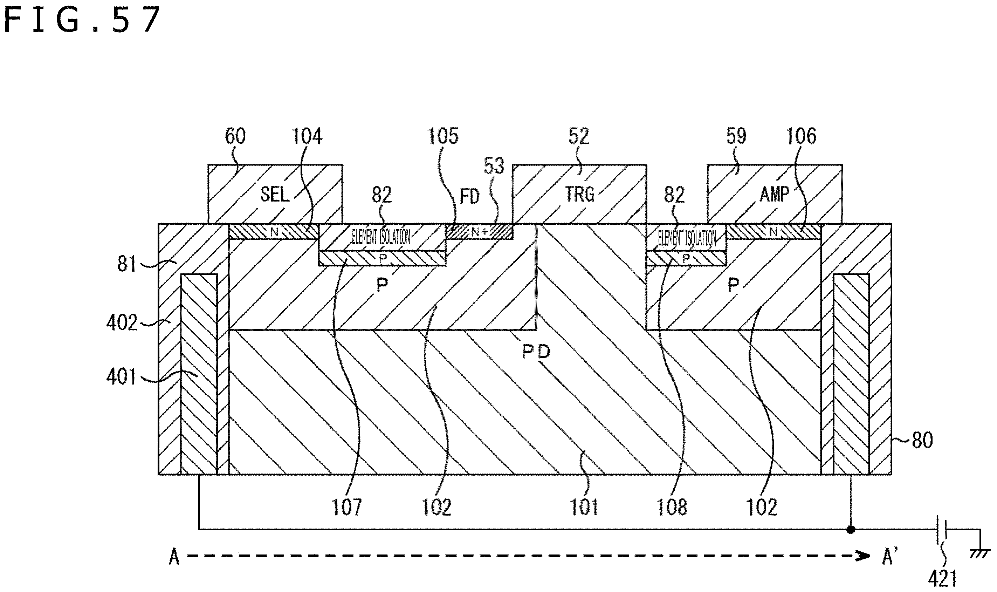

   FIG. 57 is a view depicting another sectional configuration example of the pixel in the sixteenth embodiment.
[FIG. 58]

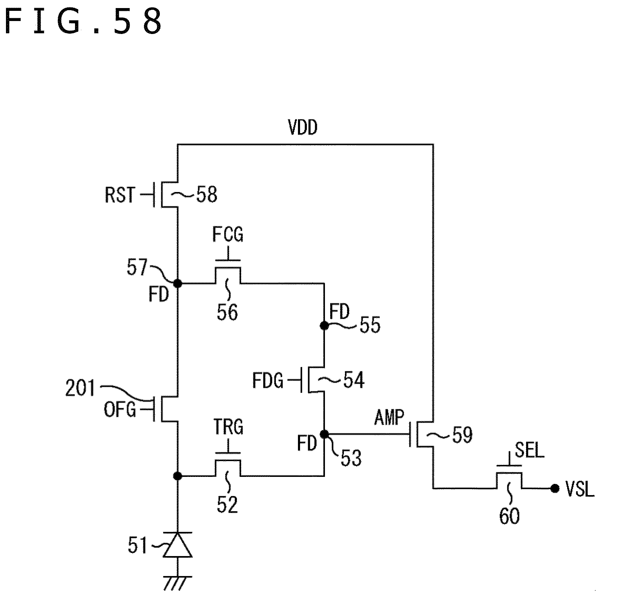

   FIG. 58 is a view depicting a circuit configuration example of the pixel in a seventeenth embodiment.
[FIG. 59]

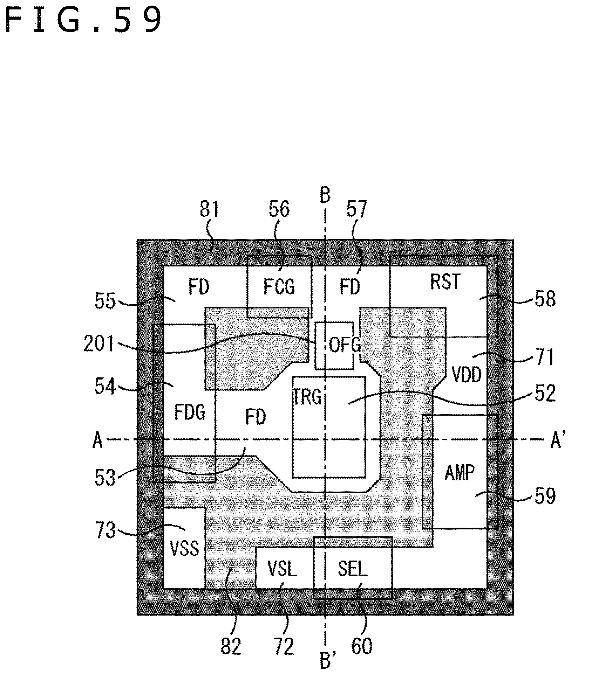

   FIG. 59 is a view depicting a planar configuration example of the pixel in the seventeenth embodiment=
[FIG. 60]

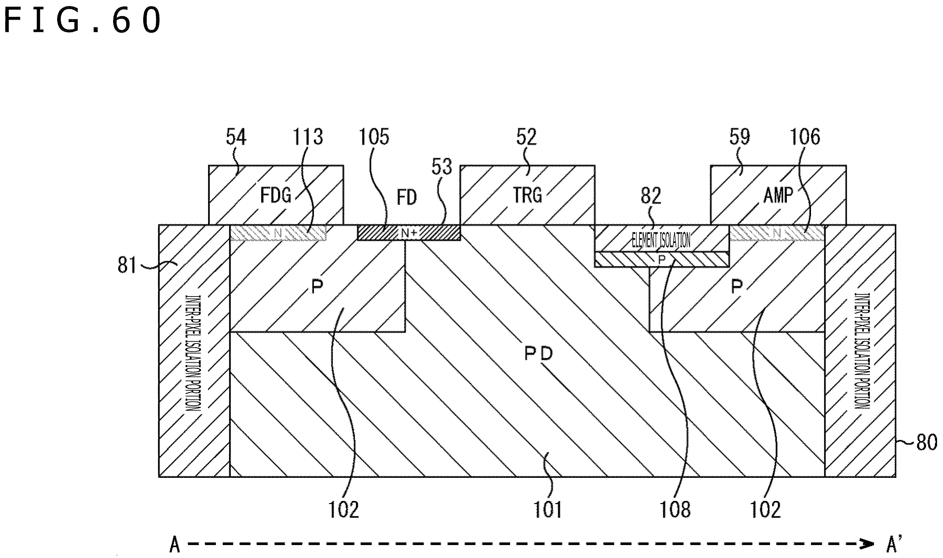

   FIG. 60 is a view depicting a sectional configuration example of the pixel in the seventeenth embodiment.
[FIG. 61]

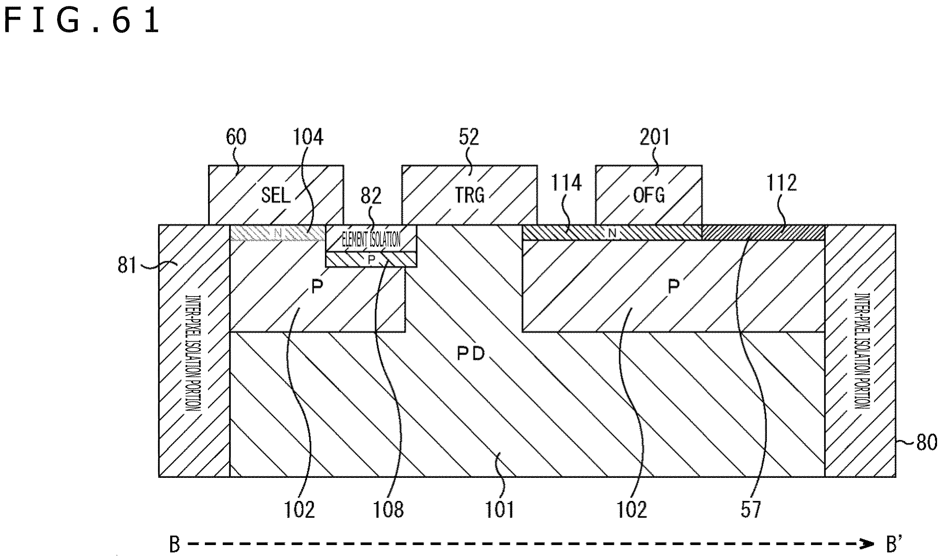

   FIG. 61 is a view depicting a sectional configuration example of the pixel in the seventeenth embodiment.
[FIG. 62]

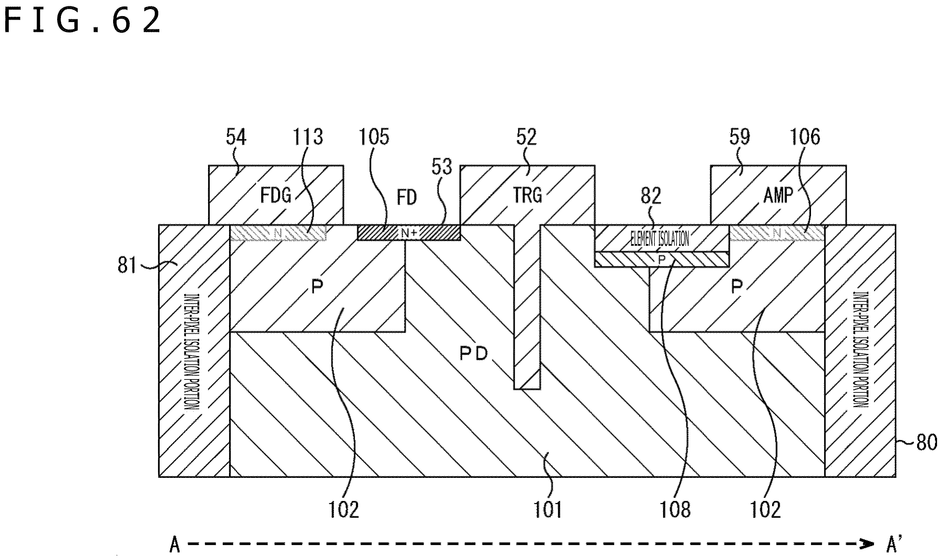

   FIG. 62 is a view depicting a sectional configuration example of the pixel in the seventeenth embodiment.
[FIG. 63]

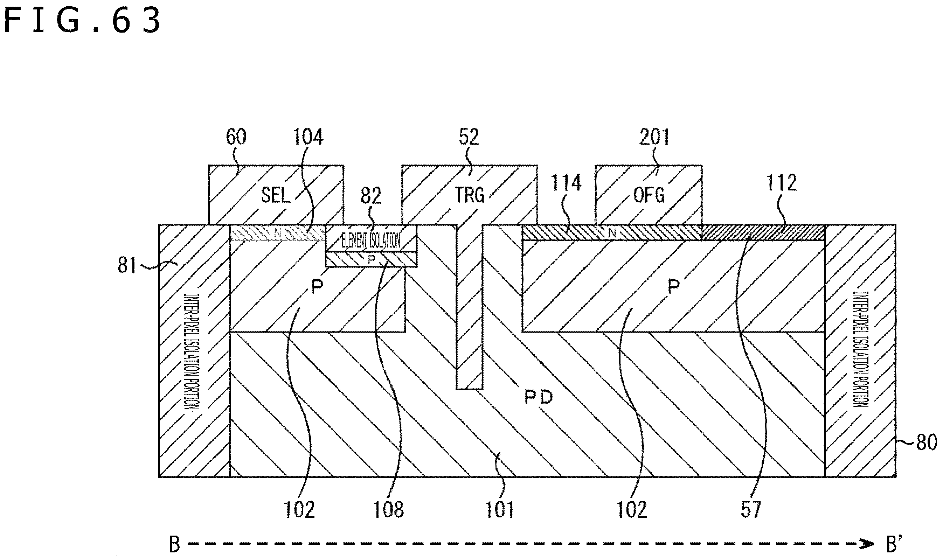

   FIG. 63 is a view depicting a sectional configuration example of the pixel in the seventeenth embodiment.
[FIG. 64]

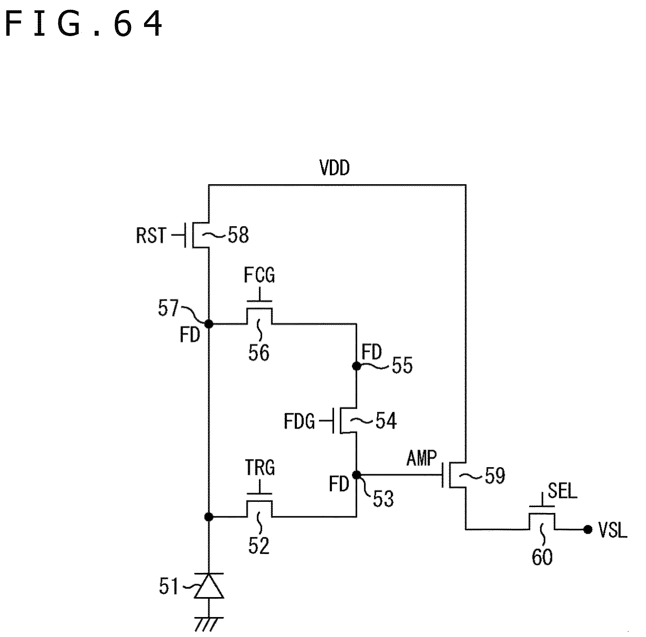

   FIG. 64 is a view depicting another circuit configuration example of the pixel in the seventeenth embodiment.
[FIG. 65]

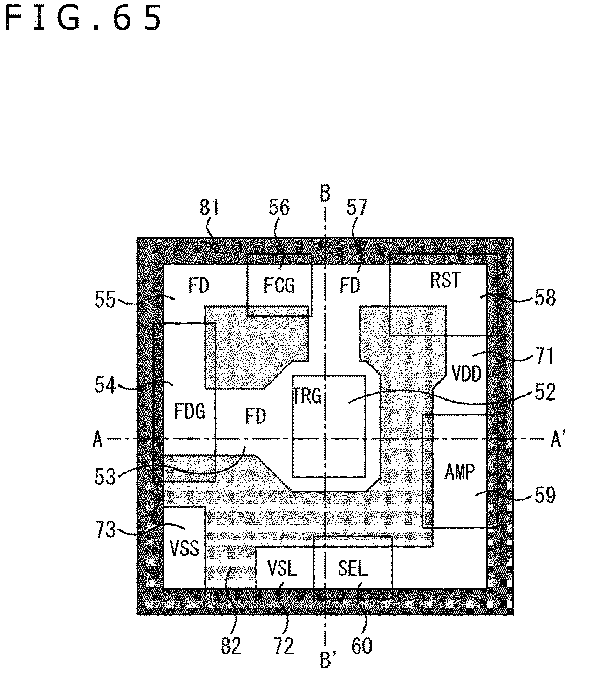

   FIG. 65 is a view depicting another planar configuration example of the pixel in the seventeenth embodiment.
[FIG. 66]

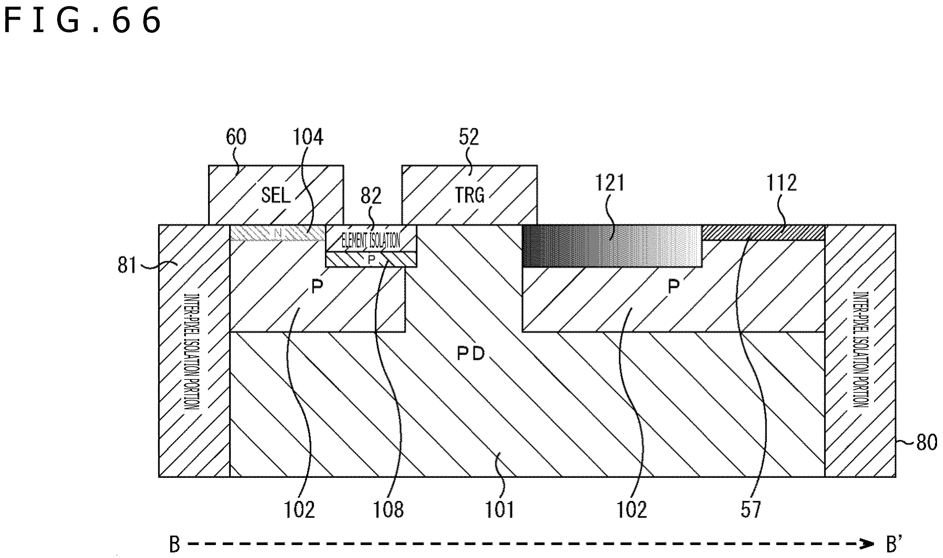

   FIG. 66 is a view depicting another sectional configuration example of the pixel in the seventeenth embodiment
[FIG. 67]

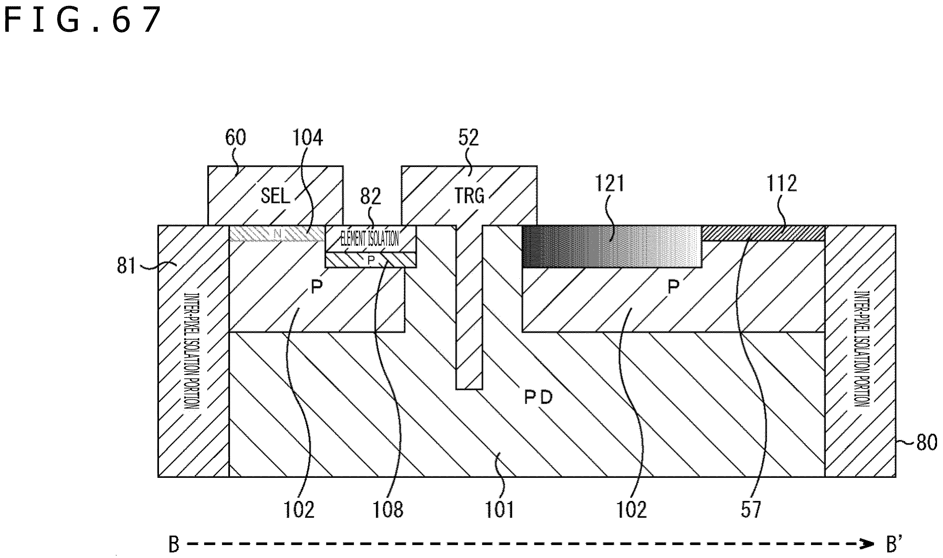

   FIG. 67 is a view depicting another sectional configuration example of the pixel in the seventeenth embodiment.
[FIG. 68]

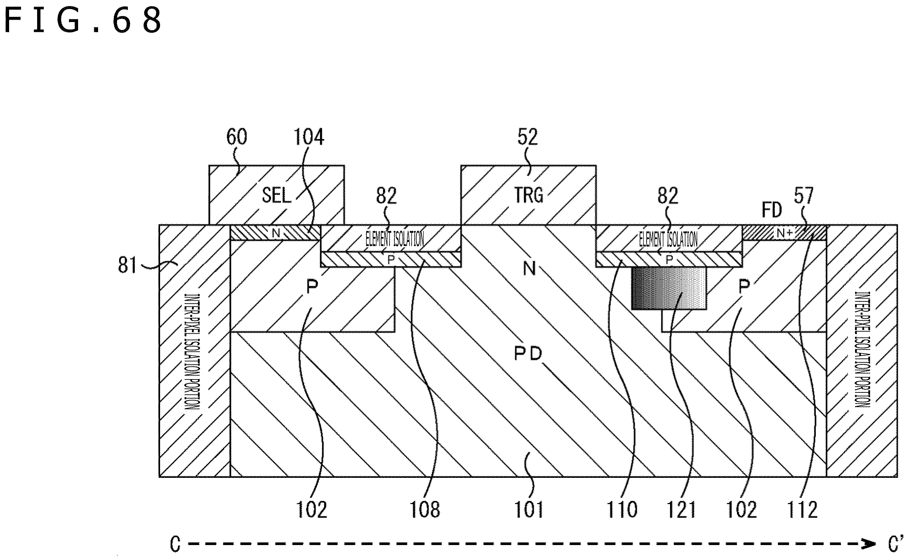

   FIG. 68 is a view depicting another sectional configuration example of the pixel in the seventeenth embodiment.
[FIG. 69]

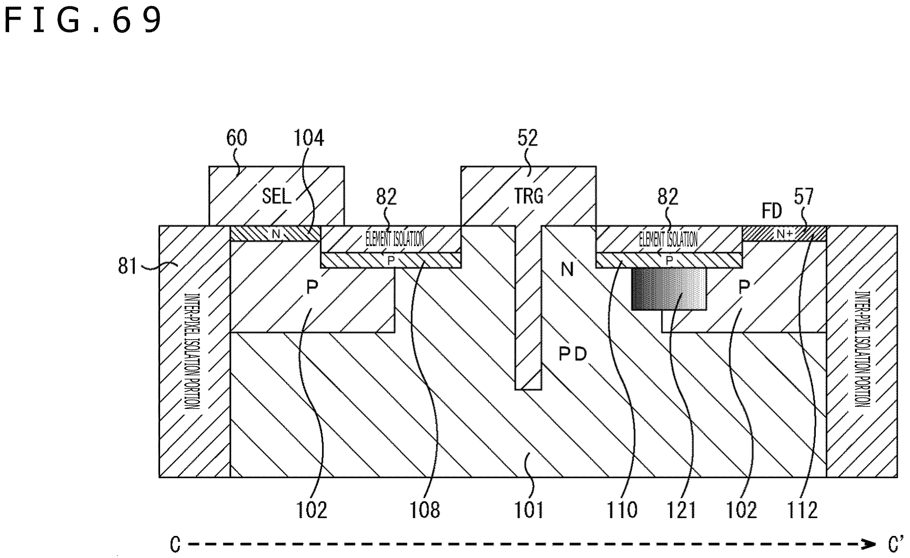

   FIG. 69 is a view depicting another sectional configuration example of the pixel in the seventeenth embodiment.
[FIG. 70]

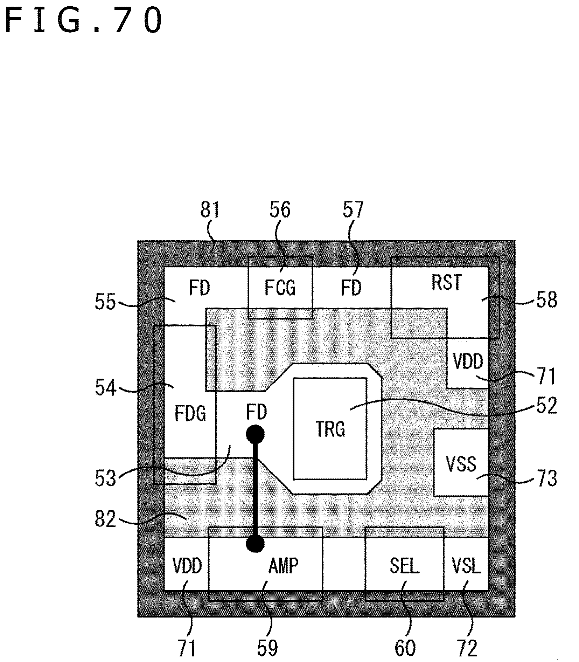

   FIG. 70 is a view depicting a planar configuration example of the pixel in an eighteenth embodiment.
[FIG. 71]

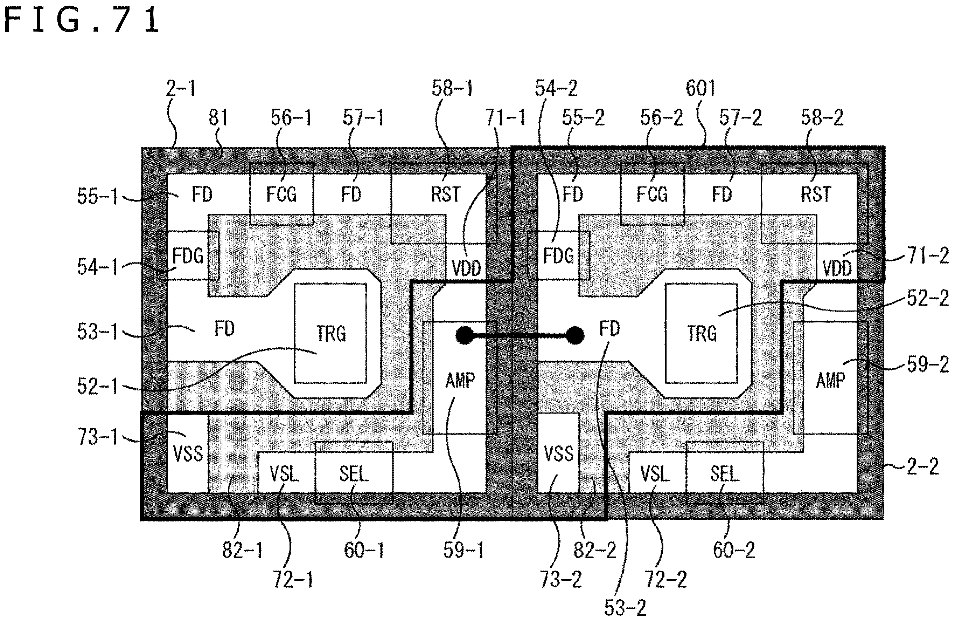

   FIG. 71 is a view depicting another planar configuration example of the pixel in the eighteenth embodiment.
[FIG. 72]

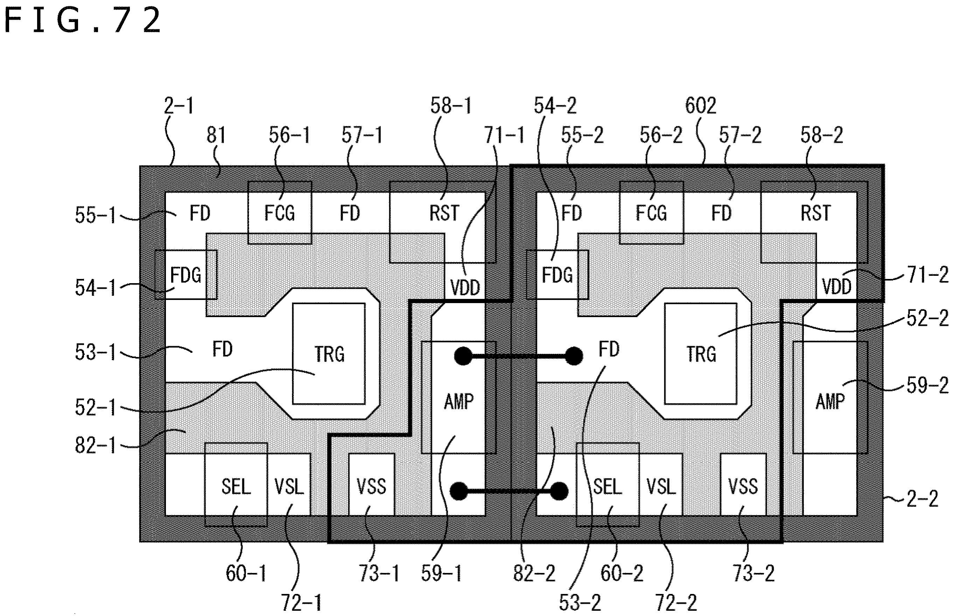

   FIG. 72 is a view depicting another planar configuration example of the pixel in the eighteenth embodiment.
[FIG. 73]

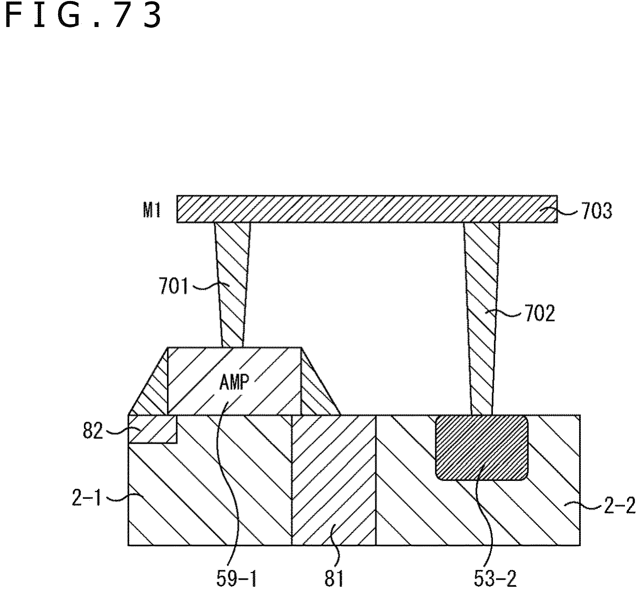

   FIG. 73 is a view depicting a sectional configuration example of a portion relating to connection of the pixels.
[FIG. 74]

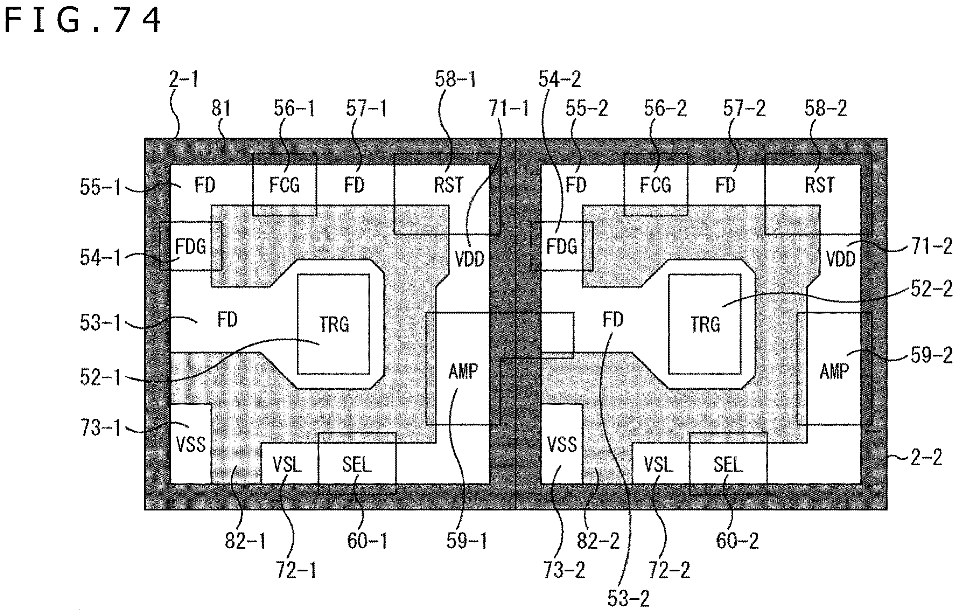

   FIG. 74 is a view depicting a planar configuration example of the pixel in a nineteenth embodiment.
[FIG. 75]

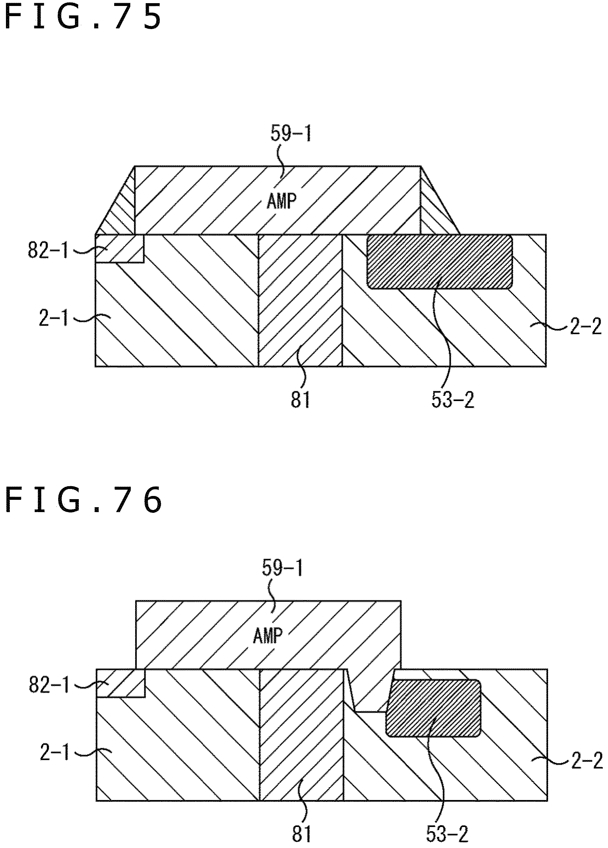

   FIG. 75 is a view depicting a sectional configuration example of the pixel in the nineteenth embodiment.
[FIG. 76]
   FIG. 76 is a view depicting another sectional configuration example of the pixel in the nineteenth embodiment.
[FIG. 77]

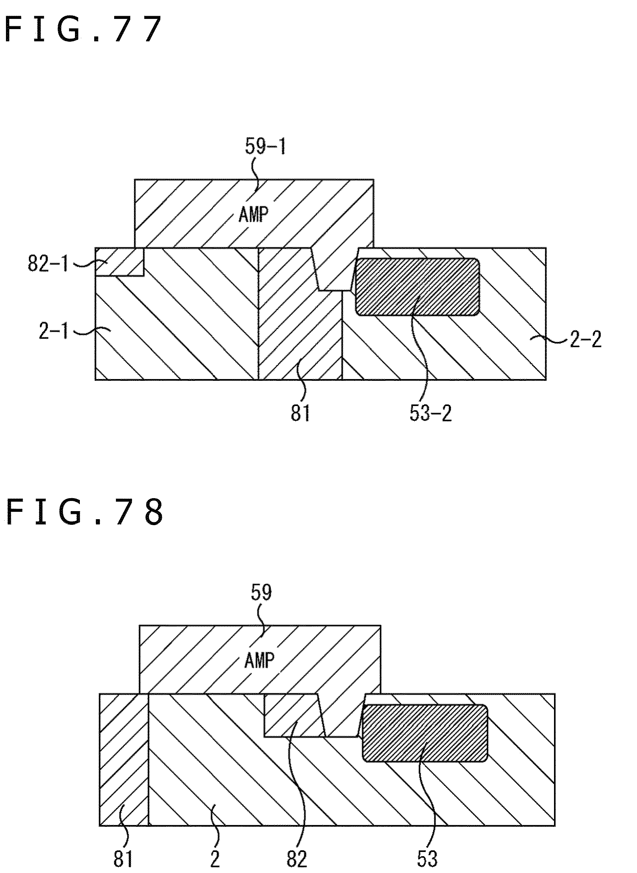

   FIG. 77 is a view depicting another sectional configuration example of the pixel in the nineteenth embodiment.
[FIG. 78]
   FIG. 78 is a view depicting another sectional configuration example of the pixel in the nineteenth embodiment.
[FIG. 79]

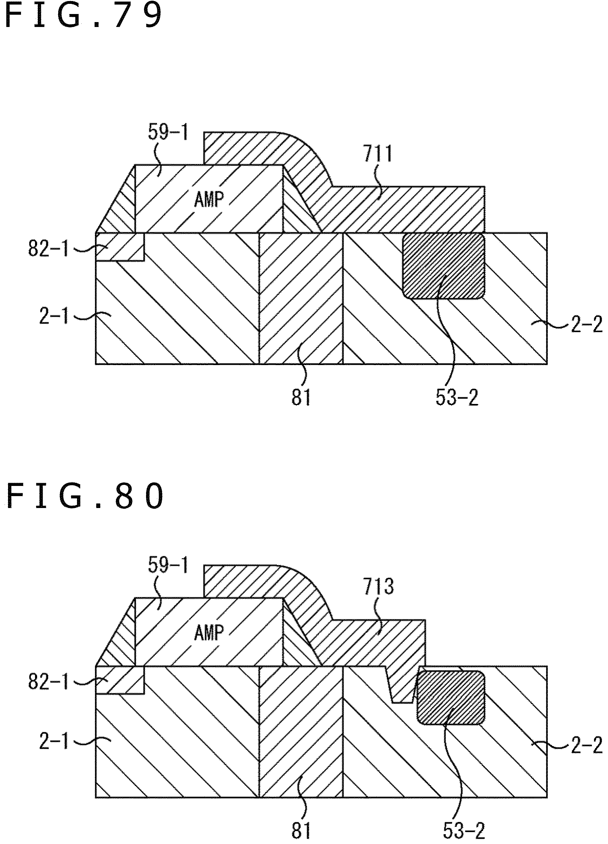

   FIG. 79 is a view depicting another sectional configuration example of the pixel in the nineteenth embodiment.
[FIG. 80]
   FIG. 80 is a view depicting another sectional configuration example of the pixel in the nineteenth embodiment.
[FIG. 81]

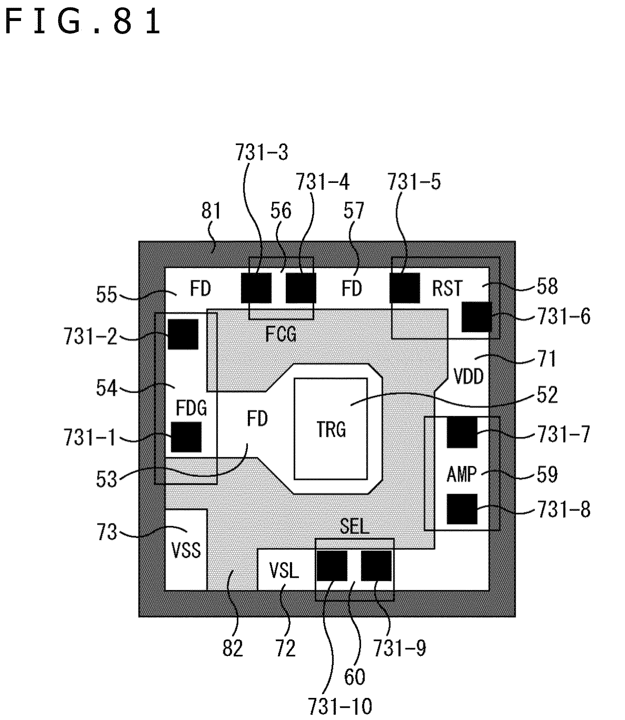

   FIG. 81 is a view depicting a planar configuration example of the pixel in a twentieth embodiment.
[FIG. 82]

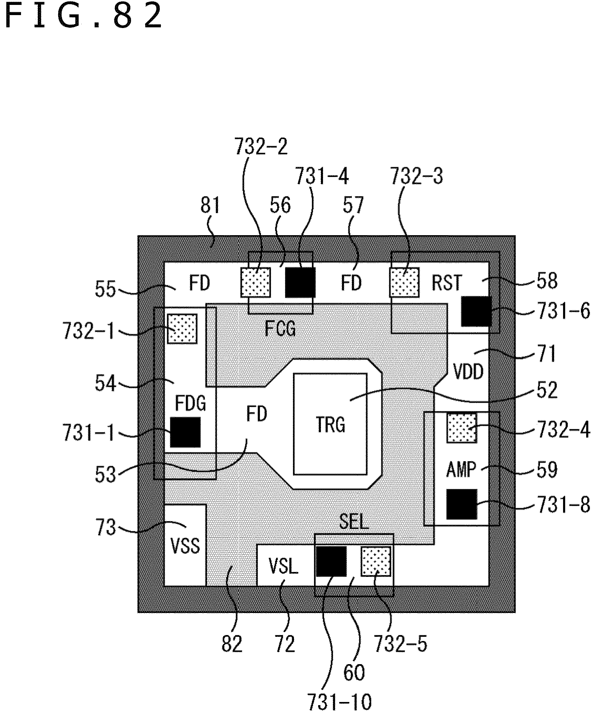

   FIG. 82 is a view depicting another planar configuration example of the pixel in the twentieth embodiment.
[FIG. 83]

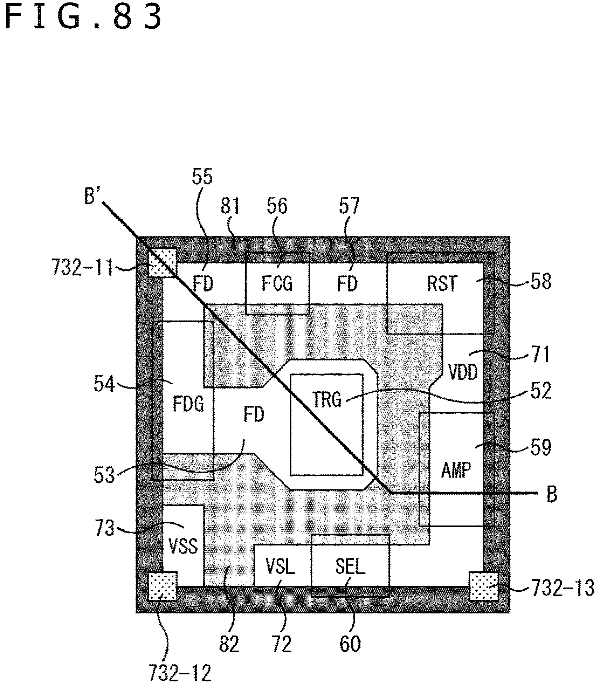

   FIG. 83 is a view depicting another planar configuration example of the pixel in the twentieth embodiment.
[FIG. 84]

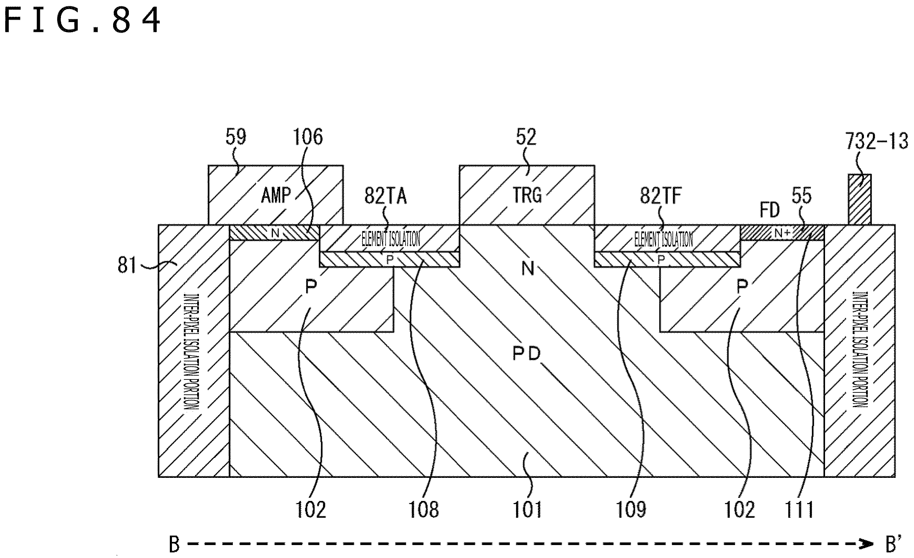

   FIG. 84 is a view depicting another sectional configuration example of the pixel in the twentieth embodiment=
[FIG. 85]

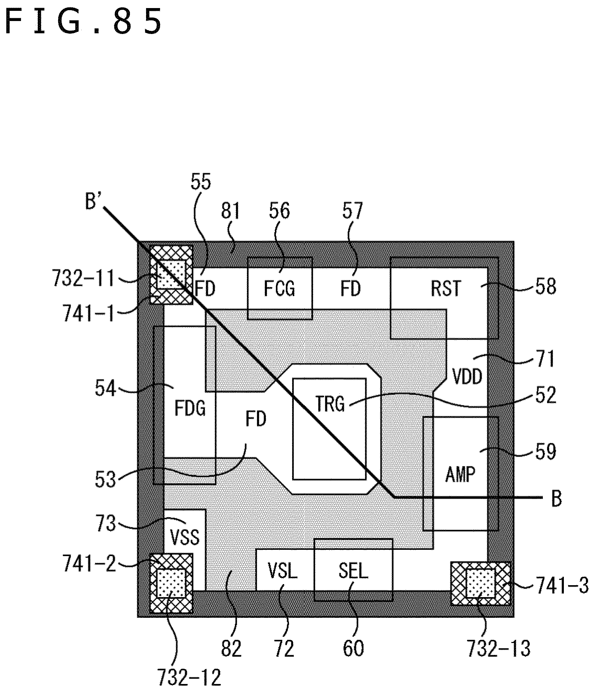

   FIG. 85 is a view depicting another planar configuration example of the pixel in the twentieth embodiment.
[FIG. 86]

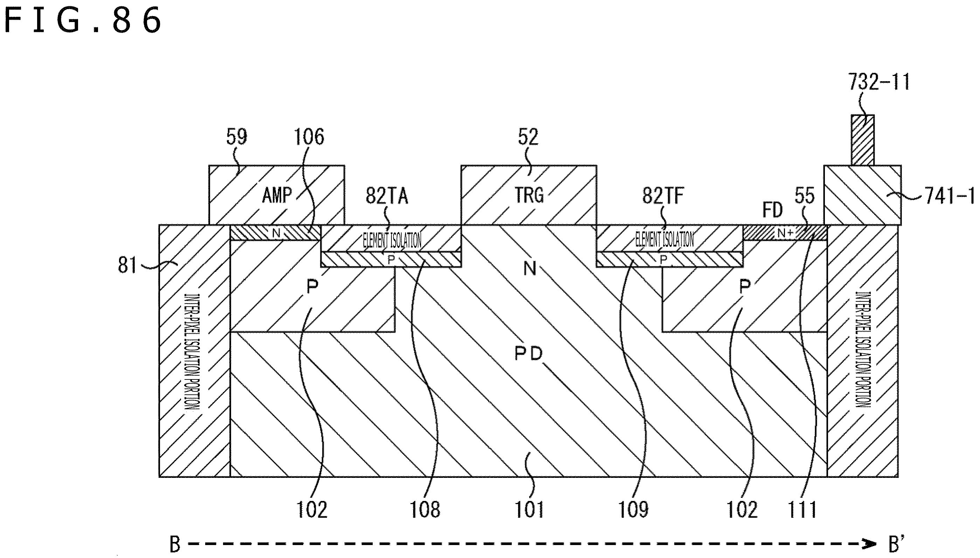

   FIG. 86 is a view depicting another sectional configuration example of the pixel in the twentieth embodiment.
[FIG. 87]

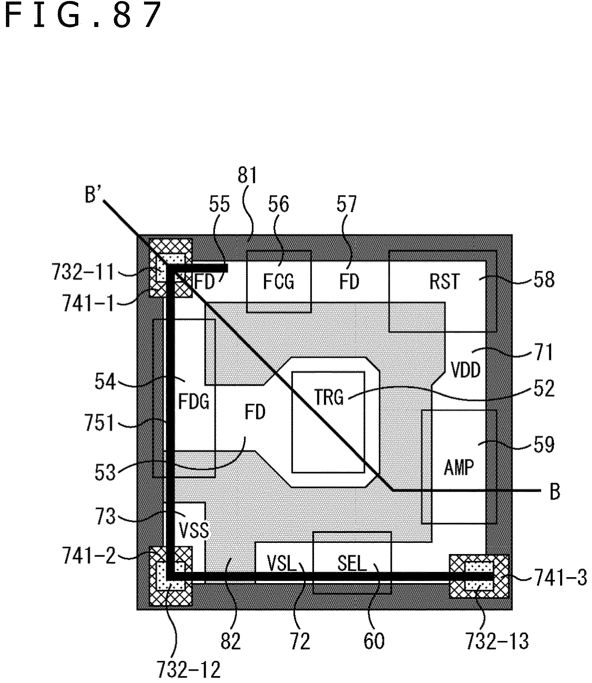

   FIG. 87 is a view depicting another planar configuration example of the pixel in the twentieth embodiment.
[FIG. 88]

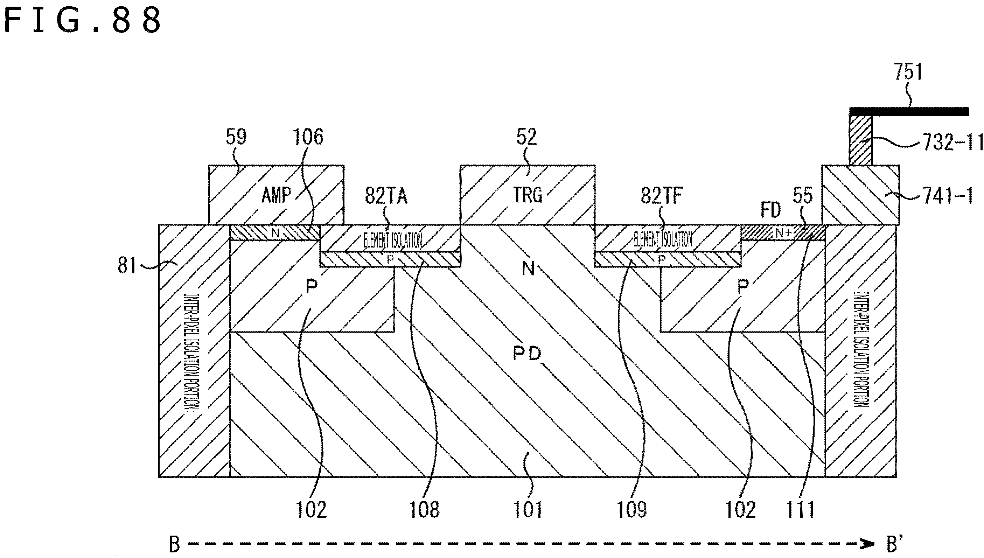

   FIG. 88 is a view depicting another sectional configuration example of the pixel in the twentieth embodiment.
[FIG. 89]

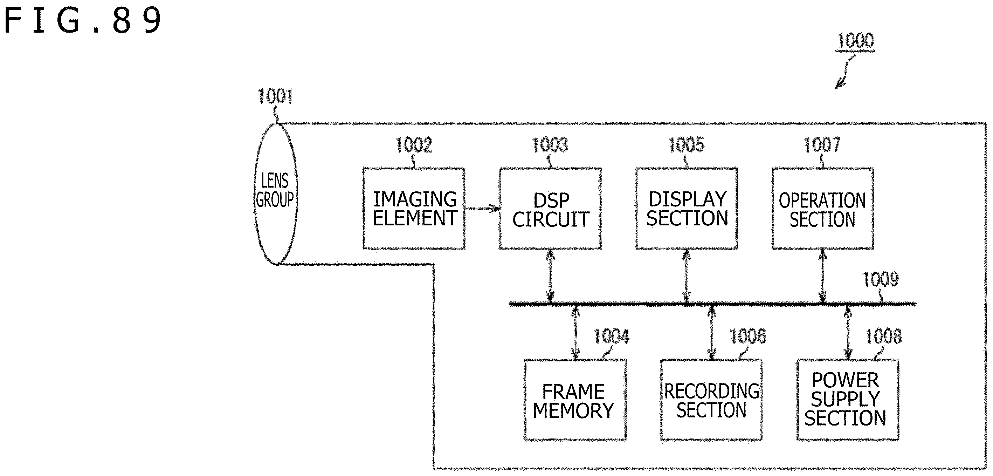

   FIG. 89 is a view depicting a configuration example of electronic equipment.
[FIG. 90]

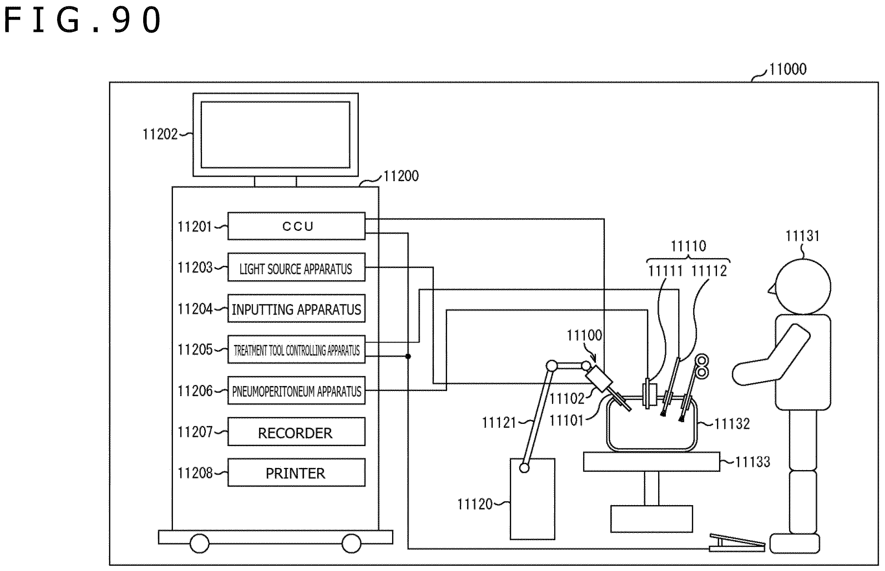

   FIG. 90 is a view depicting an example of a schematic configuration of an endoscopic surgery system.
[FIG. 91]

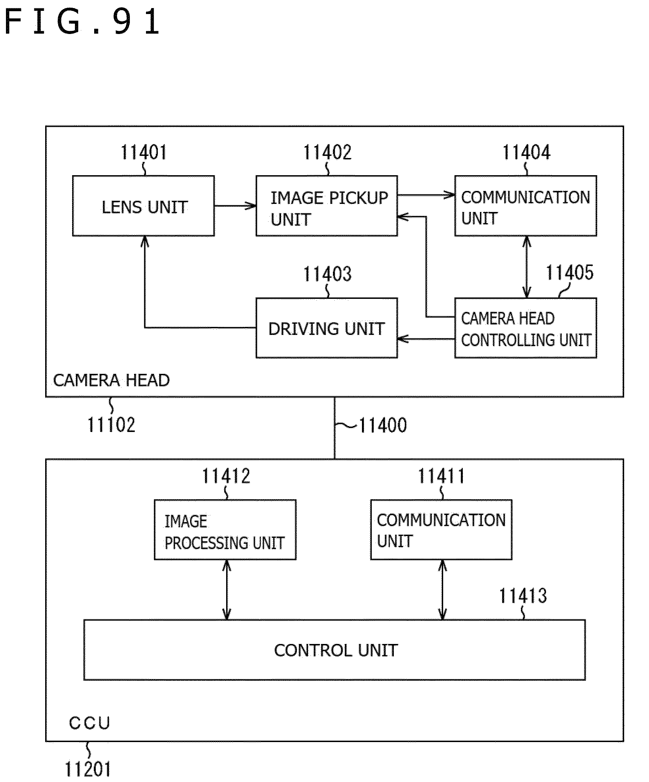

   FIG. 91 is a block diagram depicting an example of a functional configuration of a camera head and a camera control unit (CCU).
[FIG. 92]

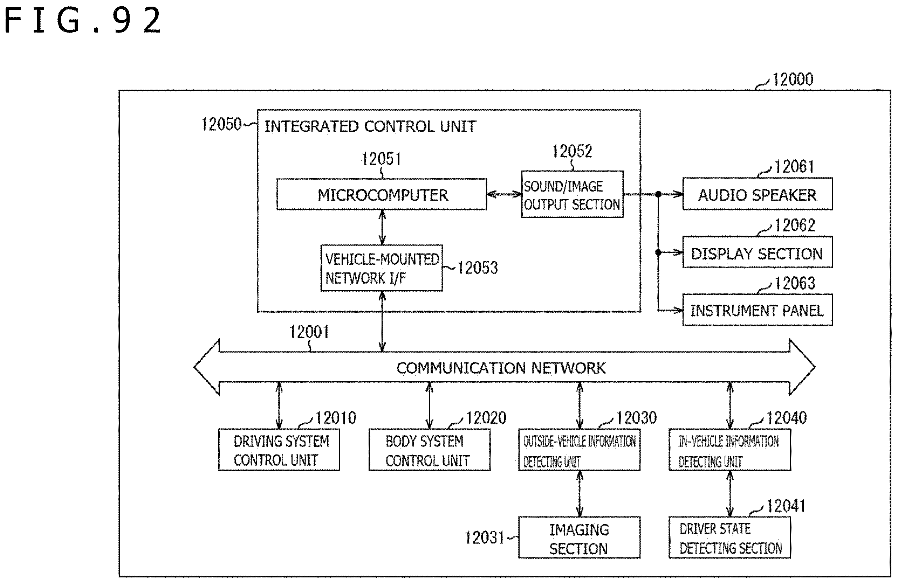

   FIG. 92 is a block diagram depicting an example of schematic configuration of a vehicle control system.
[FIG. 93]

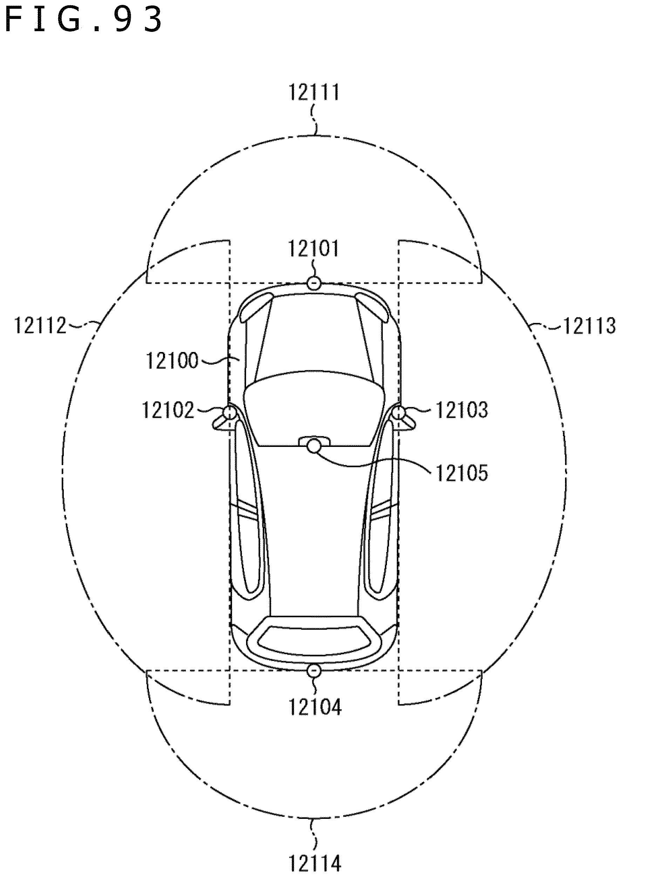

   FIG. 93 is a diagram of assistance in explaining an example of installation positions of an outside-vehicle information detecting section and an imaging section.

### [Description of Embodiments]

Modes (hereinafter, referred to as embodiments) for carrying out the present technology are described below.

### <Configuration Example of Imaging Apparatus>

FIG. 1 depicts a configuration example in an embodiment of an imaging apparatus to which the present technology is applied.

An imaging apparatus 1 of FIG. 1 has a pixel array unit 3 in which pixels 2 are arranged in a two-dimensional array manner and a peripheral circuit portion around it. The peripheral circuit portion includes a vertical drive circuit 4, column signal processing circuits 5, a horizontal drive circuit 6, an output circuit 7, a control circuit 8, and the like.

The pixel 2 has a photodiode as a photoelectric conversion element and a plurality of pixel transistors. The plurality of pixel transistors are, for example, a transfer transistor, a selection transistor, a reset transistor, an amplification transistor, and the like and include MOS transistors.

The control circuit 8 receives an input clock and data to make a command of an operation mode and the like, and outputs data of internal information of the imaging apparatus 1 and the like. That is, the control circuit 8 generates a clock signal and a control signal which serve as the basis of operation of the vertical drive circuit 4, the column signal processing circuits 5, the horizontal drive circuit 6, and the like on the basis of a vertical synchronization signal, a horizontal synchronization signal, and a master clock. The control circuit 8 outputs the generated clock signal and control signal to the vertical drive circuit 4, the column signal processing circuits 5, the horizontal drive circuit 6, and the like.

The vertical drive circuit 4 includes, for example, a shift register, and selects a predetermined pixel drive line 10 and supplies a pulse for driving the pixels 2 to the selected pixel drive line 10 to drive the pixels 2 in units of row. That is, the vertical drive circuit 4 executes selective scanning of each pixel 2 of the pixel array unit 3 in units of row sequentially in the vertical direction, and causes pixel signals based on a signal charge generated depending on the amount of received light in the photoelectric conversion portion of each pixel 2 to be supplied to the column signal processing circuits 5 through vertical signal lines 9.

The column signal processing circuits 5 are disposed for each column of the pixels 2, and execute signal processing such as denoising for signals output from the pixels 2 on one row for each pixel column. For example, the column signal processing circuits 5 execute signal processing of CDS (Correlated Double Sampling) or DDS (double data sampling) for removing fixed pattern noise specific to the pixel, AD conversion, and the like.

The horizontal drive circuit 6 includes, for example, a shift register, and selects each of the column signal processing circuits 5 in turn by sequentially outputting a horizontal scanning pulse to cause the pixel signal to be output from each of the column signal processing circuits 5 to a horizontal signal line 11.

The output circuit 7 executes signal processing for the signal sequentially supplied from each of the column signal processing circuits 5 through the horizontal signal line 11 and outputs the resulting signal. The output circuit 7 executes, for example, only buffering in some cases, and black level adjustment, column variation correction, various kinds of digital signal processing, and the like are executed in other cases. An input/output terminal 13 exchanges signals with the external.

The imaging apparatus 1 configured as above is a CMOS image sensor referred to as a column AD type in which the column signal processing circuit 5 which executes the CDS processing or the DDS processing and the AD conversion processing is disposed on each pixel column.

### <Circuit Configuration Example of Pixel>

A configuration of the unit pixel disposed in the pixel array unit 3 is described. The unit pixel disposed in the pixel array unit 3 is configured as depicted in FIG. 2, for example. It is to be noted that a part corresponding to the case in FIG. 1 is given the same reference sign in FIG. 2 and description thereof is omitted as appropriate.

The pixel 2 which is the unit pixel has a photoelectric conversion portion 51, a first transfer transistor 52, a first FD (Floating Diffusion) portion 53, a second transfer transistor 54, a second FD portion 55, a third transfer transistor 56, a third FD portion 57, a reset transistor 58, an amplification transistor 59, and a selection transistor 60.

For the pixels 2, for example, a plurality of drive lines are wired as the pixel drive lines 10 for each pixel row. Further, a drive signal TRG, a drive signal FDG, a drive signal FCG, a drive signal RST, and a drive signal SEL are supplied to the first transfer transistor 52, the second transfer transistor 54, the third transfer transistor 56, the reset transistor 58, and the selection transistor 60, respectively, from the vertical drive circuit 4 through the plurality of drive lines.

These drive signals are pulse signals which are in an active state when being in a high level (for example, supply voltage VDD) state and are in an inactive state when being in a low level state (for example, negative potential). That is, when the respective drive signals from the drive signal TRG to the drive signal SEL are set to the high level, the transistors of the supply destinations thereof become the conductive state, namely, the on-state. When the respective drive signals are set to the low level, the transistors of the supply destinations thereof become the non-conductive state, namely, the off-state.

The photoelectric conversion portion 51 includes, for example, a photodiode of a PN junction. The photoelectric conversion portion 51 receives incident light and executes photoelectric conversion to accumulate charge obtained as a result.

The first transfer transistor 52 is disposed between the photoelectric conversion portion 51 and the first FD portion 53. The drive signal TRG is supplied to the gate electrode of the first transfer transistor 52. When this drive signal TRG becomes the high level, the first transfer transistor 52 is turned on, and the charge accumulated in the photoelectric conversion portion 51 is transferred to the first FD portion 53 through the first transfer transistor 52.

The first FD portion 53, the second FD portion 55, and the third FD portion 57 are each a floating diffusion region referred to as floating diffusion, and function as the accumulation portions which temporarily accumulate a transferred charge and charge which has overflowed from the photoelectric conversion portion 51.

The second transfer transistor 54 is disposed between the first FD portion 53 and the second FD portion 55. The drive signal FDG is supplied to the gate electrode of the second transfer transistor 54. When this drive signal FDG becomes the high level, the second transfer transistor 54 is turned on, and charge from the first FD portion 53 is transferred to the second FD portion 55 through the second transfer transistor 54.

Through the turning-on of the second transfer transistor 54, the region in which charge is accumulated becomes the region obtained by combining the first FD portion 53 with the second FD portion 55, and the conversion efficiency when the charge generated in the photoelectric conversion portion is converted to a voltage can be switched. The second transfer transistor 54 functions as a conversion efficiency switching transistor which switches the conversion efficiency.

The third transfer transistor 56 is disposed between the second FD portion 55 and the third FD portion 57. The drive signal FCG is supplied to the gate electrode of the third transfer transistor 56. When this drive signal FCG becomes the high level, the third transfer transistor 56 is turned on, and charge from the second FD portion 55 is transferred to the third FD portion 57 through the third transfer transistor 56.

Through the turning-on of the third transfer transistor 56, the region in which charge is accumulated becomes the region obtained by combining the first FD portion 53, the second FD portion 55, and the third FD portion 57, and the conversion efficiency when the charge generated in the photoelectric conversion portion is converted to a voltage can be switched. The third transfer transistor 56 functions as a conversion efficiency switching transistor which switches the conversion efficiency.

It is also possible to employ a configuration in which an MIM (Metal-Insulator-Metal) capacitive element is connected to either one of or both of the second FD portion 55 and the third FD portion 57. The MIM capacitive element is a trench-type capacitor and has, for example, a three-dimensional structure with a U-shape and is thus configured to be capable of obtaining relatively high capacitance with a small mounting area. It is also possible to use a different capacitive element other than the MIM capacitive element. For example, the capacitive element may be an MOM (Metal Oxide Metal) capacitive element, a Poly-Poly capacitive element (capacitive element in which opposite electrodes both include polysilicon), or additional capacitance including parasitic capacitance or the like formed by an interconnect.

The reset transistor 58 is connected between a power supply VDD and the third FD portion 57. The drive signal RST is supplied to the gate electrode of the reset transistor 58. When the drive signal RST is set to the high level, the reset transistor 58 is turned on, and the potential of the third FD portion 57 is reset to the level of the supply voltage VDD.

The amplification transistor 59 has the gate electrode connected to the first FD portion 53 and the drain connected to the power supply VDD, and serves as an input portion of a readout circuit which reads out a signal corresponding to the charge held by the first FD portion 53, a generally-called source follower circuit. That is, the source of the amplification transistor 59 is connected to the vertical signal line 9 through the selection transistor 60. This makes the amplification transistor 59 form the source follower circuit with a constant current source (not depicted) connected to one end of the vertical signal line 9.

The selection transistor 60 is connected between the source of the amplification transistor 59 and the vertical signal line 9. The drive signal SEL is supplied to the gate electrode of the selection transistor 60. When the drive signal SEL is set to the high level, the selection transistor 60 is turned on and the pixel 2 becomes the selected state. As a result, the pixel signal output from the amplification transistor 59 is output to the vertical signal line 9 through the selection transistor 31.

It is to be noted that, hereinafter, the respective drive signals becoming the active state, namely, the high level, is expressed also as turning-on of the respective drive signals and the respective drive signals becoming the inactive state, namely, the low level, is expressed also as turning-off of the respective drive signals.

The pixel 2 depicted in FIG. 2 includes the first FD portion 53, the second FD portion 55, and the third FD portion 57, and these FD portions are connected in series to make a configuration in which the conversion efficiency when the charge generated in the photoelectric conversion portion is converted to a voltage can be switched at three stages.

High conversion efficiency (HCG) is configured by the first FD portion 53. Middle conversion efficiency (MCG) is configured by (the first FD portion 53 + the second FD portion 55). Low conversion efficiency (LCG) is configured by (the first FD portion 53 + the second FD portion 55 + the third FD portion 57).

Through turning-on of the first transfer transistor 52, charge accumulated in the photoelectric conversion portion 51 is received by the first FD portion 53 (high conversion efficiency) or (the first FD portion 53 + the second FD portion 55) (middle conversion efficiency) and is output.

A configuration is made in which, at the time of high illuminance, the charge accumulated in the photoelectric conversion portion 51 overflows to the side of the first FD portion 53 beyond the first transfer transistor 52 and is accumulated in the first FD portion 53, the second FD portion 55, and the third FD portion 57.

At the time of a small signal when the amount of received light is small, the conversion efficiency is switched to the high conversion efficiency with which charge is accumulated in the first FD portion 53. At the time of a large signal when the amount of received light is large, the conversion efficiency is switched to the low conversion efficiency with which charge is accumulated in (the first FD portion 53 + the second FD portion 55 + the third FD portion 57). Here, further, the middle conversion efficiency between the high conversion efficiency and the low conversion efficiency is set, so that conversion efficiency with which charge is accumulated in (the first FD portion 53 + the second FD portion 55) is set.

The charge which has overflowed from the photoelectric conversion portion 51 and is accumulated in the first FD portion 53, the second FD portion 55, and the third FD portion 57 is received by (the first FD portion 53 + the second FD portion 55 + the third FD portion 57) and is output together with the charge accumulated in the photoelectric conversion portion 51.

Readout of each of the high conversion efficiency, the middle conversion efficiency, and the low conversion efficiency is separately subjected to AD conversion, and which readout signal to use is determined from the amount of readout signal of each efficiency. Two readout signals may be blended to be used in a bridge part between the signal of the high conversion efficiency and the signal of the middle conversion efficiency and a bridge part between the signal of the middle conversion efficiency and the signal of the low conversion efficiency. Image quality deterioration in the bridge part is suppressed by use of the blended signal.

Disposing the FD portions at three places as above can make a configuration in which, for example, 160 uV/e, 80 uV/e, and 10 uV/e are implemented with the high conversion efficiency, the middle conversion efficiency, and the low conversion efficiency, respectively, and the three conversion efficiencies are used. This can suppress the S/N step of the bridge part.

### <About Operation of Pixel 2>

Operation of the pixel 2 is described with reference to FIGs. 3 and 4. Here, the description is given by taking operation of the pixel 2 having the circuit configuration depicted in FIG. 2 as an example. FIG. 3 is a timing chart for explaining the operation of the pixel 2. FIG. 4 is a potential diagram for explaining the operation of the pixel 2.

In FIG. 3, HGC, MCG, and LCG represent the high conversion efficiency, the middle conversion efficiency, and the low conversion efficiency, respectively. In FIG. 4, PD represents a PD 51. TRG represents the first transfer transistor 52. FD1 represents the first FD portion 53. FDG represents the second transfer transistor 54. FD2 represents the second FD portion 55. FCG represents the third transfer transistor 56. FD3 represents the third FD portion 57. RST represents the reset transistor 58.

A clock time T1 is a clock time immediately after execution of shutter operation. Described with reference to FIG. 3, immediately after the execution of the shutter operation, the drive signal SEL supplied to the selection transistor 60, the drive signal RST supplied to the reset transistor 58, the drive signal FCG supplied to the third transfer transistor 56, the drive signal FDG supplied to the second transfer transistor 54, and the drive signal TRG supplied to the first transfer transistor 52 are in the off-state.

Referring to FIG. 4, immediately after the execution of the shutter operation, the PD 51, the first FD portion 53, the second FD portion 55, and the third FD portion 57 are in the off-state, and are in the state in which a signal is not accumulated.

An exposure period starts from the clock time T1, and photoelectric conversion in the PD 51 is executed and a signal is accumulated in the PD 51. Here, in the case in which the amount of signal has become larger relative to the number of saturated electrons, the signal overflows under the first transfer transistor 52, and the signal is accumulated in the first FD portion 53, the second FD portion 55, and the third FD portion 57 depending on the amount of signal which has overflowed.

A clock time T2 is a reset period in an MCG (middle conversion efficiency) mode. Referring to FIG. 3, in the reset period in the MCG mode, the drive signal SEL supplied to the selection transistor 60 and the drive signal FDG supplied to the second transfer transistor 54 are turned on.

In the example depicted in FIG. 4, the state in which the signal which has overflowed from the PD 51 is accumulated in the first FD portion 53 and the second FD portion 55 is depicted.

When the reset period in the MCG mode is ended, a transition to a reset period in an HCG (high conversion efficiency) mode at a clock time T3 is made. Referring to FIG. 3, in the reset period in the HCG mode, the drive signal SEL supplied to the selection transistor 60 is kept at the on-state, and the drive signal FDG supplied to the second transfer transistor 54 is switched off from the on-state.

Referring to FIG. 4, the signal accumulated in the first FD portion 53 and the second FD portion 55 is subjected to capacitance dividing due to the transition to the reset period in the HCG mode and the turning-off of the drive signal FDG supplied to the second transfer transistor 54.

When the reset period in the HCG mode has been ended, a transition to a readout period in the HCG mode at a clock time T4 is made. Referring to FIG. 3, during the transition from the clock time T3 to the clock time T4, the drive signal TRG supplied to the first transfer transistor 52 is set to the on-state for a predetermined time. Due to the turning-on of the drive signal TRG, the signal accumulated in the PD 51 is read out by the first transfer transistor 52. The readout from the PD 51 is executed by CDS (correlated double sampling) driving.

Image data during the HCG mode is generated and output by the CDS driving with use of a reset signal obtained in the reset period in the HCG mode at the clock time T3 and the signal read out in the readout period in the HCG mode at the clock time T4.

Referring to FIG. 4, due to the execution of the readout based on the HDG mode at the clock time T4, the signal accumulated in the PD 51 is read out and the PD 51 becomes the empty state, and a signal depending on the signal accumulated in the PD 51 is accumulated in each of the first FD portion 53, the second FD portion 55, and the third FD portion 57.

When the readout period in the HCG mode has been ended, a transition to a readout period in the MCG mode at a clock time T5 is made. Referring to FIG. 3, during the transition from the clock time T4 to the clock time T5, the drive signal FDG supplied to the second transfer transistor 54 is set to the on-state. Due to the turning-on of the drive signal FDG, the charge accumulated in the first FD portion 53 and the second FD portion 55 is read out.

At the clock time T5, image data during the MCG mode is generated and output by the CDS driving with use of a reset signal obtained in the reset period in the MCG mode at the clock time T2 and the signal read out in the readout period in the MCG mode at the clock time T5.

When the readout period in the MCG mode has been ended, a transition to a readout period in an LCG mode at a clock time T6 is made. Referring to FIG. 3, during the transition from the clock time T5 to the clock time T6, the drive signal FCG supplied to the third transfer transistor 56 is turned on. At the clock time T6, the second transfer transistor 54 and the third transfer transistor 56 are set to the on-state.

Due to the setting of the second transfer transistor 54 and the third transfer transistor 56 to the on-state, the signal accumulated in the first FD portion 53, the second FD portion 55, and the third FD portion 57 is read out.

When the readout period in the LCG mode has been ended, a transition to a reset period at a clock time T7 is made. In the reset period at the clock time T7, reset operation in the same state as that at the time of the shuttering is executed in order to cause a signal at the black level in a reset period in the LCG mode at a clock time T8 to be identical to a signal at the black level at the time of the shuttering.

Referring to FIG. 3, in the reset period at the clock time T7, the drive signal SEL supplied to the selection transistor 60 is set to the off-state from the clock time T6 to the clock time T8. The drive signal RST supplied to the reset transistor 58 is set to the on-state for a predetermined time in the period from the clock time T6 to the clock time T8. The drive signal FCG supplied to the third transfer transistor 56 is set to the on-state for a predetermined time in the period from the clock time T6 to the clock time T8. The drive signal FDG supplied to the second transfer transistor 54 is set to the on-state for a predetermined time in the period from the clock time T6 to the clock time T8.

Due to the execution of the reset operation in the reset period at the clock time T7, the signal accumulated in the first FD portion 53, the second FD portion 55, and the third FD portion 57 is reset as depicted in FIG. 4.

When the reset period at the clock time T7 has been ended, a transition to the reset period in the LCG mode at the clock time T8 is made. In the reset period in the LCG mode at the clock time T8, the drive signal SEL supplied to the selection transistor 60 is set to the on-state. The drive signal FCG supplied to the third transfer transistor 56 and the drive signal FDG supplied to the second transfer transistor 54 are also set to the on-state.

The readout in the LCG mode is executed by DDS (double data sampling) driving. The DDS driving is driving in which a signal charge held or accumulated in the FD is read out as a signal level and subsequently the FD is reset to a predetermined potential to read out this predetermined potential as a reset level.

Because the readout in the LCG mode is executed by the DDS driving, the signal read out in the readout period in the LCG mode at the clock time T6 and a reset signal read out in the reset period in the LCG mode at the clock time T8 are used, and image data in the LCG mode is generated and output.

At the end of the readout period in the LCG mode, the drive signal SEL, the drive signal FCG, and the drive signal FDG are turned off.

Through the execution of such a series of operation, the signal at the time of HCG (high conversion efficiency), the signal at the time of MCG (middle conversion efficiency), and the signal at the time of LCG (low conversion efficiency) are each read out. By employing such a configuration to read out the signals in three times by using the three conversion efficiencies, the deterioration of the S/N step of the bridge part can be suppressed.

### <Planar Configuration Example of Pixel>

FIG. 5 is a view depicting a planar configuration example of a surface of a silicon substrate in which the transistors of the pixel 2 are disposed.

A gate electrode TRG of the first transfer transistor 52 is formed around the center of the pixel 2. The gates of the transistors other than the first transfer transistor 52 included in the pixel 2 are disposed, with the gate electrode TRG of the first transfer transistor 52 centered. In the diagram, a gate electrode FDG of the second transfer transistor 54 is formed on the left side of the gate electrode TRG of the first transfer transistor 52. The first FD portion 53 including an N+ diffusion layer is disposed between the gate electrode TRG and the gate electrode FDG and in the silicon substrate.

A gate electrode FCG of the third transfer transistor 56 is formed on the upper side of the gate electrode TRG of the first transfer transistor 52 in the diagram. The second FD portion 55 is disposed between the second transfer transistor 54 and the third transfer transistor 56.

A gate electrode RST of the reset transistor 58 is formed on the upper right side of the gate electrode TRG of the first transfer transistor 52. The third FD portion 57 is formed between the third transfer transistor 56 and the reset transistor 58.

A gate electrode AMP of the amplification transistor 59 is formed on the right side of the gate electrode TRG of the first transfer transistor 52 in the diagram. A VDD region 71 which includes a P+ diffusion layer and is connected to the supply voltage VDD is formed between the reset transistor 58 and the amplification transistor 59.

A gate electrode SEL of the selection transistor 60 is formed on the lower side of the gate electrode TRG of the first transfer transistor 52 in the diagram. A VSL region connected to the vertical signal line 9 is formed on the left side of the selection transistor 60 in the diagram.

A VSS region 73 including a P+ diffusion layer is formed on the lower left side of the first transfer transistor 52 in the diagram.

An inter-pixel isolation portion 81 is formed to surround the pixel 2. For example, the inter-pixel isolation portion 81 is formed by FFTI (Front Full Trench Isolation). The inter-pixel isolation portion 81 can be formed by a trench which does not penetrate or penetrates a semiconductor substrate. The pixels 2 are isolated by an insulator due to the inter-pixel isolation portion 81, and the respective pixels 2 are configured to be electrically isolated.

An element isolation portion 82 is formed between the transistors configuring the pixel 2. As the element isolation portion 82, for example, a structure obtained by forming a trench with a predetermined depth in an element isolation region and burying an insulating film therein or a region formed by ion implantation is employed.

For the pixel 2, the inter-pixel isolation portion 81 is disposed in a pixel boundary region, and element isolation is established by the element isolation portion 82 in an active region. The active region is a region depicted as an open region in the diagram, and is formed with a shape continuous from the lower side of the gate electrode TRG of the first transfer transistor 52 to the VSL region 72.

Part of the element isolation portion 82 is formed in contact with the inter-pixel isolation portion 81. In the example depicted in FIG. 5, the element isolation portion 82 existing between the second transfer transistor 54 and the VSS region 73 and the element isolation portion 82 existing between the VSS region 73 and the VSL region 72 are formed in contact with the inter-pixel isolation portion 81.

The pixel transistors other than the first transfer transistor 52 (second transfer transistor 54, third transfer transistor 56, reset transistor 58, amplification transistor 59, and selection transistor 60) are not only disposed on the element isolation portion 82 as element isolation but also disposed on the inter-pixel isolation portion 81.

The gate electrodes of the pixel transistors other than the first transfer transistor 52 are configured to overlap with the inter-pixel isolation portion 81 as depicted in FIG. 5. In other words, a partial region of the gate electrodes of the pixel transistors is configured in the state in which the partial region includes a region overlapping with the inter-pixel isolation portion 81 in plan view. By making the configuration overlapping with the inter-pixel isolation portion 81, the region of the electrode gate can be ensured.

The gate electrodes of the pixel transistors other than the first transfer transistor 52 are configured to also overlap with the element isolation portion 82 as depicted in FIG. 5. In other words, a partial region of the gate electrodes of the pixel transistors is configured in the state in which the partial region includes a region overlapping with the element isolation portion 82 in plan view.

The left side of the gate electrode FDG of the second transfer transistor 54 in the diagram overlaps with the inter-pixel isolation portion 81 in plan view, and part of the right side and the lower side in the diagram overlap with the element isolation portion 82 in plan view. The upper side of the gate electrode FCG of the third transfer transistor 56 in the diagram overlaps with the inter-pixel isolation portion 81 in plan view, and the lower side in the diagram overlaps with the element isolation portion 82 in plan view.

The upper side and the right side of the gate electrode RST of the reset transistor 58 in the diagram overlap with the inter-pixel isolation portion 81 in plan view, and part of the left side and part of the lower side (lower left) in the diagram overlap with the element isolation portion 82 in plan view. The right side of the gate electrode AMP of the amplification transistor 59 in the diagram overlaps with the inter-pixel isolation portion 81 in plan view, and the left side in the diagram overlaps with the element isolation portion 82 in plan view.

The lower side of the gate electrode SEL of the selection transistor 60 in the diagram overlaps with the inter-pixel isolation portion 81 in plan view, and the upper side in the diagram overlaps with the element isolation portion 82 in plan view.

In such a manner, the transistors included in the pixel 2 other than the first transfer transistor 52 are disposed to surround the first transfer transistor. Further, each transistor included in the pixel 2 other than the first transfer transistor 52 is configured such that at least one side overlaps with the inter-pixel isolation portion 81 in plan view and the side opposite the side overlapping with the inter-pixel isolation portion 81 overlaps with the element isolation portion 82.

By disposing the transistors in such a manner, the WL dimensions of the pixel transistors which can be disposed per one pixel can be enlarged, and thus cut-off variation and amplification noise of the pixel transistors can be designed to be small. Moreover, the first transfer transistor 52 which transfers charge obtained by conversion by the photoelectric conversion portion 51 to the FD portion is disposed at the center of the pixel 2, namely, the center of the photoelectric conversion portion 51. This can make a configuration in which a signal from the photoelectric conversion portion 51 is easily transferred to the first FD portion 53.

### <Sectional Configuration Example of Pixel>

A diagram obtained by adding line segment A-A' to the pixel 2 depicted in FIG. 5 is depicted in FIG. 6. A sectional configuration example along line segment A-A' regarding the pixel 2 depicted in FIG. 6 is depicted in FIG. 7.

Referring to the sectional configuration example of the pixel 2 depicted in FIG. 7, the pixel 2 includes a semiconductor substrate 80 and a multilayer interconnect layer (not depicted) formed on the front surface side thereof (upper side in the diagram). In FIG. 7, the lower side is the light incident surface side and is a side on which on-chip lenses, a color filter, and the like which are not depicted are disposed. In FIG. 7, the upper side is the interconnect layer side, and a plurality of transistors are formed thereon.

The semiconductor substrate 80 includes, for example, silicon (hereinafter, referred to as Si) and is formed to have a thickness of, for example, 1 to 10 µm. In the semiconductor substrate 80, for example, a semiconductor region 101 of an N-type (second conductivity type) is formed in units of pixel in a semiconductor region 102 of a P-type (first conductivity type). Thus, a photodiode PD is formed in units of pixel.

Between the pixels 2 of the semiconductor substrate 80, the inter-pixel isolation portion 81 which isolates adjacent pixels from each other in the depth direction of the semiconductor substrate 80 is formed from the back surface side (light incident surface side) of the semiconductor substrate 80 to a predetermined depth in the substrate depth direction. The depth to which the inter-pixel isolation portion 81 is formed in the substrate thickness direction can be set to any depth. In the example depicted in FIG. 7, the case is depicted in which the inter-pixel isolation portion 81 penetrates from the back surface side of the semiconductor substrate 80 to the front surface side and complete isolation is established in units of pixel. It is also possible to employ a configuration in which an outer circumferential portion including the sidewall of the inter-pixel isolation portion 81 is covered by an antireflection film including a layer including a hafnium oxide film or the like. It is also possible that the inter-pixel isolation portion 81 is configured to have functions of preventing incident light from penetrating to the adjacent pixel 2 to confine the incident light in the pixel and preventing the leakage and entry of incident light from the adjacent pixel 2.

Meanwhile, on the front surface side of the semiconductor substrate 80 on which the multilayer interconnect layer is formed, one first transfer transistor 52 is formed for one photodiode PD formed in each pixel 2. The gate electrode TRG of the first transfer transistor 52 is connected to the N-type region of the photodiode PD. An N+ region 105 which is the first FD portion 53 is formed on the left side of the first transfer transistor 52 in the diagram.

The element isolation portion 82 is formed on the left side of the first FD portion 53 in the diagram. This element isolation portion 82 includes, for example, an oxide film and is disposed to isolate the transistors of the pixel 2. A pinning film 107 is formed on the lower side of the element isolation portion 82. The pinning film 107 is formed at a boundary portion between the element isolation portion 82 and the P-type semiconductor region 102 and is, for example, a fixed charge film having a negative fixed charge. The pinning film 107 is formed with use of, for example, hafnium oxide (HfO2), zirconium dioxide (ZrO2), tantalum oxide (Ta2O5), or the like.

Due to the disposing of the pinning film 107, a positive charge (hole) accumulation region is formed at the boundary portion of the semiconductor substrate 80 of silicon, and the occurrence of a dark current can be suppressed.

The selection transistor 60 is formed on the left side of the element isolation portion 82 in the diagram. A channel 104 is formed by an N-type region on the lower side of the gate electrode SEL of the selection transistor 60.

As depicted in FIG. 7, the gate electrode SEL of the selection transistor 60 is formed with such a position and a size that one side includes a region overlapping with the element isolation portion 82 and the other side includes a region overlapping with the inter-pixel isolation portion 81. It is to be noted that, although the gate electrode SEL is depicted with a rectangular shape in FIG. 7, a configuration in which a sidewall is also included or is not included in this rectangle is employed. When the sidewall is also included in the gate electrode SEL, the gate electrode SEL may be configured such that part of the sidewall overlaps with the element isolation portion 82 and overlaps with the inter-pixel isolation portion 81. A similar configuration can be employed also regarding the other transistors.

The element isolation portion 82 is formed on the right side of the first transfer transistor 52 in the diagram. A pinning film 108 is formed on the lower side of the element isolation portion 82. The amplification transistor 59 is formed on the right side of this element isolation portion 82 in the diagram. A channel 106 is formed by an N-type region on the lower side of the gate electrode AMP of the amplification transistor 59.

As depicted in FIG. 7, the gate electrode AMP of the amplification transistor 59 is formed with such a position and a size that one side includes a region overlapping with the element isolation portion 82 and the other side includes a region overlapping with the inter-pixel isolation portion 81.

As above, the transistors disposed around the first transfer transistor 52, for example, in FIG. 7, the selection transistor 60 and the amplification transistor 59, are configured such that one side exists on the inter-pixel isolation portion 132 and the other side exists on the element isolation portion 82.

The gate electrode TRG of the first transfer transistor 52 may have a configuration in which a gate is disposed also in the perpendicular direction like one depicted in FIG. 8. Referring to FIG. 8, the photodiode PD is configured as the buried photodiode PD, and a configuration in which part of the gate electrode TRG of the first transfer transistor 52 is disposed to reach part of the photodiode PD is made.

The gate electrode TRG of the first transfer transistor 52 is formed into a configuration having a gate disposed on the front surface of the semiconductor substrate 80 (gate disposed in the horizontal direction) and a gate disposed to the inside of the N-type semiconductor region 101 of the photodiode PD in the semiconductor substrate 80 (gate disposed in the perpendicular direction).

It is also possible to employ such a configuration using the vertical transistor having the gate also in the vertical direction. Here, the description has been given by taking as an example the case in which the first transfer transistor 52 is the vertical transistor. However, the present technology can be applied also to the case in which the transistor other than the first transfer transistor 52 is the vertical transistor.

### <Second Embodiment>

FIG. 9 is a view depicting a planar configuration example of the pixel 2 in a second embodiment. In the configuration of the pixel 2 depicted in FIG. 9, a part similar to that in the pixel 2 in the first embodiment depicted in FIG. 5 is given a similar reference sign, and description thereof is omitted as appropriate.

Compared with the pixel 2 depicted in FIG. 5, the pixel 2 depicted in FIG. 9 is different in that part of the element isolation portion 82 is formed by ion implantation, and is similar regarding the other points.

In the pixel 2 depicted in FIG. 9, an element isolation portion 131-1 formed by ion implantation is employed as the element isolation portion 82 disposed between the VSL region 72 and the VSS region 73. Further, in the pixel 2 depicted in FIG. 9, an element isolation portion 131-2 formed by ion implantation is employed as the element isolation portion 82 disposed between the VSS region 73 and the second transfer transistor 54.

The element isolation portion 131 is, for example, an element isolation portion formed by doping the semiconductor substrate 80 with a P-type impurity.

In the example depicted in FIG. 9, in the element isolation portion 82, the element isolation portion 131 formed by ion implantation is employed as the element isolation portion 82 in the region in contact with the inter-pixel isolation portion 81. The manufacturing is made easy by forming the element isolation portion 82 in the region in contact with the inter-pixel isolation portion 81 by ion implantation as above.

### <Third Embodiment>

FIG. 10 is a view depicting a planar configuration example of the pixel 2 in a third embodiment. In the configuration of the pixel 2 depicted in FIG. 10, a part similar to that in the pixel 2 in the first embodiment depicted in FIG. 5 is given a similar reference sign and description thereof is omitted as appropriate.

Compared with the pixel 2 depicted in FIG. 5, the pixel 2 depicted in FIG. 10 is different in that a region formed by ion implantation is employed as the whole of the element isolation portion 82, and is similar regarding the other points.

In the pixel 2 depicted in FIG. 10, the element isolation portion 131 formed by ion implantation is employed as the element isolation portion 82. The element isolation portion 131 is, for example, an element isolation portion formed by doping the semiconductor substrate 80 with a P-type impurity.

It is also possible to make the configuration in which the element isolation portion 131 formed by ion implantation is employed as the element isolation portion as above.

FIG. 11 is a view depicting a sectional configuration example of the pixel 2 along line segment A-A' depicted in FIG. 10. The sectional configuration example of the pixel 2 depicted in FIG. 11 is similar to the sectional configuration example of the pixel 2 depicted in FIG. 7 except that the element isolation portion 82 is replaced by the element isolation portion 131.

The element isolation portion 131 disposed between the first FD portion 53 and the selection transistor 60 is the element isolation portion formed by ion implantation. The element isolation portion 131 disposed between the first transfer transistor 52 and the amplification transistor 59 is the element isolation portion formed by ion implantation.

It is also possible to employ the configuration in which the element isolation portion is formed as the region which is formed by ion implantation and is doped with, for example, a P-type impurity as above.

### <Position of Contact>

FIG. 12 is a view for explaining a position at which a contact which fixes the substrate potential for each pixel is disposed. FIG. 12 depicts a sectional configuration example of the pixel 2. This sectional configuration example basically has a configuration similar to the sectional configuration example of the pixel 2 depicted in FIG. 7.

The contact for supplying the substrate potential can be configured to be shared from the back surface side. In FIG. 12, contacts 151 are each disposed on the lower side (back surface side) of the left side and the right side in the diagram. This contact 151 is connected to a P+ layer which is formed on a side surface of the inter-pixel isolation portion 81 and has a high P-type impurity concentration. For example, this contact 151 is connected to the supply voltage VSS and is connected to a place provided with the voltage VSS in the pixel 2.

### <Fourth Embodiment>

FIG. 13 is a view depicting a circuit configuration example of the pixel 2 in a fourth embodiment. The pixel 2 in the above-described first to third embodiments has been described by giving the configuration example having the three FD portions. However, the present technology can be applied also to a configuration having two FD portions as depicted in FIG. 13. In the circuit diagram of the pixel 2 depicted in FIG. 13, a part similar to that in the circuit diagram of the pixel 2 depicted in FIG. 2 is given the same reference sign and description thereof is omitted as appropriate.

The pixel 2 depicted in FIG. 13 is formed into a configuration obtained by deleting the third transfer transistor 56 and the third FD portion 57 from the pixel 2 depicted in FIG. 2. That is, the pixel 2 depicted in FIG. 13 has the photoelectric conversion portion 51, the first transfer transistor 52, the first FD portion 53, the second transfer transistor 54, the second FD portion 55, the reset transistor 58, the amplification transistor 59, and the selection transistor 60.

The photoelectric conversion portion 51 includes, for example, a photodiode of a PN junction, and receives incident light and executes photoelectric conversion to accumulate charge obtained as a result. The first transfer transistor 52 is disposed between the photoelectric conversion portion 51 and the first FD portion 53. The drive signal TRG is supplied to the gate electrode of the first transfer transistor 52. When this drive signal TRG becomes the high level, the first transfer transistor 52 is turned on, and the charge accumulated in the photoelectric conversion portion 51 is transferred to the first FD portion 53 through the first transfer transistor 52.

The second transfer transistor 54 is disposed between the first FD portion 53 and the second FD portion 55. The drive signal FDG is supplied to the gate electrode of the second transfer transistor 54. When this drive signal FDG becomes the high level, the second transfer transistor 54 is turned on, and charge from the first FD portion 53 is transferred to the second FD portion 55 through the second transfer transistor 54.

Through the turning-on of the second transfer transistor 54, the region in which charge is accumulated becomes the region obtained by combining the first FD portion 53 with the second FD portion 55, and the conversion efficiency when the charge generated in the photoelectric conversion portion is converted to a voltage can be switched. The second transfer transistor 54 functions as a conversion efficiency switching transistor which switches the conversion efficiency, and functions as a switch which switches on and off the conversion efficiency.

The reset transistor 58 is connected between the power supply VDD and the second FD portion 55. The drive signal RST is supplied to the gate electrode of the reset transistor 58. When the drive signal RST is set to the high level, the reset transistor 58 is turned on, and the potential of the second FD portion 55 is reset to the level of the supply voltage VDD.

The amplification transistor 59 has the gate electrode connected to the first FD portion 53 and the drain connected to the power supply VDD, and serves as an input portion of a readout circuit which reads out a signal corresponding to the charge held by the first FD portion 53, a generally-called source follower circuit. That is, the source of the amplification transistor 59 is connected to the vertical signal line 9 through the selection transistor 60. This makes the amplification transistor 59 form the source follower circuit with a constant current source (not depicted) connected to one end of the vertical signal line 9.

The selection transistor 60 is connected between the source of the amplification transistor 59 and the vertical signal line 9. The drive signal SEL is supplied to the gate electrode of the selection transistor 60. When the drive signal SEL is set to the high level, the selection transistor 60 is turned on, and the pixel 2 becomes the selected state. Due to this, the pixel signal output from the amplification transistor 59 is output to the vertical signal line 9 through the selection transistor 60.

### <Planar Configuration Example of Pixel>

FIG. 14 is a view depicting a planar configuration example of a surface of the silicon substrate in which the transistors of the pixel 2 having the circuit configuration depicted in FIG. 13 are disposed.

The gate electrode TRG of the first transfer transistor 52 is formed around the center of the pixel 2. The gates of the transistors other than the first transfer transistor 52 included in the pixel 2 are disposed, with the gate electrode TRG of the first transfer transistor 52 centered. In other words, with the first transfer transistor 52 centered, the transistors configuring the pixel 2 other than the first transfer transistor 52 are disposed around the first transfer transistor 52.

In the diagram, the gate electrode FDG of the second transfer transistor 54 is formed on the left side of the gate electrode TRG of the first transfer transistor 52. The first FD portion 53 including an N+ diffusion layer is disposed between the gate electrode TRG and the gate electrode FDG and in the silicon substrate.

The gate electrode RST of the reset transistor 58 is formed on the upper side of the gate electrode TRG of the first transfer transistor 52 in the diagram. The second FD portion 55 is formed between the second transfer transistor 54 and the reset transistor 58.

The gate electrode AMP of the amplification transistor 59 is formed on the right side of the gate electrode TRG of the first transfer transistor 52 in the diagram. The VDD region 71 connected to the supply voltage VDD is formed between the reset transistor 58 and the amplification transistor 59.

The gate electrode SEL of the selection transistor 60 is formed on the lower side of the gate electrode TRG of the first transfer transistor 52 in the diagram. A VSL region connected to the vertical signal line 9 is formed on the left side of the selection transistor 60 in the diagram.

The VSS region 73 including a P+ diffusion layer is formed on the lower left side of the first transfer transistor 52 in the diagram.

The inter-pixel isolation portion 81 is formed between the pixels 2. The element isolation portion 82 is formed between the respective transistors. As the element isolation portion 82, for example, a structure obtained by forming a trench with a predetermined depth in an element isolation region and burying an insulating film therein is employed. It is also possible to employ the element isolation portion 131 formed by ion implantation as described with reference to FIG. 10.

The inter-pixel isolation portion 81 is disposed in a pixel boundary region of the pixel 2, and element isolation is established by the element isolation portion 82 in an active region. The active region is formed as a serial region (continuous region). In the example depicted in FIG. 14, the active region is formed as the serial region from the lower side of the gate electrode TRG of the first transfer transistor 52 to the VSL region 72. The element isolation portion 82 is formed into a structure in which part thereof is in contact with the inter-pixel isolation portion 81.

The gate electrodes of the pixel transistors other than the first transfer transistor 52 are configured to overlap with the inter-pixel isolation portion 81 as depicted in FIG. 14. In other words, a partial region of the gate electrodes of the pixel transistors is configured in the state in which the partial region includes a region overlapping with the inter-pixel isolation portion 81 in plan view. By making the configuration overlapping with the inter-pixel isolation portion 81, the region of the electrode gate can be ensured.

The gate electrodes of the pixel transistors other than the first transfer transistor 52 are configured to also overlap with the element isolation portion 82 as depicted in FIG. 14. In other words, a partial region of the gate electrodes of the pixel transistors is configured in the state in which the partial region includes a region overlapping with the element isolation portion 82 in plan view.

The left side of the gate electrode FDG of the second transfer transistor 54 in the diagram overlaps with the inter-pixel isolation portion 81 in plan view, and the right side in the diagram overlaps with the element isolation portion 82 in plan view. The upper side of the gate electrode RST of the reset transistor 58 in the diagram overlaps with the inter-pixel isolation portion 81 in plan view, and the lower side in the diagram overlaps with the element isolation portion 82 in plan view.

The right side of the gate electrode AMP of the amplification transistor 59 in the diagram overlaps with the inter-pixel isolation portion 81 in plan view, and the left side in the diagram overlaps with the element isolation portion 82 in plan view. The lower side of the gate electrode SEL of the selection transistor 60 in the diagram overlaps with the inter-pixel isolation portion 81 in plan view, and the upper side in the diagram overlaps with the element isolation portion 82 in plan view.

In such a manner, the transistors included in the pixel 2 other than the first transfer transistor 52 are disposed to surround the first transfer transistor 52. Further, each transistor included in the pixel 2 other than the first transfer transistor 52 is configured such that at least one side overlaps with the inter-pixel isolation portion 81 in plan view and the side opposite the side overlapping with the inter-pixel isolation portion 81 overlaps with the element isolation portion 82.

By disposing the transistors in such a manner, the WL dimensions of the pixel transistors which can be disposed per one pixel can be enlarged, and thus cut-off variation and amplification noise of the pixel transistors can be designed to be small. Moreover, the first transfer transistor 52 which transfers charge obtained by conversion by the photoelectric conversion portion 51 to the FD portion is disposed at the center of the pixel 2, namely, the center of the photoelectric conversion portion 51. This can make a configuration in which a signal from the photoelectric conversion portion 51 is easily transferred to the first FD portion 53.

In the pixel 2 depicted in FIG. 14, the number of disposed transistors is smaller than that of the pixel 2 depicted in FIG. 5, and thus one transistor can be formed with a large size. In particular, the amplification transistor 59 can be formed with a large size, and it becomes possible to reduce noise.

### <Fifth Embodiment>

FIG. 15 is a view depicting a circuit configuration example of the pixel 2 in a fifth embodiment. The pixel 2 in the fifth embodiment has a configuration having the three FD portions as with the pixel 2 in the first to third embodiments, and is formed into a configuration to which an overflow transistor 201 is further added.

The pixel 2 has the photoelectric conversion portion 51, the first transfer transistor 52, the first FD portion 53, the second transfer transistor 54, the second FD portion 55, the third transfer transistor 56, the third FD portion 57, the reset transistor 58, the amplification transistor 59, the selection transistor 60, and the overflow transistor 201.

The overflow transistor 201 is disposed between the photoelectric conversion portion 51 and the third FD portion 57, and is configured such that charge which has overflowed from the photoelectric conversion portion 51 is accumulated in the third FD portion 57.

The first transfer transistor 52 is disposed between the photoelectric conversion portion 51 and the first FD portion 53. The drive signal TRG is supplied to the gate electrode of the first transfer transistor 52. When this drive signal TRG becomes the high level, the first transfer transistor 52 is turned on, and the charge accumulated in the photoelectric conversion portion 51 is transferred to the first FD portion 53 through the first transfer transistor 52.

The second transfer transistor 54 is disposed between the first FD portion 53 and the second FD portion 55. The drive signal FDG is supplied to the gate electrode of the second transfer transistor 54. When this drive signal FDG becomes the high level, the second transfer transistor 54 is turned on, and charge from the first FD portion 53 is transferred to the second FD portion 55 through the second transfer transistor 54.

Through the turning-on of the second transfer transistor 54, the region in which charge is accumulated becomes the region obtained by combining the first FD portion 53 with the second FD portion 55, and the conversion efficiency when the charge generated in the photoelectric conversion portion is converted to a voltage can be switched.

The third transfer transistor 56 is disposed between the second FD portion 55 and the third FD portion 57. The drive signal FCG is supplied to the gate electrode of the third transfer transistor 56. When this drive signal FCG becomes the high level, the third transfer transistor 56 is turned on, and charge from the second FD portion 55 is transferred to the third FD portion 57 through the third transfer transistor 56.

Through the turning-on of the third transfer transistor 56, the region in which charge is accumulated becomes the region obtained by combining the first FD portion 53, the second FD portion 55, and the third FD portion 57, and the conversion efficiency when the charge generated in the photoelectric conversion portion is converted to a voltage can be switched. As described above, charge which has overflowed from the photoelectric conversion portion 51 and been transferred through the overflow transistor 201 is also accumulated in the third FD portion 57.

The reset transistor 58 is connected between the power supply VDD and the intersection of the second FD portion 55 and the third FD portion 57. The drive signal RST is supplied to the gate electrode of the reset transistor 58. When the drive signal RST is set to the high level, the reset transistor 58 is turned on, and the potential of the second FD portion 55 and the third FD portion 57 is reset to the level of the supply voltage VDD.

The amplification transistor 59 has the gate electrode connected to the first FD portion 53 and the drain connected to the power supply VDD, and serves as an input portion of a readout circuit which reads out a signal corresponding to the charge held by the first FD portion 53, a generally-called source follower circuit. That is, the source of the amplification transistor 59 is connected to the vertical signal line 9 through the selection transistor 60. This makes the amplification transistor 59 form the source follower circuit with a constant current source (not depicted) connected to one end of the vertical signal line 9.

The selection transistor 60 is connected between the source of the amplification transistor 59 and the vertical signal line 9. The drive signal SEL is supplied to the gate electrode of the selection transistor 60. When the drive signal SEL is set to the high level, the selection transistor 60 is turned on and the pixel 2 becomes the selected state. Due to this, the pixel signal output from the amplification transistor 59 is output to the vertical signal line 9 through the selection transistor 31.

### <Planar Configuration Example of Pixel>

FIG. 16 is a view depicting a planar configuration example of a surface of the silicon substrate in which the transistors of the pixel 2 having the circuit configuration depicted in FIG. 15 are disposed.

The gate electrode TRG of the first transfer transistor 52 is formed around the center of the pixel 2. The gates of the transistors other than the first transfer transistor 52 included in the pixel 2 are disposed, with the gate electrode TRG of the first transfer transistor 52 centered. In the diagram, the gate electrode FDG of the second transfer transistor 54 is formed on the left side of the gate electrode TRG of the first transfer transistor 52. The first FD portion 53 including an N+ diffusion layer is disposed between the gate electrode TRG and the gate electrode FDG and in the silicon substrate.

The gate electrode RST of the reset transistor 58 is formed on the upper side of the gate electrode TRG of the first transfer transistor 52 in the diagram. The second FD portion 55 is formed between the second transfer transistor 54 and the reset transistor 58.

The gate electrode AMP of the amplification transistor 59 is formed on the upper right side of the gate electrode TRG of the first transfer transistor 52. The VDD region 71 is formed between the reset transistor 58 and the amplification transistor 59.

The gate electrode SEL of the selection transistor 60 is formed on the right side of the gate electrode TRG of the first transfer transistor 52 in the diagram. The VSL region 72 is formed on the lower side of the selection transistor 60 in the diagram.

A gate electrode OFG of the overflow transistor 201 is formed on the lower right side of the gate electrode TRG of the first transfer transistor 52 in the diagram. The VSS region 73 is formed on the right side of the overflow transistor 201 in the diagram. The gate electrode FCG of the third transfer transistor 56 is formed on the lower left side of the gate electrode TRG of the first transfer transistor 52 in the diagram. The third FD portion 57 is formed between the overflow transistor 201 and the third transfer transistor 56.

Part of the second FD portion 55 is formed on the left side of the third transfer transistor 56 in the diagram. The second FD portion 55 is disposed on each of the upper side and the lower side of the second transfer transistor 54.

As depicted in FIG. 17, it is also possible to employ a configuration in which the second FD portion 55 is disposed on each of the upper side and the lower side of the second transfer transistor 54 and is continuous. In the example depicted in FIG. 17, the first transfer transistor 52 and the other transistors are formed by one active region.

The inter-pixel isolation portion 81 is formed to surround the pixel 2. The element isolation portion 82 is formed between the respective transistors. As the element isolation portion 82, for example, a structure obtained by forming a trench with a predetermined depth in an element isolation region and burying an insulating film therein is employed. It is also possible to employ the element isolation portion 131 formed by ion implantation as described with reference to FIG. 10.

The pixel transistors other than the first transfer transistor 52 (second transfer transistor 54, third transfer transistor 56, reset transistor 58, amplification transistor 59, selection transistor 60, and overflow transistor 201) are disposed such that part thereof is located on the element isolation portion 82 as element isolation and part thereof is located on the inter-pixel isolation portion 81.

The gate electrodes of the pixel transistors other than the first transfer transistor 52 are configured to overlap with the inter-pixel isolation portion 81 as depicted in FIG. 16. In other words, a partial region of the gate electrodes of the pixel transistors is configured in the state in which the partial region includes a region overlapping with the inter-pixel isolation portion 81 in plan view. By making the configuration overlapping with the inter-pixel isolation portion 81, the region of the electrode gate can be ensured.

The gate electrodes of the pixel transistors other than the first transfer transistor 52 are configured to also overlap with the element isolation portion 82 as depicted in FIG. 16. In other words, a partial region of the gate electrodes of the pixel transistors is configured in the state in which the partial region includes a region overlapping with the element isolation portion 82 in plan view.

The left side of the gate electrode FDG of the second transfer transistor 54 in the diagram overlaps with the inter-pixel isolation portion 81 in plan view, and part of the right side in the diagram overlaps with the element isolation portion 82 in plan view. The upper side of the gate electrode RST of the reset transistor 58 in the diagram overlaps with the inter-pixel isolation portion 81 in plan view, and the lower side in the diagram overlaps with the element isolation portion 82 in plan view.

The upper side and the right side of the gate electrode AMP of the amplification transistor 59 in the diagram overlap with the inter-pixel isolation portion 81 in plan view, and part of the lower side in the diagram overlaps with the element isolation portion 82 in plan view. The right side of the gate electrode SEL of the selection transistor 60 in the diagram overlaps with the inter-pixel isolation portion 81 in plan view, and the left side in the diagram overlaps with the element isolation portion 82 in plan view.

The lower side of the gate electrode OFG of the overflow transistor 201 in the diagram overlaps with the inter-pixel isolation portion 81 in plan view, and the upper side in the diagram overlaps with the element isolation portion 82 in plan view. The lower side of the gate electrode FCG of the third transfer transistor 56 in the diagram overlaps with the inter-pixel isolation portion 81 in plan view, and the upper side in the diagram overlaps with the element isolation portion 82 in plan view.

In such a manner, the transistors included in the pixel 2 other than the first transfer transistor 52 are disposed to surround the first transfer transistor 52. Further, each transistor included in the pixel 2 other than the first transfer transistor 52 is configured such that at least one side overlaps with the inter-pixel isolation portion 81 in plan view and the side opposite the side overlapping with the inter-pixel isolation portion 81 overlaps with the element isolation portion 82.

By disposing the transistors in such a manner, the WL dimensions of the pixel transistors which can be disposed per one pixel can be enlarged, and thus cut-off variation and amplification noise of the pixel transistors can be designed to be small. Moreover, the first transfer transistor 52 which transfers charge obtained by conversion by the photoelectric conversion portion 51 to the FD portion is disposed at the center of the pixel 2, namely, the center of the photoelectric conversion portion 51. This can make a configuration in which a signal from the photoelectric conversion portion 51 is easily transferred to the first FD portion 53.

### <About Occurrence of White Spot and Dark Current>

The above-described pixel 2 has the plurality of transistors. When the size of the pixel 2 is miniaturized, there is a possibility that a defect which occurs due to weakening of pinning during voltage application to the transistor or a strong electric field attributed to a PN junction between an N-type source or drain and a P-type well enters the FD portion or the photoelectric conversion portion and the white spot or the dark current becomes worse.

A description is given of this point with reference to FIGs. 18 to 21. FIG. 18 is a view obtained by adding line segments A-A', B-B', and C-C' to the diagram depicting the planar configuration example of the pixel 2 depicted in FIG. 5. FIG. 19 is a view depicting a sectional configuration example along line segment A-A' in FIG. 18. FIG. 20 is a view depicting a sectional configuration example along line segment B-B' in FIG. 18. FIG. 21 is a view depicting a sectional configuration example along line segment C-C' in FIG. 18.

The sectional configuration example of the pixel 2 depicted in FIG. 19 is similar to the sectional configuration example depicted in FIG. 7, and therefore description thereof is omitted. As depicted in FIG. 19, there is a possibility that a strong electric field occurs at a junction portion between the N+ region 105 forming the first FD portion 53 and the pinning film 107 which is a P-type region formed on the lower side of the element isolation portion 82 (hereinafter, the element isolation portion 82 existing between the first transfer transistor 52 and the first FD portion 53 is referred to as an element isolation portion 82SF).

In the case in which the element isolation portion 82SF has a rectangular shape, an electric field tends to concentrate at the corner portions, and a strong electric field tends to occur at the portions. As depicted in FIG. 19, due to the occurrence of the strong electric field between the N+ region 105 and the element isolation portion 82SF, charge flows to the first FD portion 53 or the photodiode PD, which possibly causes a white spot or a dark current.

Referring to the sectional configuration example along line segment B-B' depicted in FIG. 20, the gate electrode TRG of the first transfer transistor 52 is formed around the center of the semiconductor substrate 80. The element isolation portion 82 (defined as an element isolation portion 82TA) is formed on the left side of the first transfer transistor 52 in the diagram. The pinning film 108 is formed on the lower side of the element isolation portion 82TA.

The amplification transistor 59 is formed on the left side of the element isolation portion 82TA in the diagram. The channel 106 is formed by an N-type region on the lower side of the gate electrode AMP of the amplification transistor 59.

As depicted in FIG. 20, the gate electrode AMP of the amplification transistor 59 is formed with such a position and a size that one side includes a region overlapping with the element isolation portion 82TA and the other side includes a region overlapping with the inter-pixel isolation portion 81.

The element isolation portion 82 (defined as an element isolation portion 82TF) is formed on the right side of the first transfer transistor 52 in the diagram. A pinning film 109 is formed on the lower side of the element isolation portion 82TF. An N+ region 111 forming the second FD portion 55 is formed on the left side of this element isolation portion 82TF in the diagram.

As depicted in FIG. 20, there is a possibility that a strong electric field occurs at a junction portion between the N+ region 111 forming the second FD portion 55 and the pinning film 109 of a P-type formed on the lower side of the element isolation portion 82TF. As depicted in FIG. 20, due to the occurrence of the strong electric field between the N+ region 111 and the element isolation portion 82TF, charge flows to the second FD portion 55 or the photodiode PD, which possibly causes a white spot or a dark current.

Referring to the sectional configuration along line segment C-C' depicted in FIG. 21, the gate electrode TRG of the first transfer transistor 52 is formed around the center of the semiconductor substrate 80. An element isolation portion 82TS is formed on the left side of the first transfer transistor 52 in the diagram. The pinning film 108 is formed on the lower side of the element isolation portion 82TS.

The selection transistor 60 is formed on the left side of the element isolation portion 82TS in the diagram. The channel 104 is formed by an N-type region on the lower side of the gate electrode SEL of the selection transistor 60.

As depicted in FIG. 21, the gate electrode SEL of the selection transistor 60 is formed with such a position and a size that one side includes a region overlapping with the element isolation portion 82TS and the other side includes a region overlapping with the inter-pixel isolation portion 81.

The element isolation portion 82TF is formed on the right side of the first transfer transistor 52 in the diagram. A pinning film 110 is formed on the lower side of the element isolation portion 82TF. An N+ region 112 forming the third FD portion 57 is formed on the left side of this element isolation portion 82TF in the diagram.

As depicted in FIG. 21, there is a possibility that a strong electric field occurs at a junction portion between the N+ region 112 forming the third FD portion 57 and the pinning film 110 of a P-type formed on the lower side of the element isolation portion 82TF. As depicted in FIG. 21, due to the occurrence of the strong electric field between the N+ region 112 and the element isolation portion 82TF, charge flows to the third FD portion 57 or the photodiode PD, which possibly causes a white spot or a dark current.

As above, there is a possibility that a strong electric field occurs at the element isolation portion 82 adjacent to the FD portion and a white spot or a dark current occurs. A description is given below of a configuration of the pixel 2 which suppresses the occurrence of a strong electric field at the element isolation portion 82 adjacent to the FD portion and suppresses the occurrence of a white spot or a dark current.

### <Sixth Embodiment>

FIGs. 22 to 24 are views depicting sectional configuration examples of the pixel 2 in a sixth embodiment. FIG. 22 is a view depicting a sectional configuration example along line segment A-A' in FIG. 18. FIG. 23 is a view depicting a sectional configuration example along line segment B-B' in FIG. 18. FIG. 24 is a view depicting a sectional configuration example along line segment C-C' in FIG. 18.

Referring to the sectional configuration example of the pixel 2 along line segment A-A' depicted in FIG. 22, the depth of the element isolation portion 82SF adjacent to the first FD portion 53 is set deeper than the depth of the element isolation portion 82 which is not adjacent to the FD portion. In the example depicted in FIG. 22, the element isolation portion 82TA adjacent to the amplification transistor 59 exists as the element isolation portion 82 which is not adjacent to the FD portion. The depth of this element isolation portion 82TA is defined as a depth "a." The depth is the length in the vertical direction (upward-downward direction) in the diagram.

In the case in which the depth of the element isolation portion 82SF adjacent to the first FD portion 53 is defined as a depth "b," a relation of depth "b" > depth "a" holds. By setting the depth "b" of the element isolation portion 82SF deep, the distance between the corner portion of the element isolation portion 82SF (P-type pinning film 107) and the N+ region 105 of the first FD portion 53 can be made long. The junction leakage can be suppressed by separating the pinning film 107 and the N+ region 105. Thus, it is possible to suppress the occurrence of a white spot or a dark current like that described with reference to FIG. 19.

It is to be noted that, due to setting the depth "b" of the element isolation portion 82SF deep, there is a possibility that the element isolation portion 82SF becomes close to the N-type semiconductor region 101 of the photoelectric conversion portion 61. Thus, there is a possibility of formation of a structure in which charge generated at an Si-SiO2 interface under the element isolation portion 82SF readily flows into the photoelectric conversion portion 61 and the occurrence of a dark current. Thus, the depth "b" of the element isolation portion 82SF is set to such a depth that a dark current does not occur.

The element isolation portion 82TA adjacent to the amplification transistor 59 may also be deeply formed. However, as with the element isolation portion 82SF, increasing the depth causes a possibility that charge flows into the photoelectric conversion portion 61. For such a reason, it is also possible to employ a configuration in which the depth of the element isolation portion 82 adjacent to the FD portion is set deep but the depth of the other element isolation portions 82 is not set deep.

Referring to the sectional configuration example of the pixel 2 along line segment B-B' depicted in FIG. 23, a depth "c" of the element isolation portion 82TF adjacent to the second FD portion 55 is set deeper than the depth of the element isolation portion 82 which is not adjacent to the FD portion. In the example depicted in FIG. 23, the element isolation portion 82TA adjacent to the amplification transistor 59 exists as the element isolation portion 82 which is not adjacent to the FD portion. The depth of this element isolation portion 82TA is the depth "a."

The depth "c" of the element isolation portion 82TF adjacent to the second FD portion 55 is a depth satisfying a relation of depth "c" > depth "a." By setting the depth "c" of the element isolation portion 82TF deep, the distance between the corner portion of the element isolation portion 82TF (P-type pinning film 109) and the N+ region 111 of the second FD portion 55 can be made long. Thus, a configuration which can suppress the junction leakage can be made. Accordingly, it is possible to suppress the occurrence of a white spot or a dark current like that described with reference to FIG. 20.

Referring to the sectional configuration example of the pixel 2 along line segment C-C' depicted in FIG. 24, the depth "c" of the element isolation portion 82TF adjacent to the third FD portion 57 is set deeper than the depth of the element isolation portion 82 which is not adjacent to the FD portion. In the example depicted in FIG. 24, the element isolation portion 82TS adjacent to the selection transistor 60 exists as the element isolation portion 82 which is not adjacent to the FD portion. The depth of this element isolation portion 82TS is the depth "a."

The depth "c" of the element isolation portion 82TF adjacent to the third FD portion 57 is a depth satisfying a relation of depth "c" > depth "a." By setting the depth "c" of the element isolation portion 82TF deep, the distance between the corner portion of the element isolation portion 82TF (P-type pinning film 110) and the N+ region 112 of the third FD portion 57 can be made long. Thus, a configuration which can suppress the junction leakage can be made. Thus, it is possible to suppress the occurrence of a white spot or a dark current like that described with reference to FIG. 21.

The depth "b" of the element isolation portion 82 adjacent to the first FD portion 53, the depth "c" of the element isolation portion 82 adjacent to the second FD portion 55, and the depth "d" of the element isolation portion 82 adjacent to the third FD portion 57, described with reference to FIGs. 22 to 24, satisfy a relation of depth "b" = depth "c" = depth "d." As above, the depths of the element isolation portions 82 adjacent to the FD portion can be set identical.

In the case in which the depth "a" is defined as 1, the depths b, c, and d are set to, for example, approximately 1.2 to 2.0. The depth of the element isolation portion 82 adjacent to the FD portion is set to a depth approximately 1.2 to 2.0 times the depth "a" as the basis.

The depth "b" of the element isolation portion 82 adjacent to the first FD portion 53, the depth "c" of the element isolation portion 82 adjacent to the second FD portion 55, and the depth "d" of the element isolation portion 82 adjacent to the third FD portion 57 may be set to satisfy a relation of depth "b" < depth "c" < depth "d" as depicted in FIG. 25.

Here, the description has been given by taking as an example the case in which three places, the element isolation portion 82 adjacent to the first FD portion 53, the element isolation portion 82 adjacent to the second FD portion 55, and the element isolation portion 82 adjacent to the third FD portion 57, are formed to be deeper than the depth "a" of the element isolation portion 82 which is not adjacent to the FD portion. However, two places or one place out of the three places may be formed to be deeper than the depth "a."

For example, it is also possible to set the depth "a" of the element isolation portion 82 which is not adjacent to the FD portion = the depth "b" of the element isolation portion 82 adjacent to the first FD portion 53 = the depth "c" of the element isolation portion 82 adjacent to the second FD portion 55 < the depth "d" of the element isolation portion 82 adjacent to the third FD portion 57. In this case, a relation of depth "a" = depth "b" = depth "c" < depth "d" is satisfied, and a configuration in which one place of the element isolation portion 82 adjacent to the FD portion is deeply formed is made.

For example, it is also possible to set the depth "a" of the element isolation portion 82 which is not adjacent to the FD portion = the depth "b" of the element isolation portion 82 adjacent to the first FD portion 53 < the depth "c" of the element isolation portion 82 adjacent to the second FD portion 55 = the depth "d" of the element isolation portion 82 adjacent to the third FD portion 57. In this case, a relation of depth "a" = depth "b" < depth "c" = depth "d" is satisfied, and a configuration in which two places of the element isolation portions 82 adjacent to the FD portion are deeply formed is made.

In the case of a structure including a plurality of element isolation portions 82 adjacent to the FD portion, which element isolation portion 82 is deeply formed is allowed to be set depending on, for example, the voltage applied to the FD portion or the capacitance of the FD portion.

In terms of driving, the depth of the element isolation portion 82 adjacent to the FD portion to which a high voltage is applied may be set deeper than the other element isolation portions 82. It is also possible that the depth of the element isolation portion 82 is set depending on the voltage applied to the FD portion.

The depth of the element isolation portion 82 adjacent to the FD portion with high capacitance may be set deeper than the other element isolation portions 82. Because the dark current is readily accumulated in the FD portion with high capacitance, the depth of the element isolation portion 82 can be set deep in order to suppress the occurrence of the dark current. It is possible that the depth of the element isolation portion 82 is set depending on the magnitude of the capacitance of the FD portion.

### <Seventh Embodiment>

FIG. 26 is a view depicting a sectional configuration example of the pixel 2 in a seventh embodiment. The element isolation portion 82 depicted in FIG. 26 includes two regions. The element isolation portion 82TF adjacent to the third FD portion 57 includes an element isolation portion 82TF-1 and an element isolation portion 82TF-2.

The element isolation portion 82TF-1 is the element isolation portion 82 located on the side separate from the third FD portion 57, and is formed with a depth equivalent to the depth of the element isolation portion 82 which is not adjacent to the FD portion, for example, the element isolation portion 82TS. Meanwhile, the element isolation portion 82TF-2 adjacent to the third FD portion 57 is formed to be deeper than the depth of the element isolation portion 82 which is not adjacent to the FD portion.

It is also possible to deeply form the element isolation portion 82 on the side closer to the FD portion to make such a configuration that the N+ region of the FD portion and the pinning film are separate in such a manner. In other words, it is also possible to employ a configuration in which the element isolation portion 82 on the side closer to the FD portion is deeply formed and the element isolation portion 82 on the side remoter from the FD portion is formed with a depth equivalent to that of the other element isolation portions 82.

As depicted in FIG. 27, the element isolation portion 82 may be formed with a plurality of steps. It can also be said that the element isolation portion 82TF depicted in FIG. 26 is formed with depths at two levels. On the other hand, the element isolation portion 82TF depicted in FIG. 27 is formed with depths at three levels. As above, the element isolation portion 82 may be formed such that the depth becomes deeper in a stepwise manner as the position shifts from the side remoter from the FD portion toward the side closer to the FD portion.

As depicted in FIG. 28, it is also possible to allow the element isolation portion 82 to be formed with a triangular shape. The element isolation portion 82TF depicted in FIG. 28 is formed such that the depth gradually becomes deeper from the side of the first transfer transistor 52 to the third FD portion 57, and is formed with a triangular shape having a side of the element isolation portion 82TF as the hypotenuse. As above, the element isolation portion 82 may be formed such that the depth gradually becomes deeper as the position shifts from the side remoter from the FD portion toward the side closer to the FD portion.

Although here the description has been given by taking as an example the element isolation portion 82 adjacent to the third FD portion 57, application also to the element isolation portion 82 adjacent to the first FD portion 53 or the second FD portion 55 is possible.

<Eighth Embodiment>

FIG. 29 is a view depicting a sectional configuration example of the pixel 2 in an eighth embodiment. The element isolation portion 82 depicted in FIG. 29 is formed with a shape other than the rectangular shape.

The element isolation portion 82TF depicted in FIG. 29 is formed with a trapezoidal shape. The short side of the trapezoid exists in the semiconductor substrate 80, and the pinning film 110 is formed on the short side. By forming the element isolation portion 82TF into the trapezoidal shape and forming the pinning film 110 on the side of the short side thereof, the pinning film 110 and the third FD portion 57 can be separated, and the junction leakage can be suppressed.

In the case in which the element isolation portion 82 is formed into a rectangular shape, an electric field tends to concentrate at the corner portions. Therefore, a shape with rounded corner portions may be employed as depicted in FIG. 30. By employing the shape with rounded corners, the electric field at the portions at which the electric field readily concentrates can be alleviated, and the occurrence of a strong electric field can be suppressed. Further, rounding the corners can shorten the side on which the pinning film 110 is formed, and a structure in which the pinning film 110 and the N+ region 112 are correspondingly separated can be made.

As above, the shape of the element isolation portion 82 is not limited to the rectangular shape and may be the trapezoidal shape or the shape with rounded corners. The depth of the element isolation portion 82 may be set deeper than the element isolation portion 82 which is not adjacent to the FD portion as with the case described with reference to FIGs. 22 to 24.

Although here the description has been given by taking as an example the element isolation portion 82 adjacent to the third FD portion 57, application also to the element isolation portion 82 adjacent to the first FD portion 53 or the second FD portion 55 is possible.

### <Ninth Embodiment>

FIG. 31 is a view depicting a sectional configuration example of the pixel 2 in a ninth embodiment. The element isolation portion 82 depicted in FIG. 31 includes two different materials.

The element isolation portion 82 adjacent to the first FD portion 53 includes an element isolation portion 82SF-1 and an element isolation portion 82SF-2. The element isolation portion 82SF-1 is the element isolation portion 82 formed on the side remoter from the first FD portion 53, and includes an oxide film or the like. The element isolation portion 82SF-2 is the element isolation portion 82 formed on the side closer to the first FD portion 53, and is the element isolation portion 82 formed as a P-type region by ion implantation.

It is also possible to employ the configuration in which the P-type region formed by ion implantation is formed between the element isolation portion 82SF-1 including an oxide film or the like and the diffusion layer (N+ region 105) of the FD portion as above.

Although here the description has been given by taking as an example the element isolation portion 82 adjacent to the first FD portion 53, application also to the element isolation portion 82 adjacent to the second FD portion 55 or the third FD portion 57 is possible.

As depicted in FIG. 32, the whole of the element isolation portion 82 may be formed as a P-type region formed by ion implantation. In the example depicted in FIG. 32, the element isolation portion 82TF adjacent to the third FD portion 57 is formed as a P-type impurity region, and is, for example, a region formed by ion implantation. In this case, the depth of the element isolation portion 82TF may be set deeper than the other element isolation portions 82 or be set to an equivalent depth.

Although here the description has been given by taking as an example the element isolation portion 82 adjacent to the third FD portion 57, application also to the element isolation portion 82 adjacent to the first FD portion 53 or the second FD portion 55 is possible.

### <Configuration of Element Isolation Portion>

In the case in which the element isolation portion 82 includes an oxide film, a single layer or stacked layers can be employed as depicted in FIG. 33. Referring to A of FIG. 33, an oxide film of a single layer including SiO2 or SiN can be employed as the element isolation portion 82.

Referring to B of FIG. 33, an oxide film of stacked layers including SiO2 and SiN can be employed as the element isolation portion 82. In the example depicted in B of FIG. 33, a configuration in which layers of SiO2, SiO, and SiO2 are stacked is depicted.

### <Configuration of Inter-pixel Isolation Portion>

Configuration examples of the inter-pixel isolation portion 81 are depicted in FIG. 34. An example depicted in A of FIG. 34 depicts an example in which the inter-pixel isolation portion 81 is formed by FDTI (Front side Deep Trench Isolation). The FDTI is a trench dug from the front surface of the semiconductor substrate 80 (upper side in the diagram). An example depicted in B of FIG. 34 depicts an example in which the inter-pixel isolation portion 81 is formed by RDTI (Reverse side Deep Trench Isolation). The RDTI is a trench dug from the back surface of the semiconductor substrate 80 (lower side in the diagram).

The inter-pixel isolation portion 81 may be a structure referred to as a full trench (FFTI: Front Full Trench Isolation) formed to penetrate the semiconductor substrate 80.

According to the present technology, it is possible to make a structure in which the corner portions of the element isolation portion are separated from the diffusion layer of the FD portion and the P/N boundary portion of the well region. Thus, the electric field can be alleviated and the junction leakage can be suppressed, so that the image quality can be improved.

### <About Reduction in Influence of Dark Current>

As described with reference to FIG. 3, in the pixel 2, charge which has overflowed from the PD 51 is accumulated in the first FD portion 53, the second FD portion 55, and the third FD portion 57. These first FD portion 53, second FD portion 55, and third FD portion 57 function as overflow accumulation capacitance (LOFIC: Lateral Over Flow Integration Capacitor) which accumulates charge which has overflowed. It is difficult for such an LOFIC on the FD accumulation side to reset the FD. Thus, there is a possibility that an FD dark current which occurs in an accumulation period from execution of shutter operation to the completion of signal readout deteriorates the image quality of the image sensor.

A description is given of this point with reference to FIG. 35. FIG. 35 depicts potential diagrams corresponding to the timing chart depicted in FIG. 3. The period from the clock time T1 to the clock time T2 is an exposure period. The clock time T1 is a clock time immediately after execution of shutter operation. Referring to FIG. 3, immediately after the execution of the shutter operation, the drive signal SEL supplied to the selection transistor 60, the drive signal RST supplied to the reset transistor 58, the drive signal FCG supplied to the third transfer transistor 56, the drive signal FDG supplied to the second transfer transistor 54, and the drive signal TRG supplied to the first transfer transistor 52 are in the off-state.

Immediately after the execution of the shutter operation (clock time T1), the PD 51, the first FD portion 53, the second FD portion 55, and the third FD portion 57 are in the off-state, and are in the state in which a signal is not accumulated.

The exposure period starts from the clock time T1, photoelectric conversion in the PD 51 is executed, and a signal is accumulated in the PD 51. Here, in the case in which the amount of signal has become larger relative to the number of saturated electrons, the signal overflows under the first transfer transistor 52, the signal is accumulated in the first FD portion 53, the second FD portion 55, and the third FD portion 57 depending on the amount of signal which has overflowed.

As depicted in the place of the clock time T1 to the clock time T2 in FIG. 35, in the exposure period, in addition to the accumulation of the signal in the PD 51, possibly a dark current occurs and is accumulated in each of the first FD portion 53, the second FD portion 55, and the third FD portion 57.

From the clock time T2 to the clock time T4, operation in the reset period in the MCG (middle conversion efficiency) mode and operation in the reset period in the HCG (high conversion efficiency) mode, described with reference to FIGs. 3 and 4, are executed.

A right diagram of FIG. 35 represents a potential diagram at the clock time T4. The clock time T4 is the readout period in the HCG mode. Due to execution of readout based on the HDG mode at the clock time T4, the signal accumulated in the PD 51 is read out, and the PD 51 becomes the empty state, so that a signal depending on the signal accumulated in the PD 51 is accumulated in each of the first FD portion 53, the second FD portion 55, and the third FD portion 57.

Because the dark current is accumulated in the first FD portion 53, the second FD portion 55, and the third FD portion 57, the signal including the dark current is accumulated. Thus, the FD range reduces.

### <Tenth Embodiment>

A mechanism to step down the voltage of the FD portion in the exposure period is set in order to suppress the reduction in the FD range and suppress the occurrence of the dark current. FIG. 36 depicts potential diagrams in the case in which a coupling line is connected to the second FD portion 55 to allow control to step down or step up the voltage of the second FD portion 55.

A left diagram of FIG. 36 depicts a potential diagram in the period from the clock time T1 to the clock time T2, namely, the exposure period. In the exposure period (during signal accumulation), control to step down the voltage of the second FD portion 55 and suppress the dark current is executed by control by the coupling line.

As depicted in a right diagram of FIG. 36, at the clock time T4, during signal readout in the readout period in the HCG mode or the like, control to step up the voltage of the second FD portion 55 and ensure the FD range is executed by control by the coupling line.

In the case in which the fear of the dark current is low, it is also possible that the control of voltage step-down or the like is not executed during signal accumulation and execution of the control to step up the voltage and enlarge the FD range during signal readout is allowed.

The coupling line functions as a control line which controls step-down or step-up of the voltage applied to the FD portion.

FIG. 37 depicts a circuit configuration example of the pixel 2 in the case in which the coupling line is connected to the second FD portion 55 to control the voltage of the second FD portion 55. The circuit configuration example of the pixel 2 depicted in FIG. 37 is a configuration obtained by adding a coupling line 301 connected to the second FD portion 55 to the circuit configuration of the pixel 2 depicted in FIG. 2. The coupling line 301 is connected to the second FD portion 55 through a capacitive element 311.

Operation of the pixel 2 depicted in FIG. 37 is described with reference to a timing chart depicted in FIG. 38. A timing chart depicted in FIG. 38 is a diagram obtained by adding a signal (FD Control) to the coupling line 301 to the timing chart depicted in FIG. 3. The signals other than the signal to the coupling line 301 are similar to those in the case described with reference to FIG. 3. Therefore, a description is given of the signal to the coupling line 301 here.

In the exposure period from the clock time T1 to the clock time T2, the signal of FD Control is switched off from the on-state. Then, after the off-state is continued for a predetermined period, the signal of FD Control is switched on.

Due to the turning-off of the signal of FD Control, the voltage of the capacitive element 311 on the side connected to the coupling line 301 becomes the off-state, and the potential on the side of the second FD portion 55 becomes high. The charge accumulated in the second FD portion 55 flows to the capacitive element 311. This lowers the potential of the second FD portion 55 (that is, the voltage is stepped down).

In such a manner, the control to step down the voltage of the FD portion is executed in the exposure period (during signal accumulation). This can reduce an influence of the dark current. Thus, reduction in the FD range due to the dark current is prevented, and the FD range can be ensured.

As depicted in FIG. 39, a configuration may be employed in which the coupling line 301 is not disposed for only the second FD portion 55 but disposed for all FD portions of the first FD portion 53, the second FD portion 55, and the third FD portion 57. Referring to the circuit configuration example of the pixel 2 depicted in FIG. 39, as with the circuit configuration depicted in FIG. 27, the coupling line 301 is connected to the second FD portion 55, and the capacitive element 311 is disposed for the coupling line 301.

Moreover, in the pixel 2 depicted in FIG. 39, a coupling line 302 is connected to the first FD portion 53, and a capacitive element 312 is disposed for the coupling line 302. In the pixel 2 depicted in FIG. 39, a coupling line 303 is connected to the third FD portion 57 and a capacitive element 313 is disposed for the coupling line 303.

FIG. 40 is a view depicting a sectional configuration example of the pixel 2 depicted in FIG. 39. In FIG. 40, the first transfer transistor 52, the first FD portion 53, the second transfer transistor 54, the second FD portion 55, the third transfer transistor 56, and the third FD portion 57 are depicted side by side.

The coupling line 302 is connected to the diffusion layer of the first FD portion 53, and the capacitive element 312 is disposed at part of the coupling line 302. The coupling line 301 is connected to the diffusion layer of the second FD portion 55, and the capacitive element 311 is disposed at part of the coupling line 301. The coupling line 303 is connected to the diffusion layer of the third FD portion 57, and the capacitive element 313 is disposed at part of the coupling line 303.

It is also possible to employ the configuration in which each FD portion is provided with the coupling line and the capacitive element in such a manner. In the case in which each FD portion is provided with the coupling line in such a manner, the FD portions can be individually controlled. That is, the control of voltage step-up and voltage step-down can be executed for each FD portion. It is also possible to employ a configuration in which the control of voltage step-up and voltage step-down is not individually executed for each FD portion but simultaneously executed. In such a case, it is also possible to employ a configuration in which the coupling line connected to the FD portion is made common (is not individually disposed).

In the example depicted in FIGs. 39 and 40, the example in which the coupling line is disposed for each of the first FD portion 53, the second FD portion 55, and the third FD portion 57 is depicted. However, it is also possible to employ a configuration in which the coupling line is disposed for the first FD portion 53 and the second FD portion 55 but not for the third FD portion 57. Further, it is also possible to employ a configuration in which the coupling line is disposed for the first FD portion 53 and the third FD portion 57 but not for the second FD portion 55. It is also possible to employ a configuration in which the coupling line is disposed for only one FD portion among the first FD portion 53, the second FD portion 55, and the third FD portion 57.

It is to be noted that, in the case of the configuration of the pixel 2 including three or more FD portions, it is also possible to employ a configuration in which the coupling line is disposed for all FD portions, and it is also possible to employ a configuration in which the coupling line is disposed for one or more FD portions. That is, it is possible to make a configuration in which the same number of coupling lines as the number of FD portions are disposed or a configuration in which a smaller number of coupling lines than the number of FD portions are disposed.

### <Eleventh Embodiment>

FIGs. 41 to 46 are views depicting circuit configuration examples and sectional configuration examples of the pixel 2 in an eleventh embodiment.

The circuit configuration of the pixel 2 depicted in FIG. 41 is different in that it is formed into a configuration obtained by adding a coupling line to the circuit configuration of the pixel 2 depicted in FIG. 13, and the other points are similar. Description is omitted as appropriate regarding the similar part.

The pixel 2 depicted in FIG. 41 includes the first FD portion 53 and the second FD portion 55, and the coupling line 302 is connected to the first FD portion 53. The capacitive element 312 is disposed between the coupling line 302 and the first FD portion 53.

FIG. 42 is a view depicting a sectional configuration example of the pixel 2 depicted in FIG. 41. In FIG. 42, the first transfer transistor 52, the first FD portion 53, the second transfer transistor 54, and the second FD portion 55 are depicted side by side. The coupling line 302 is connected to the diffusion layer of the first FD portion 53, and the capacitive element 312 is disposed at part of the coupling line 302.

The example depicted in FIGs. 41 and 42 is an example which includes the two FD portions and has a smaller number of coupling lines than the number of FD portions. Further, it is an example in which the coupling line is disposed only on the high gain side. The FD range can be enlarged by making the configuration in which a smaller number of coupling lines than the number of FD portions are disposed and the disposed coupling line is connected to the FD portion on the high gain side (in this case, the first FD portion 53) as above.

The circuit configuration and a sectional configuration example of the pixel 2 depicted in FIGs. 43 and 44 depict a configuration example in the case in which a smaller number of coupling lines than the number of FD portions are disposed and the disposed coupling line is connected to the FD portion on the low gain side.

The pixel 2 depicted in FIG. 43 includes the first FD portion 53 and the second FD portion 55, and the coupling line 301 is connected to the second FD portion 55. The capacitive element 311 is disposed between the coupling line 301 and the second FD portion 55.

FIG. 44 is a view depicting the sectional configuration example of the pixel 2 depicted in FIG. 43. In FIG. 44, the first transfer transistor 52, the first FD portion 53, the second transfer transistor 54, and the second FD portion 55 are depicted side by side. The coupling line 301 is connected to the diffusion layer of the second FD portion 55, and the capacitive element 311 is disposed at part of the coupling line 301.

The example depicted in FIGs. 43 and 44 is an example in which the pixel 2 includes the two FD portions and has a smaller number of coupling lines than the number of FD portions and the coupling line is disposed only on the low gain side. The FD range can be enlarged and the dark current can be suppressed by making the configuration in which a smaller number of coupling lines than the number of FD portions are disposed and the disposed coupling line is connected to the FD portion on the low gain side (in this case, second FD portion 55) as above.

The circuit configuration and a sectional configuration example of the pixel 2 depicted in FIGs. 45 and 46 depict a configuration example in the case in which the same number of coupling lines as the number of FD portions are disposed.

The pixel 2 depicted in FIG. 45 includes the first FD portion 53 and the second FD portion 55. The coupling line 302 is connected to the first FD portion 53, and the coupling line 301 is connected to the second FD portion 55. The capacitive element 312 is disposed between the coupling line 302 and the first FD portion 53. The capacitive element 311 is disposed between the coupling line 301 and the second FD portion 55.

FIG. 46 is a view depicting the sectional configuration example of the pixel 2 depicted in FIG. 45. In FIG. 46, the first transfer transistor 52, the first FD portion 53, the second transfer transistor 54, and the second FD portion 55 are depicted side by side. The coupling line 302 is connected to the diffusion layer of the first FD portion 53, and the capacitive element 312 is disposed at part of the coupling line 302. The coupling line 301 is connected to the diffusion layer of the second FD portion 55, and the capacitive element 311 is disposed at part of the coupling line 301.

The example depicted in FIGs. 45 and 46 is an example in which the pixel 2 includes the two FD portions and has the same number of coupling lines as the number of FD portions and the coupling lines are disposed on both the high gain side and the low gain side. The FD range can be enlarged and the dark current can be suppressed by making the configuration in which the same number of coupling lines as the number of FD portions are disposed and the disposed coupling lines are connected to the FD portions on the high gain side and the low gain side (in this case, first FD portion 53 and second FD portion 55) as above.

The inclusion of the coupling line makes it possible to achieve both suppression of the dark current and ensuring of the number of saturated electrons. In the pixel with the configuration which has the function of switching the conversion efficiency and does not share the FD portion by a plurality of pixels, coupling can be given to a desired place and effective contribution to dark current suppression and Qs enlargement of the FD portion is allowed.

For example, it is possible to execute control in which the voltage is stepped down to suppress the dark current during signal accumulation and the voltage is stepped up to ensure the FD range during signal readout. Further, in the case in which the fear of the dark current is low, it is also possible that the voltage is not particularly stepped down during signal accumulation and the voltage is stepped up to enlarge the FD range during signal readout.

The above-described first to tenth embodiments can be carried out alone, of course, and it is also possible to carry out a plurality of embodiments among them in combination.

### <Twelfth Embodiment>

FIG. 47 is a view obtained by extracting the inter-pixel isolation portion 81 and the element isolation portion 82 from the diagram which is depicted in FIG. 5 and depicts the planar configuration example of the surface of the silicon substrate in which the transistors of the pixel 2 are disposed.

In regions "a" to "d" (in FIG. 47, regions surrounded by a circle) in which the inter-pixel isolation portion 81 is in contact with the element isolation portion 82, there is a possibility that the shape of the inter-pixel isolation portion 81 and the element isolation portion 82 becomes sharp, for example, such a shape as to intersect each other at 90 degrees in FIG. 47, and thus becomes a shape which readily causes electric field concentration. When an electric field concentrates at regions "a" to "d" and a high electric field is made, there is a possibility that a dark current or a white spot occurs and the image quality deteriorates.

With reference to FIG. 48, a description is given of a structure of the pixel 2 in a twelfth embodiment, made as a structure in which an electric field does not concentrate at regions "a" to "d" in which the inter-pixel isolation portion 81 is in contact with the element isolation portion 82.

FIG. 48 is a view depicting a planar configuration example of the pixel 2 in the twelfth embodiment. FIG. 49 is a view depicting a sectional configuration example along line segment A-B in FIG. 48. The pixel 2 depicted in FIG. 48 is a diagram depicting an arrangement example of the inter-pixel isolation portion 81 and the element isolation portion 82 as with the pixel 2 depicted in FIG. 47.

Regions "a" to "d" of the pixel 2 depicted in FIG. 48 are formed with a shape which is not a sharp shape. Regions "a" to "d" of the pixel 2 depicted in FIG. 48 are configured to avoid a sharp shape by expanding the shape of the element isolation portion 82. As depicted in FIG. 49, in the sectional configuration along line segment A-B, the inter-pixel isolation portion 81 is formed with a predetermined thickness (width), and the element isolation portion 82 is formed between the inter-pixel isolation portion 81 and the inter-pixel isolation portion 81 and at the upper surface in the diagram.

As above, the shape of the element isolation portion 82 in contact with the inter-pixel isolation portion 81 is expanded. This allows the absence of a portion with a sharp shape in the regions in which the inter-pixel isolation portion 81 is in contact with the element isolation portion 82. Employing such a shape of the element isolation portion 82 can prevent the concentration of an electric field and suppress the occurrence of a dark current or a white spot which occurs due to the concentration of an electric field.

In FIG. 48, the example is depicted in which, for example, the element isolation portion 82 in region "a" is formed with a shape including a triangular shape. However, the shape may be any shape as long as it is a shape without a sharp portion. For example, the shape may be a shape having a circular arc.

Referring to FIG. 48, the regions in which the inter-pixel isolation portion 81 is in contact with the element isolation portion 82 exist at four places. These four places can be classified into the following three kinds.

Referring to FIGs. 48 and 5, the region corresponding to region "a" is a region in which the gate of the second transfer transistor 54 (described as FDG in FIG. 5) is formed. The pixel 2 depicted in FIG. 5 has the circuit configuration depicted in FIG. 2 and has the first FD portion 53, the second FD portion 55, and the third FD portion 57. In the case in which the configuration which has the plurality of FD portions and accumulates a signal which has overflowed in the FD portions as above is employed, when a dark current occurs in the FD portion, there is a possibility of the deterioration of the image quality at a bridge point at which HDR synthesis is executed.

For such a reason, the dark current in the FD portion needs to be sufficiently small. By making a shape which is not sharp in region "a," a structure to suppress the dark current which occurs in the FD portion can be made. The region disposed in order to make the dark current in the FD portion small is defined as region 1.

Referring to FIGs. 48 and 5, the regions corresponding to regions "b" and "c" exist at the VSS region 73 (described as VSS in FIG. 5). The VSS region 73 involves a possibility that charge of the P+ diffusion layer moves to the FD portion or the photodiode PD, and therefore is a region desired not to be sharp even at a place where an electric field does not occur (defined as region 2). The absence of a sharp place in such regions "b" and "c" can be achieved, and the flow of charge to the FD portion or the photodiode PD can be suppressed.

Referring to FIGs. 48 and 5, the region corresponding to region "d" exists at the VSL region 72 (described as VSL in FIG. 5). When a dark current moves to the photodiode PD in the case in which the dark current has occurred in the VSL region 72 or the VDD region 71, possibly it becomes the dark current of the photodiode PD. Thus, it is preferable to reduce also such a possibility. The region to suppress such a dark current which occurs in the VSL region 72 or the VDD region 71 is defined as region 3 hereinafter. The absence of a sharp place in this region 3 (in this case, region d) can be achieved, and the occurrence of a dark current can be suppressed.

FIGs. 50 and 51 are views depicting another configuration example of the pixel 2 in the twelfth embodiment. FIG. 50 is a view depicting another planar configuration example of the pixel 2 in the twelfth embodiment. FIG. 51 is a view depicting a sectional configuration example along line segment A-B in FIG. 50. The pixel 2 depicted in FIG. 50 is a diagram depicting an arrangement example of the inter-pixel isolation portion 81 and the element isolation portion 82 as with the pixel 2 depicted in FIG. 47.

For the pixel 2 described with reference to FIGs. 48 and 49, the description has been given by taking the example in which the shape without a sharp portion is made by giving an expanded shape to the element isolation portion 82 in the regions in which the inter-pixel isolation portion 81 is in contact with the element isolation portion 82. The pixel 2 to be described with reference to FIGs. 50 and 51 is an example in which a shape without a sharp portion is made by giving an expanded shape to the inter-pixel isolation portion 81 in the regions in which the inter-pixel isolation portion 81 is in contact with the element isolation portion 82.

Regions "a" to "d" of the pixel 2 depicted in FIG. 50 are formed with a shape which is not a sharp shape. Regions "a" to "d" of the pixel 2 depicted in FIG. 50 are configured to avoid a sharp shape by expanding the shape of the inter-pixel isolation portion 81.

As depicted in FIG. 51, in the sectional configuration along line segment A-B, the inter-pixel isolation portion 81 is formed with a predetermined thickness (width), and the element isolation portion 82 is formed between the inter-pixel isolation portion 81 and the inter-pixel isolation portion 81 and at the upper surface in the diagram. The width of this inter-pixel isolation portion 81 is set wide compared with the width of the inter-pixel isolation portion 81 of the pixel 2 depicted in FIG. 49.

As above, the shape of the inter-pixel isolation portion 81 in contact with the inter-pixel isolation portion 81 is expanded. This allows the absence of a portion with a sharp shape in the regions in which the inter-pixel isolation portion 81 is in contact with the element isolation portion 82. Employing such a shape of the inter-pixel isolation portion 81 can prevent the concentration of an electric field and also suppress the occurrence of a dark current or a white spot which occurs due to the concentration of an electric field.

It is also possible to apply the twelfth embodiment in combination with any one or a plurality of embodiments among the first to eleventh embodiments.

### <Thirteenth Embodiment>

FIG. 52 is a view depicting a planar configuration example of a surface of the silicon substrate in which the transistors of the pixel 2 in a thirteenth embodiment are disposed. FIG. 52 depicts a planar configuration example of the pixel 2 having the circuit configuration depicted in FIG. 2. A planar configuration example of the pixel 2 having the circuit configuration depicted in FIG. 2 is depicted also in FIG. 5. However, the arrangement of the transistors is different from the planar configuration example depicted in FIG. 5, and the shape of the element isolation portion 82 is also different in association with this. A part similar to that in the pixel 2 depicted in FIG. 5 is given a similar reference sign and description thereof is omitted as appropriate.

The gate electrode TRG of the first transfer transistor 52 is formed around the center of the pixel 2. The gates of the transistors other than the first transfer transistor 52 included in the pixel 2 are disposed, with the gate electrode TRG of the first transfer transistor 52 centered. In the diagram, the gate electrode FDG of the second transfer transistor 54 is formed on the left side of the gate electrode TRG of the first transfer transistor 52. The first FD portion 53 including an N+ diffusion layer is disposed between the gate electrode TRG and the gate electrode FDG and in the silicon substrate.

The gate electrode FCG of the third transfer transistor 56 is formed on the upper side of the gate electrode TRG of the first transfer transistor 52 in the diagram. The second FD portion 55 is disposed between the second transfer transistor 54 and the third transfer transistor 56.

The gate electrode RST of the reset transistor 58 is formed on the upper right side of the gate electrode TRG of the first transfer transistor 52. The third FD portion 57 is formed between the third transfer transistor 56 and the reset transistor 58.

The VSS region 73 including a P+ diffusion layer is formed on the right side of the gate electrode TRG of the first transfer transistor 52 in the diagram. The VDD region 71 which includes a P+ diffusion layer and is connected to the supply voltage VDD is formed on the lower side of the gate electrode RST of the reset transistor 58 in the diagram and between the reset transistor 58 and the VSS region 73. The VDD region 71 and the VSS region 73 are isolated by the element isolation portion 82.

The VSL region 72 connected to the vertical signal line 9 is formed on the lower right side of the gate electrode TRG of the first transfer transistor 52 in the diagram. The VSL region 72 and the VSS region 73 are isolated by the element isolation portion 82.

The gate electrode SEL of the selection transistor 60 is formed on the left side of the VSL region 72 in the diagram and on the lower right side of the gate electrode TRG of the first transfer transistor 52 in the diagram. The gate electrode AMP of the amplification transistor 59 is formed on the left side of the selection transistor 60 in the diagram and on the lower left side of the gate electrode TRG of the first transfer transistor 52 in the diagram.

The VDD region 71 is formed on the left side of the gate electrode AMP of the amplification transistor 59 in the diagram.

For the pixel 2, the inter-pixel isolation portion 81 is disposed in a pixel boundary region, and element isolation is established by the element isolation portion 82 in an active region. The active region is a region depicted as an open region in the diagram.

Part of the element isolation portion 82 is formed in contact with the inter-pixel isolation portion 81. In the example depicted in FIG. 52, there exist the element isolation portion 82 existing between the second transfer transistor 54 existing on the left side in the diagram and the VDD region 71, the element isolation portion 82 existing between the VDD region 71 existing on the right side in the diagram and the VSS region 73, and the element isolation portion 82 existing between the VSS region 73 existing on the right side in the diagram and the VSL region 72.

In these regions in which the inter-pixel isolation portion 81 is in contact with the element isolation portion 82, regions corresponding to regions 1, 2, and 3 described in the twelfth embodiment exist. Region 1, namely, the region for suppressing the occurrence of a dark current in the FD portion, is region "a."

Regions 2, namely, the regions for suppressing the movement of charge generated in the VSS region 73 to the FD portion or the photodiode PD, are regions "d" and "e."

Regions 3, namely, the regions for suppressing the movement of a dark current generated in the VDD region 71 or the VSL region 72 to the photodiode PD, are regions "b," "c," and "f."

Regions "a" to "f" are formed into a shape without a sharp portion as in the twelfth embodiment. These regions may be formed with avoidance of a sharp shape by forming the element isolation portion 82 into an expanded shape as described with reference to FIGs. 48 and 49. Alternatively, these regions may be formed with avoidance of a sharp shape by forming the inter-pixel isolation portion 81 into an expanded shape as described with reference to FIGs. 50 and 51. In FIG. 52, the case in which the element isolation portion 82 is formed into an expanded shape is depicted as an example.

As above, the configuration to suppress the occurrence of a dark current or a white spot can be made even in the case in which the arrangement of the transistors is changed.

Further, also in the configuration of the pixel 2 depicted in FIG. 52, as with the case depicted in FIG. 5, the pixel transistors other than the first transfer transistor 52 (second transfer transistor 54, third transfer transistor 56, reset transistor 58, amplification transistor 59, and selection transistor 60) are disposed on not only the element isolation portion 82 but also the inter-pixel isolation portion 81.

The gate electrodes of the pixel transistors other than the first transfer transistor 52 are configured to overlap with the inter-pixel isolation portion 81 as depicted in FIG. 52. In other words, a partial region of the gate electrodes of the pixel transistors is configured in the state in which the partial region includes a region overlapping with the inter-pixel isolation portion 81 in plan view. By making the configuration overlapping with the inter-pixel isolation portion 81, the region of the electrode gate can be ensured.

The gate electrodes of the pixel transistors other than the first transfer transistor 52 are configured to also overlap with the element isolation portion 82 as depicted in FIG. 52. In other words, a partial region of the gate electrodes of the pixel transistors is configured in the state in which the partial region includes a region overlapping with the element isolation portion 82 in plan view.

In such a manner, the transistors included in the pixel 2 other than the first transfer transistor 52 are disposed to surround the first transfer transistor. Further, each transistor included in the pixel 2 other than the first transfer transistor 52 is configured such that at least one side overlaps with the inter-pixel isolation portion 81 in plan view and the side opposite the side overlapping with the inter-pixel isolation portion 81 overlaps with the element isolation portion 82.

By disposing the transistors in such a manner, the WL dimensions of the pixel transistors which can be disposed per one pixel can be enlarged, and thus cut-off variation and amplification noise of the pixel transistors can be designed to be small. Moreover, the first transfer transistor 52 which transfers charge obtained by conversion by the photoelectric conversion portion 51 to the FD portion is disposed at the center of the pixel 2, namely, the center of the photoelectric conversion portion 51. This can make a configuration in which a signal from the photoelectric conversion portion 51 is easily transferred to the first FD portion 53.

### <Fourteenth Embodiment>

FIG. 53 is a view depicting a planar configuration example of a surface of the silicon substrate in which the transistors of the pixel 2 in a fourteenth embodiment are disposed. FIG. 53 depicts a planar configuration example of the pixel 2 having the circuit configuration depicted in FIG. 2. A planar configuration example of the pixel 2 having the circuit configuration depicted in FIG. 2 is depicted also in FIG. 5. However, the arrangement of the transistors is different from the planar configuration example depicted in FIG. 5, and the shape of the element isolation portion 82 is also different in association with this. A part similar to that in the pixel 2 depicted in FIG. 5 is given a similar reference sign and description thereof is omitted as appropriate.

The gate electrode TRG of the first transfer transistor 52 is formed around the center of the pixel 2. The gates of the transistors other than the first transfer transistor 52 included in the pixel 2 are disposed, with the gate electrode TRG of the first transfer transistor 52 centered. In the diagram, the gate electrode FDG of the second transfer transistor 54 is formed on the left side of the gate electrode TRG of the first transfer transistor 52. The first FD portion 53 is disposed between the gate electrode TRG and the gate electrode FDG.

The gate electrode FCG of the third transfer transistor 56 is formed on the upper side of the gate electrode TRG of the first transfer transistor 52 in the diagram. The second FD portion 55 is disposed between the second transfer transistor 54 and the third transfer transistor 56. A third FD portion 57-1 is formed on the right side of the gate electrode FCG of the third transfer transistor 56 in the diagram.

The VSS region 73 is formed on the upper right side of the gate electrode TRG of the first transfer transistor 52. The element isolation portion 82 is formed between the third FD portion 57-1 and the VSS region 73.

The gate electrode RST of the reset transistor 58 is disposed on the right side of the gate electrode TRG of the first transfer transistor 52. A third FD portion 57-2 is disposed on the upper side of the gate electrode RST of the reset transistor 58 in the diagram, and the VDD region 71 is disposed on the lower side in the diagram. The third FD portion 57-1 and the third FD portion 57-2 are connected by an interconnect disposed at another layer to form one third FD portion 57. The element isolation portion 82 is formed between the third FD portion 57-2 and the VSS region 73.

The VSL region 72 is disposed on the lower side of the VDD region 71 in the diagram. The element isolation portion 82 is formed between the VSL region 72 and the VDD region 71. The gate electrode SEL of the selection transistor 60 is formed on the left side of the VSL region 72 in the diagram and on the lower right side of the gate electrode TRG of the first transfer transistor 52 in the diagram.

The gate electrode AMP of the amplification transistor 59 is formed on the lower left side of the selection transistor 60 in the diagram. The VDD region 71 is formed on the left side of the gate electrode AMP of the amplification transistor 59 in the diagram, in other words, on the lower left side of the gate electrode TRG of the first transfer transistor 52 in the diagram.

For the pixel 2, the inter-pixel isolation portion 81 is disposed in a pixel boundary region, and element isolation is established by the element isolation portion 82 in an active region. The active region is a region depicted as an open region in the diagram.

Part of the element isolation portion 82 is formed in contact with the inter-pixel isolation portion 81. In the example depicted in FIG. 53, there exist the element isolation portion 82 existing between the second transfer transistor 54 existing on the left side in the diagram and the VDD region 71, the element isolation portion 82 existing between the third FD portion 57-1 existing on the upper side in the diagram and the VSS region 73, the element isolation portion 82 existing between the VSS region 73 existing on the right side in the diagram and the third FD portion 57-2, and the element isolation portion 82 existing between the VDD region 71 existing on the right side in the diagram and the VSL region 72.

In these regions in which the inter-pixel isolation portion 81 is in contact with the element isolation portion 82, regions corresponding to regions 1, 2, and 3 described in the twelfth embodiment exist. Regions 1, namely, the regions for suppressing the occurrence of a dark current in the FD portion, are regions "a," "c," and "f."

Regions 2, namely, the regions for suppressing the movement of charge generated in the VSS region 73 to the FD portion or the photodiode PD, are regions "d" and "e."

Regions 3, namely, the regions for suppressing the movement of a dark current generated in the VDD region 71 or the VSL region 72 to the photodiode PD, are regions "b," "g," and "h."

Regions "a" to "h" are formed into a shape without a sharp portion as in the twelfth embodiment. These regions may be formed with avoidance of a sharp shape by forming the element isolation portion 82 into an expanded shape as described with reference to FIGs. 48 and 49. Alternatively, these regions may be formed with avoidance of a sharp shape by forming the inter-pixel isolation portion 81 into an expanded shape as described with reference to FIGs. 50 and 51. In FIG. 53, the case in which the element isolation portion 82 is formed into an expanded shape is depicted as an example.

As above, the configuration to suppress the occurrence of a dark current or a white spot can be made even in the case in which the arrangement of the transistors is changed.

Further, also in the configuration of the pixel 2 depicted in FIG. 53, as with the case depicted in FIG. 5, part of the pixel transistors other than the first transfer transistor 52 (second transfer transistor 54, third transfer transistor 56, reset transistor 58, amplification transistor 59, and selection transistor 60) is disposed also on the element isolation portion 82 and the inter-pixel isolation portion 81.

The gate electrodes of the pixel transistors other than the first transfer transistor 52 are configured to overlap with the inter-pixel isolation portion 81 as depicted in FIG. 53. In other words, a partial region of the gate electrodes of the pixel transistors is configured in the state in which the partial region includes a region overlapping with the inter-pixel isolation portion 81 in plan view. By making the configuration overlapping with the inter-pixel isolation portion 81, the region of the electrode gate can be ensured.

The gate electrodes of the pixel transistors other than the first transfer transistor 52 are configured to also overlap with the element isolation portion 82 as depicted in FIG. 53. In other words, a partial region of the gate electrodes of the pixel transistors is configured in the state in which the partial region includes a region overlapping with the element isolation portion 82 in plan view.

In such a manner, the transistors included in the pixel 2 other than the first transfer transistor 52 are disposed to surround the first transfer transistor. Further, each transistor included in the pixel 2 other than the first transfer transistor 52 is configured such that at least one side overlaps with the inter-pixel isolation portion 81 in plan view and the side opposite the side overlapping with the inter-pixel isolation portion 81 overlaps with the element isolation portion 82.

By disposing the transistors in such a manner, the WL dimensions of the pixel transistors which can be disposed per one pixel can be enlarged, and thus cut-off variation and amplification noise of the pixel transistors can be designed to be small. Moreover, the first transfer transistor 52 which transfers charge obtained by conversion by the photoelectric conversion portion 51 to the FD portion is disposed at the center of the pixel 2, namely, the center of the photoelectric conversion portion 51. This can make a configuration in which a signal from the photoelectric conversion portion 51 is easily transferred to the first FD portion 53.

### <Case of Combination with Fifth Embodiment>

FIG. 54 is a view depicting a planar configuration example of the pixel 2 for explaining the case in which the fifth embodiment and the twelfth embodiment are combined. The fifth embodiment has been described with reference to FIGs. 15 and 16. The circuit configuration example of the pixel 2 in the fifth embodiment depicted in FIG. 15 is a configuration having three FD portions as with the pixel 2 in the first to third embodiments, and is a configuration to which the overflow transistor 201 is further added.

A planar configuration example of the pixel 2 having the circuit configuration depicted in FIG. 15 is depicted in FIG. 16. Moreover, a planar configuration example depicted in FIG. 54 is obtained in the case in which the twelfth embodiment is applied to the pixel 2 having the planar configuration example depicted in FIG. 16. The planar configuration example of the pixel 2 depicted in FIG. 54 is similar to the planar configuration example of the pixel 2 depicted in FIG. 16, and is a drawing obtained by adding circles indicating regions "a" to "d" to the planar configuration example of the pixel 2 depicted in FIG. 16. The arrangement of the transistors and the like of the pixel 2 depicted in FIG. 54 has already been described with reference to FIG. 16, and therefore description thereof is omitted.

In the regions in which the inter-pixel isolation portion 81 is in contact with the element isolation portion 82 in the pixel 2 depicted in FIG. 54, regions corresponding to regions 1, 2, and 3 described in the twelfth embodiment exist. Regions 1, namely, the regions for suppressing the occurrence of a dark current in the FD portion, are regions "a" and "b."

Region 2, namely, the region for suppressing the movement of charge generated in the VSS region 73 to the FD portion or the photodiode PD, is region "d."

Region 3, namely, the region for suppressing the movement of a dark current generated in the VDD region 71 or the VSL region 72 to the photodiode PD, is region "c."

Regions "a" to "d" are formed into a shape without a sharp portion as in the twelfth embodiment. These regions may be formed with avoidance of a sharp shape by forming the element isolation portion 82 into an expanded shape as described with reference to FIGs. 48 and 49. Alternatively, these regions may be formed with avoidance of a sharp shape by forming the inter-pixel isolation portion 81 into an expanded shape as described with reference to FIGs. 50 and 51. In FIG. 54, the case in which the element isolation portion 82 is formed into an expanded shape is depicted as an example.

As above, the configuration to suppress the occurrence of a dark current or a white spot can be formed by making the configuration such that a sharp portion is absent.

### <Fifteenth Embodiment>

FIG. 55 is a view depicting a circuit configuration example of the pixel 2 in a fifteenth embodiment. The circuit configuration of the pixel 2 depicted in FIG. 55 is different in that it is formed into a configuration obtained by deleting the overflow transistor 201 from the circuit configuration of the pixel 2 depicted in FIG. 15, and the other points are similar. In the circuit configuration of the pixel 2 depicted in FIG. 15, a configuration is depicted in which a memory 501 is connected to the third FD portion 57 and the memory 501 also functions as the third FD portion 57. However, it is also possible to employ a configuration without the memory 501 as with the above-described embodiments.

In the case of the pixel 2 having the circuit configuration depicted in FIG. 55, design is made such that the Low cut-off of the third transfer transistor 56 is deeper than the Low cut-off of the reset transistor 58, and a signal accumulated in the second FD portion 55 overflows through the third transfer transistor 56 and is accumulated in the third FD portion 57 (memory 501).

The planar configuration example of the pixel 2 depicted in FIG. 53 can be applied as a planar configuration example of the pixel 2 having the circuit configuration depicted in FIG. 55. Thus, description thereof is omitted here.

Also to the pixel 2 having the circuit configuration depicted in FIG. 55, any one or a plurality of embodiments in combination among the first to fourteenth embodiments can be applied.

### <Sixteenth Embodiment>

FIG. 56 is a view depicting a sectional configuration example of the pixel 2 in a sixteenth embodiment. When the pixel 2 depicted in FIG. 56 is compared with the pixel 2 depicted in FIG. 7, the configuration of the inter-pixel isolation portion 81 is different and the other points are similar. Description is omitted regarding the part similar to that in the sectional configuration example of the pixel 2 depicted in FIG. 7.

The inter-pixel isolation portion 81 of the pixel 2 depicted in FIG. 56 includes an inside layer 401 obtained by filling the inside with polysilicon or metal and an oxide film 402 which surrounds the inside layer 401. It is also possible to form the inter-pixel isolation portion 81 into a configuration in which a plurality of layers are stacked in such a manner.

In the case in which the inter-pixel isolation portion 81 is provided with the inside layer 401, as depicted in FIG. 57, a configuration in which a power supply 421 which provides a predetermined voltage is connected to the inside layer 401 may be employed. By employing the configuration in which a bias is applied to the inside layer 401 of the inter-pixel isolation portion 81, pinning can be enhanced, and a configuration which further suppresses the occurrence of a dark current can be made.

It is possible to carry out the fifteenth embodiment in combination with any one or a plurality of embodiments among the first to fourteenth embodiments.

### <Seventeenth-1st Embodiment>

FIG. 58 is a view depicting a circuit configuration example of the pixel 2 in a seventeenth-1st embodiment. The pixel 2 in the seventeenth-1st embodiment has a configuration having three FD portions as in the pixel 2 in the first embodiment, and is formed into a configuration to which the overflow transistor 201 is further added. A part with the same configuration as the pixel 2 in the first embodiment is given the same reference sign and description thereof is omitted as appropriate.

The pixel 2 has the photoelectric conversion portion 51, the first transfer transistor 52, the first FD portion 53, the second transfer transistor 54, the second FD portion 55, the third transfer transistor 56, the third FD portion 57, the reset transistor 58, the amplification transistor 59, the selection transistor 60, and the overflow transistor 201.

The overflow transistor 201 is disposed between the photoelectric conversion portion 51 and the third FD portion 57, and is configured such that charge which has overflowed from the photoelectric conversion portion 51 is accumulated in the third FD portion 57.

The first transfer transistor 52 is disposed between the photoelectric conversion portion 51 and the first FD portion 53. The drive signal TRG is supplied to the gate electrode of the first transfer transistor 52. When this drive signal TRG becomes the high level, the first transfer transistor 52 is turned on, and the charge accumulated in the photoelectric conversion portion 51 is transferred to the first FD portion 53 through the first transfer transistor 52.

The second transfer transistor 54 is disposed between the first FD portion 53 and the second FD portion 55. The drive signal FDG is supplied to the gate electrode of the second transfer transistor 54. When this drive signal FDG becomes the high level, the second transfer transistor 54 is turned on, and charge from the first FD portion 53 is transferred to the second FD portion 55 through the second transfer transistor 54.

Through the turning-on of the second transfer transistor 54, the region in which charge is accumulated becomes the region obtained by combining the first FD portion 53 with the second FD portion 55, and the conversion efficiency when the charge generated in the photoelectric conversion portion is converted to a voltage can be switched.

The third transfer transistor 56 is disposed between the second FD portion 55 and the third FD portion 57. The drive signal FCG is supplied to the gate electrode of the third transfer transistor 56. When this drive signal FCG becomes the high level, the third transfer transistor 56 is turned on, and charge from the second FD portion 55 is transferred to the third FD portion 57 through the third transfer transistor 56.

Through the turning-on of the third transfer transistor 56, the region in which charge is accumulated becomes the region obtained by combining the first FD portion 53, the second FD portion 55, and the third FD portion 57, and the conversion efficiency when the charge generated in the photoelectric conversion portion is converted to a voltage can be switched. As described above, charge which has overflowed from the photoelectric conversion portion 51 and been transferred through the overflow transistor 201 is also accumulated in the third FD portion 57.

The reset transistor 58 is connected to the power supply VDD and the third FD portion 57. The drive signal RST is supplied to the gate electrode of the reset transistor 58. When the drive signal RST is set to the high level, the reset transistor 58 is turned on, and the potential of the third FD portion 57 is reset to the level of the supply voltage VDD.

The amplification transistor 59 has the gate electrode connected to the first FD portion 53 and the drain connected to the power supply VDD, and serves as an input portion of a readout circuit which reads out a signal corresponding to the charge held by the first FD portion 53, a generally-called source follower circuit. That is, the source of the amplification transistor 59 is connected to the vertical signal line 9 through the selection transistor 60. This makes the amplification transistor 59 form the source follower circuit with a constant current source (not depicted) connected to one end of the vertical signal line 9.

The selection transistor 60 is connected between the source of the amplification transistor 59 and the vertical signal line 9. The drive signal SEL is supplied to the gate electrode of the selection transistor 60. When the drive signal SEL is set to the high level, the selection transistor 60 is turned on, and the pixel 2 becomes the selected state. Due to this, the pixel signal output from the amplification transistor 59 is output to the vertical signal line 9 through the selection transistor 31.

### <Planar Configuration Example of Pixel>

FIG. 59 is a view depicting a planar configuration example of a surface of the silicon substrate in which the transistors of the pixel 2 having the circuit configuration depicted in FIG. 58 are disposed. The planar configuration example depicted in FIG. 59 is basically similar to the planar configuration example depicted in FIG. 5, but is different in that the overflow transistor 201 is added.

The gate electrode TRG of the first transfer transistor 52 is formed around the center of the pixel 2. The gates of the transistors other than the first transfer transistor 52 included in the pixel 2 are disposed, with the gate electrode TRG of the first transfer transistor 52 centered. In the diagram, the gate electrode FDG of the second transfer transistor 54 is formed on the left side of the gate electrode TRG of the first transfer transistor 52. The first FD portion 53 including an N+ diffusion layer is disposed between the gate electrode TRG and the gate electrode FDG and in the silicon substrate.

The gate electrode FCG of the third transfer transistor 56 is formed on the upper side of the gate electrode TRG of the first transfer transistor 52 in the diagram. The second FD portion 55 is disposed between the second transfer transistor 54 and the third transfer transistor 56.

The gate electrode RST of the reset transistor 58 is formed on the upper right side of the gate electrode TRG of the first transfer transistor 52. The third FD portion 57 is formed between the third transfer transistor 56 and the reset transistor 58.

The gate electrode AMP of the amplification transistor 59 is formed on the right side of the gate electrode TRG of the first transfer transistor 52 in the diagram. The VDD region 71 which includes a P+ diffusion layer and is connected to the supply voltage VDD is formed between the reset transistor 58 and the amplification transistor 59.

The gate electrode SEL of the selection transistor 60 is formed on the lower side of the gate electrode TRG of the first transfer transistor 52 in the diagram. The VSL region connected to the vertical signal line 9 is formed on the left side of the selection transistor 60 in the diagram.

The VSS region 73 including a P+ diffusion layer is formed on the lower left side of the first transfer transistor 52 in the diagram.

The gate electrode OFG of the overflow transistor 201 is formed between the gate electrode TRG of the first transfer transistor 52 and the third FD portion 57.

The inter-pixel isolation portion 81 is formed to surround the pixel 2. For example, the inter-pixel isolation portion 81 is formed by FFTI (Front Full Trench Isolation). The inter-pixel isolation portion 81 can be formed by a trench which does not penetrate or penetrates the semiconductor substrate. The pixels 2 are isolated by an insulator due to the inter-pixel isolation portion 81, and the respective pixels 2 are configured to be electrically isolated.

The element isolation portion 82 is formed between the transistors configuring the pixel 2. As the element isolation portion 82, for example, a structure obtained by forming a trench with a predetermined depth in an element isolation region and burying an insulating film therein or a region formed by ion implantation is employed.

For the pixel 2, the inter-pixel isolation portion 81 is disposed in a pixel boundary region, and element isolation is established by the element isolation portion 82 in an active region. The active region is a region depicted as an open region in the diagram, and is formed with a shape continuous from the lower side of the gate electrode TRG of the first transfer transistor 52 to the VSL region 72. Further, the active region is disposed also in the region in which the overflow transistor 201 is disposed. Thus, the configuration is made with a shape in which the active region of the first transfer transistor 52 and the active region of the third FD portion 57 are also continuous.

Part of the element isolation portion 82 is formed in contact with the inter-pixel isolation portion 81. In the example depicted in FIG. 59, the element isolation portion 82 existing between the second transfer transistor 54 and the VSS region 73 and the element isolation portion 82 existing between the VSS region 73 and the VSL region 72 are formed in contact with the inter-pixel isolation portion 81.

The pixel transistors other than the first transfer transistor 52 (second transfer transistor 54, third transfer transistor 56, reset transistor 58, amplification transistor 59, and selection transistor 60) are not only disposed on the element isolation portion 82 as element isolation but also disposed on the inter-pixel isolation portion 81.

The gate electrodes of the pixel transistors other than the first transfer transistor 52 and the overflow transistor 201 are configured to overlap with the inter-pixel isolation portion 81 as depicted in FIG. 59. In other words, a partial region of the gate electrodes of the pixel transistors is configured in the state in which the partial region includes a region overlapping with the inter-pixel isolation portion 81 in plan view. By making the configuration overlapping with the inter-pixel isolation portion 81, the region of the electrode gate can be ensured.

In such a manner, the transistors included in the pixel 2 other than the first transfer transistor 52 are disposed to surround the first transfer transistor. Further, each transistor included in the pixel 2 other than the first transfer transistor 52 and the overflow transistor 201 is configured such that at least one side overlaps with the inter-pixel isolation portion 81 in plan view and the side opposite the side overlapping with the inter-pixel isolation portion 81 overlaps with the element isolation portion 82.

By disposing the transistors in such a manner, the WL dimensions of the pixel transistors which can be disposed per one pixel can be enlarged, and thus cut-off variation and amplification noise of the pixel transistors can be designed to be small. Moreover, the first transfer transistor 52 which transfers charge obtained by conversion by the photoelectric conversion portion 51 to the FD portion is disposed at the center of the pixel 2, namely, the center of the photoelectric conversion portion 51. This can make a configuration in which a signal from the photoelectric conversion portion 51 is easily transferred to the first FD portion 53.

### <Sectional Configuration Example of Pixel>

A sectional configuration example along line segment A-A' regarding the pixel 2 depicted in FIG. 59 is depicted in FIG. 60. A sectional configuration example along line segment B-B' regarding the pixel 2 depicted in FIG. 59 is depicted in FIG. 61.

Referring to the sectional configuration examples of the pixel 2 depicted in FIGs. 60 and 61, the pixel 2 includes the semiconductor substrate 80 and a multilayer interconnect layer (not depicted) formed on the front surface side thereof (upper side in the diagram). In FIG. 7, the lower side is the light incident surface side and is a side on which on-chip lenses, a color filter, and the like which are not depicted are disposed. In FIGs. 60 and 61, the upper side is the interconnect layer side, and a plurality of transistors are formed thereon.

The photodiode PD is formed in units of pixel in the semiconductor substrate 80. Between the pixels 2 of the semiconductor substrate 80, the inter-pixel isolation portion 81 which isolates adjacent pixels from each other in the depth direction of the semiconductor substrate 80 is formed from the back surface side (light incident surface side) of the semiconductor substrate 80 to a predetermined depth in the substrate depth direction. Meanwhile, on the front surface side of the semiconductor substrate 80 on which the multilayer interconnect layer is formed, one first transfer transistor 52 is formed for one photodiode PD formed in each pixel 2. The gate electrode TRG of the first transfer transistor 52 is connected to the N-type region of the photodiode PD. The N+ region 105 which is the first FD portion 53 is formed on the left side of the first transfer transistor 52 in the diagram.

The second transfer transistor 54 is formed on the left side of the first FD portion 53 in the diagram. A channel 113 is formed by an N-type region on the lower side of the gate electrode FDG of the second transfer transistor 54.

As depicted in FIG. 60, the gate electrode FDG of the second transfer transistor 54 is formed with such a position and a size that one side includes a region overlapping with the inter-pixel isolation portion 81. Although not depicted in FIG. 60, part of the gate electrode FDG of the second transfer transistor 54 is formed to include a region overlapping with the element isolation portion 82.

The element isolation portion 82 is formed on the right side of the first transfer transistor 52 in the diagram. The pinning film 108 is formed on the lower side of the element isolation portion 82. The amplification transistor 59 is formed on the right side of this element isolation portion 82 in the diagram. The channel 106 is formed by an N-type region on the lower side of the gate electrode AMP of the amplification transistor 59.

As depicted in FIG. 60, the gate electrode AMP of the amplification transistor 59 is formed with such a position and a size that one side includes a region overlapping with the element isolation portion 82 and the other side includes a region overlapping with the inter-pixel isolation portion 81.

As above, the transistors disposed around the first transfer transistor 52, for example, in FIG. 60, the selection transistor 60 and the amplification transistor 59, are configured such that (part of) one side exists on the inter-pixel isolation portion 132 and (part of) the other side exists on the element isolation portion 82.

Referring to the sectional configuration example depicted in FIG. 61, the element isolation portion 82 is formed on the left side of the first FD portion 53 in the diagram. The pinning film 108 is formed on the lower side of the element isolation portion 82. The selection transistor 60 is formed on the right side of this element isolation portion 82 in the diagram. The channel 104 is formed by an N-type region on the lower side of the gate electrode SEL of the selection transistor 60.

As depicted in FIG. 61, the gate electrode SEL of the selection transistor 60 is formed with such a position and a size that one side includes a region overlapping with the element isolation portion 82 and the other side includes a region overlapping with the inter-pixel isolation portion 81.

The gate electrode OFG of the overflow transistor 201 is formed on the right side of the gate electrode TRG of the first transfer transistor 52 in the diagram. A channel 114 is formed by an N-type region from part of the right side of the lower side of the gate electrode TRG of the first transfer transistor 52 in the diagram to the lower side of the gate electrode OFG of the overflow transistor 201.

The N+ region 112 which is the third FD portion 57 is formed on the right side of the overflow transistor 201 in the diagram.

As above, the transistor disposed around the first transfer transistor 52, for example, in FIG. 61, the selection transistor 60, is configured such that one side exists on the inter-pixel isolation portion 81 and the other side exists on the element isolation portion 82.

The gate electrode TRG of the first transfer transistor 52 may have a configuration in which a gate is disposed also in the perpendicular direction as depicted in FIGs. 62 and 63. Referring to FIGs. 62 and 63, configurations are made in which part of the gate electrode TRG of the first transfer transistor 52 is disposed to reach part of the photodiode PD.

The gate electrode TRG of the first transfer transistor 52 is formed into a configuration having a gate disposed on the front surface of the semiconductor substrate 80 (gate disposed in the horizontal direction) and a gate disposed to the inside of the N-type semiconductor region 101 of the photodiode PD in the semiconductor substrate 80 (gate disposed in the perpendicular direction).

It is also possible to employ such a configuration using the vertical transistor having the gate also in the vertical direction. Here, the description has been given by taking as an example the case in which the first transfer transistor 52 is the vertical transistor. However, the present technology can be applied also to the case in which the transistor other than the first transfer transistor 52 is the vertical transistor.

### <Seventeenth-2nd Embodiment>

FIG. 64 is a view depicting a circuit configuration example of the pixel 2 in a seventeenth-2nd embodiment. The pixel 2 in the seventeenth-2nd embodiment depicted in FIG. 64 is different in that it is formed into a configuration obtained by deleting the overflow transistor 201 from the pixel 2 in the seventeenth-1st embodiment depicted in FIG. 58, and the other points are similar. Description is omitted as appropriate regarding the similar points.

One side of the third FD portion 57 is connected to the photoelectric conversion portion 51, and the other side is connected to the reset transistor 58.

FIG. 65 is a view depicting a planar configuration example of the pixel 2 in the seventeenth-2nd embodiment. Because the configuration which does not include the overflow transistor 201 between the third FD portion 57 and the photoelectric conversion portion 51 is employed, the pixel 2 is configured such that the overflow transistor 201 is not disposed between the first transfer transistor 52 and the third FD portion 57.

Although the overflow transistor 201 is not disposed, a region having the function of the overflow transistor 201 is disposed. FIG. 66 is a view depicting a sectional configuration example along line segment B-B' depicted in FIG. 65. The N+ region 112 which is the third FD portion 57 is formed on the right side of the gate electrode TRG of the first transfer transistor 52 in the diagram.

An N-type region 121 is formed between part of the right side of the lower side of the gate electrode TRG of the first transfer transistor 52 in the diagram and the third FD portion 57. This N-type region 121 is configured to have a potential gradient and allow charge which has overflowed from the photoelectric conversion portion 51 to be easily transferred to the third FD portion 57. By disposing such a region having a potential gradient between the photoelectric conversion portion 51 and the third FD portion 57, the configuration in which the overflow transistor 201 is not disposed can also be employed. In FIG. 66, the example in which the N+ region 121 is formed in the front surface of the silicon substrate is depicted. However, a configuration may be employed in which the N+ region 121 having a potential gradient is formed in a region deep from the front surface by a predetermined depth in the depth direction. By disposing the N+ region 121 at a position separate from the third FD portion 57, a configuration in which overflow control is less susceptible to the influence of drain modulation can be made. It is to be noted that the drain here is the third FD portion 57. It is possible to make a configuration less likely to be affected by a drop of the drain voltage due to overflow and the occurrence of drain modulation.

The sectional configuration along line segment A-A' in FIG. 65 is similar to the sectional configuration depicted in FIG. 60, and therefore description thereof is omitted.

As depicted in a sectional configuration example of FIG. 67, it is also possible to employ a configuration in which the first transfer transistor 52 is formed as a vertical transistor also in the pixel 2 which does not include the overflow transistor 201 and has the region 121 having a potential gradient.

### <Seventeenth-3rd Embodiment>

A description is given of the pixel 2 in a seventeenth-3rd embodiment. To the circuit of the pixel 2 in the seventeenth-3rd embodiment, for example, the circuit configuration depicted in FIG. 64, which has three FD portions and does not include the overflow transistor 201, can be applied. As for a planar configuration example, the planar configuration example of the pixel 2 depicted in FIG. 5 (FIG. 18) can be applied.

FIG. 68 is a view depicting a sectional configuration example of the pixel 2 in the seventeenth-3rd embodiment. The sectional configuration example depicted in FIG. 68 is the sectional configuration example along line segment C-C' in FIG. 18, and depicts the sectional configuration example along line segment C-C', along which the selection transistor 60, the first transfer transistor 52, and the third FD portion 57 are disposed. Between the first transfer transistor 52 and the third FD portion 57, the element isolation portion 82 is disposed and the N+ region 121 is disposed on the lower side of the element isolation portion 82 in the diagram and in the silicon substrate.

The N+ region 121 includes, for example, an N-type region having a potential gradient. By forming the N+ region 121 by a region having a potential gradient, a configuration can be made in which charge which has overflowed from the photoelectric conversion portion 51 is easily transferred to the third FD portion 57. It is also possible to make a configuration in which the overflow transistor 201 is not disposed by disposing such an N+ region 121 having a potential gradient between the photoelectric conversion portion 51 and the third FD portion 57 and on the lower side of the element isolation portion 82 (in the silicon substrate). Further, by disposing the element isolation portion 82 between the first transfer transistor 52 and the third FD portion 57, overflow can be controlled without being affected by drain modulation of the third FD portion 57.

As depicted in a sectional configuration example of FIG. 69, it is also possible to employ a configuration in which the first transfer transistor 52 is formed as a vertical transistor also in the pixel 2 which does not include the overflow transistor 201 and has the N+ region 121 having a potential gradient.

Also in the seventeenth embodiments, the WL dimensions of the pixel transistors which can be disposed per one pixel can be enlarged, and cut-off variation and amplification noise of the pixel transistors can be designed to be small. Moreover, the first transfer transistor 52 which transfers charge obtained by conversion by the photoelectric conversion portion 51 to the FD portion is disposed at the center of the pixel 2, namely, the center of the photoelectric conversion portion 51. This can make a configuration in which a signal from the photoelectric conversion portion 51 is easily transferred to the first FD portion 53.

The above-described first to seventeenth embodiments can be carried out alone, of course, and it is also possible to carry out a plurality of embodiments among them in combination.

### <Eighteenth-1st Embodiment>

A planar configuration example of the pixel 2 depicted in FIG. 70 is a planar configuration example in the circuit configuration example of the pixel 2 depicted in FIG. 2, and is a planar configuration example of the pixel 2 in an eighteenth-1st embodiment.

The gate electrode TRG of the first transfer transistor 52 is formed around the center of the pixel 2. In the diagram, the gate electrode FDG of the second transfer transistor 54 is formed on the left side of the gate electrode TRG of the first transfer transistor 52. The first FD portion 53 including an N+ diffusion layer is disposed between the gate electrode TRG and the gate electrode FDG and in the silicon substrate.

The gate electrode FCG of the third transfer transistor 56 is formed on the upper side of the gate electrode TRG of the first transfer transistor 52 in the diagram. The second FD portion 55 is disposed between the second transfer transistor 54 and the third transfer transistor 56.

The gate electrode RST of the reset transistor 58 is formed on the upper right side of the gate electrode TRG of the first transfer transistor 52. The third FD portion 57 is formed between the third transfer transistor 56 and the reset transistor 58.

The VDD region 71 which includes a P+ diffusion layer and is connected to the supply voltage VDD and the VSS region 73 including a P+ diffusion layer are formed on the right side of the gate electrode TRG of the first transfer transistor 52.

The VSL region 72 connected to the vertical signal line 9 is formed on the lower right side of the gate electrode TRG of the first transfer transistor 52 and on the lower side of the VSS region 73. The element isolation portion 82 is disposed between the VDD region 71 and the VSS region 73 and between the VSS region 73 and the VSL region 72.

The gate electrode SEL of the selection transistor 60 and the gate electrode AMP of the amplification transistor 59 are formed on the lower side of the gate electrode TRG of the first transfer transistor 52 in the diagram. The VDD region 71 is formed on the left side of the gate electrode AMP of the amplification transistor 59 in the diagram.

In the pixel 2 depicted in FIG. 70, the gate electrode AMP of the amplification transistor 59 is formed on the lower side of the first FD portion 53. The first FD portion 53 and the gate electrode AMP are connected by an interconnect. In the pixel 2 in the eighteenth-1st embodiment depicted in FIG. 70, the first FD portion 53 and the amplification transistor 59 are disposed at close positions compared with the pixels 2 in the first to seventeenth embodiments.

Due to the disposing of the first FD portion 53 and the amplification transistor 59 at close positions, the D (Data Phase) range during high conversion efficiency operation can be made high. In addition, high conversion efficiency is allowed, and improving the image quality at low illuminance is enabled.

The inter-pixel isolation portion 81 is formed to surround the pixel 2. The pixels 2 are isolated by an insulator due to the inter-pixel isolation portion 81, and the respective pixels 2 are configured to be electrically isolated. The element isolation portion 82 is formed between the transistors configuring the pixel 2. As the element isolation portion 82, for example, a structure obtained by forming a trench with a predetermined depth in an element isolation region and burying an insulating film therein or a region formed by ion implantation is employed.

For the pixel 2, the inter-pixel isolation portion 81 is disposed in a pixel boundary region, and element isolation is established by the element isolation portion 82 in an active region. The active region is a region depicted as an open region in the diagram, and is formed with a shape continuous from the lower side of the gate electrode TRG of the first transfer transistor 52 to the VDD region 71. Further, the active region is formed with a shape continuous from the VSL region 72 formed along one side on the lower side in the diagram to the VDD region 71.

Part of the element isolation portion 82 is formed in contact with the inter-pixel isolation portion 81. In the example depicted in FIG. 70, the element isolation portion 82 existing between the second transfer transistor 54 and the VDD region 71, the element isolation portion 82 existing between the VDD region 71 and the VSS region 73, and the element isolation portion 82 existing between the VSS region 73 and the VSL region 72 are formed in contact with the inter-pixel isolation portion 81.

The pixel transistors other than the first transfer transistor 52 (second transfer transistor 54, third transfer transistor 56, reset transistor 58, amplification transistor 59, and selection transistor 60) are not only disposed on the element isolation portion 82 as element isolation but also disposed on the inter-pixel isolation portion 81.

The gate electrodes of the pixel transistors other than the first transfer transistor 52 are configured to overlap with the inter-pixel isolation portion 81 as depicted in FIG. 70. In other words, a partial region of the gate electrodes of the pixel transistors is configured in the state in which the partial region includes a region overlapping with the inter-pixel isolation portion 81 in plan view. By making the configuration overlapping with the inter-pixel isolation portion 81, the region of the electrode gate can be ensured.

Also in the pixel 2 in the eighteenth-1st embodiment, the WL dimensions of the pixel transistors which can be disposed per one pixel can be enlarged, and thus cut-off variation and amplification noise of the pixel transistors can be designed to be small. Moreover, the first transfer transistor 52 which transfers charge obtained by conversion by the photoelectric conversion portion 51 to the FD portion is disposed at the center of the pixel 2, namely, the center of the photoelectric conversion portion 51. This can make a configuration in which a signal from the photoelectric conversion portion 51 is easily transferred to the first FD portion 53.

### <Eighteenth-2nd Embodiment>

A planar configuration example of the pixel 2 depicted in FIG. 71 is a planar configuration example in the circuit configuration example of the pixel 2 depicted in FIG. 2, and is a planar configuration example of the pixel 2 in an eighteenth-2nd embodiment.

A pixel 2-1 and a pixel 2-2 which are adjacent are depicted in FIG. 71. The pixel 2-1 and the pixel 2-2 each have a configuration similar to that of the pixel 2 depicted in FIG. 5, and the arrangement of the transistors and the like are basically similar. In the pixel 2-1 and the pixel 2-2 depicted in FIG. 71, the gate electrode FDG of the second transfer transistor 54 is configured to be smaller than the gate electrode FDG depicted in FIG. 5.

In the gate electrodes FDG depicted in FIG. 71, the left side in the diagram overlaps with the inter-pixel isolation portion 81, and the right side overlaps with the element isolation portion 82. However, differently from the gate electrode FDG depicted in FIG. 5, the gate electrodes FDG depicted in FIG. 71 are formed into a configuration in which the lower side in the diagram does not overlap with the element isolation portion 82.

The pixel 2 in the eighteenth-2nd embodiment is configured to use the amplification transistor 59 and the selection transistor 60 located in the adjacent pixel 2 as the amplification transistor 59 and the selection transistor 60 of the own pixel 2. In the case in which attention is paid to the pixel 2-2 as the own pixel 2, in the circuit configuration depicted in FIG. 2 relating to the pixel 2-2, the first transfer transistor 52, the second transfer transistor 54, the third transfer transistor 56, and the reset transistor 58 are configured by transistors disposed in the region of the pixel 2-2, and the amplification transistor 59 and the selection transistor 60 are configured by transistors disposed in the region of the pixel 2-1 (another pixel 2) adjacent on the left side in the diagram.

The pixels 2 in the first to eighteenth-1st embodiments are examples in which the transistors are disposed such that the circuit depicted in FIG. 2 relating to the own pixel 2 can be configured by the transistors disposed in the own pixel 2. The pixel 2 in the eighteenth-2nd embodiment is an example in which the transistors are disposed such that the circuit depicted in FIG. 2 relating to the own pixel 2 can be configured by the transistors disposed in the own pixel 2 and the transistors disposed in another pixel 2 adjacent.

Charge accumulated in the pixel 2-2 is processed by the transistors and the regions disposed in a range 601 depicted in FIG. 71. The range 601 includes a first transfer transistor 52-2, a first FD portion 53-2, a second transfer transistor 54-2, a second FD portion 55-2, a third transfer transistor 56-2, a third FD portion 57-2, a reset transistor 58-2, a VDD region 71-2, and a VSS region 73-2 which are disposed in the region of the pixel 2-2. Moreover, the range 601 includes an amplification transistor 59-1, a selection transistor 60-1, a VSL region 72-1, and a VSS region 73-1 which are disposed in the region of the pixel 2-1.

As above, the configuration in which the transistor disposed in the region of the adjacent pixel 2 is used as the amplification transistor 59 is employed. The first FD portion 53-2 of the own pixel 2-2 and the amplification transistor 59 -1 of the other pixel 2-1 are connected by an interconnect or the like disposed through the inter-pixel isolation portion. This makes a configuration in which a signal can be supplied from the first FD portion 53-2 to the amplification transistor 59-1.

Using the amplification transistor 59 disposed in the adjacent pixel 2 can shorten the distance between the amplification transistor 59 and the first FD portion 53. For example, when distance "a" between the amplification transistor 59-2 and the first FD portion 53-2 in the own pixel 2-2 is compared with distance "b" between the amplification transistor 59-1 in the pixel 2-1 and the first FD portion 53-2 in the pixel 2-2, a relation of distance "a" > distance "b" is satisfied.

As with the eighteenth-1st embodiment, by shortening the distance between the amplification transistor 59 and the first FD portion 53, the D range during high conversion efficiency operation can be made high. In addition, high conversion efficiency is allowed, and improving the image quality at low illuminance is enabled.

Employing such a configuration eliminates the need for a Poly-shield of the gate electrode FDG, and can make the area of the gate electrode FDG small as depicted in FIG. 71. The reduction in the area of the gate electrode FDG makes it possible to prevent also voltage step-down during the P phase (Preset Phase) due to charge injection.

It becomes possible to simultaneously implement reduction in coupling between the amplification transistor 59 (AMP) and the second transfer transistor 54 (FDG) and achievement of high conversion efficiency.

### <Eighteenth-3rd Embodiment>

A planar configuration example of the pixel 2 depicted in FIG. 72 is a planar configuration example in the circuit configuration example of the pixel 2 depicted in FIG. 2, and is a planar configuration example of the pixel 2 in an eighteenth-3rd embodiment.

The pixel 2 in the above-described eighteenth-2nd embodiment has been described by taking the example using the amplification transistor 59 and the selection transistor 60 disposed in the region of the adjacent pixel 2. The pixel 2 in the eighteenth-3rd embodiment is described by taking as an example the case of using the amplification transistor 59 disposed in the region of the adjacent pixel 2 and using the selection transistor 60 disposed in the region of the own pixel 2. In the case of such a configuration, the arrangement of the transistors like one depicted in FIG. 72 is made.

The pixel 2-1 and the pixel 2-2 have the same configuration. Thus, a description is given of the configuration of the pixel 2 by taking the pixel 2-1 as an example. The gate electrode TRG of a first transfer transistor 52-1 is formed around the center of the pixel 2-1. In the diagram, the gate electrode FDG of a second transfer transistor 54-1 is formed on the upper left side of the gate electrode TRG of the first transfer transistor 52-1. A first FD portion 53-1 including an N+ diffusion layer is disposed between the gate electrode TRG and the gate electrode FDG and in the silicon substrate.

The gate electrode FCG of a third transfer transistor 56-1 is formed on the upper side of the gate electrode TRG of the first transfer transistor 52-1 in the diagram. A second FD portion 55-1 is disposed between the second transfer transistor 54-1 and the third transfer transistor 56-1.

The gate electrode RST of a reset transistor 58-1 is formed on the upper right side of the gate electrode TRG of the first transfer transistor 52-1. A third FD portion 57-1 is formed between the third transfer transistor 56-1 and the reset transistor 58-1.

A VDD region 71-1 which includes a P+ diffusion layer and is connected to the supply voltage VDD and the gate electrode AMP of the amplification transistor 59-1 are formed on the right side of the gate electrode TRG of the first transfer transistor 52-1.

The VSS region 73-1, the VSL region 72-1 connected to the vertical signal line 9, and the gate electrode SEL of the selection transistor 60-1 are formed on the lower side of the gate electrode TRG of the first transfer transistor 52-1.

In the diagram depicted in FIG. 72, the adjacent two pixels 2 having such a configuration are depicted. The pixel 2-1 and the pixel 2-2 which are adjacent are depicted in FIG. 72. In the pixels 2 depicted in FIG. 72, the gate electrode FDG of the second transfer transistor 54 is configured to be smaller than the gate electrode FDG depicted in FIG. 5 as with the pixels 2 depicted in FIG. 71.

The pixel 2 in the eighteenth-3rd embodiment is configured to use the amplification transistor 59-1 located in the adjacent pixel 2. In the case in which attention is paid to the pixel 2-2, in the circuit configuration depicted in FIG. 2 relating to the pixel 2-2, the first transfer transistor 52, the second transfer transistor 54, the third transfer transistor 56, the reset transistor 58, and the selection transistor 60 are configured by transistors disposed in the region of the pixel 2-2 (own pixel), and the amplification transistor 59 is configured by a transistor disposed in the region of the pixel 2-1 adjacent on the left side in the diagram.

In the pixel 2 in the eighteenth-3rd embodiment, the transistors are disposed such that the circuit depicted in FIG. 2 relating to the own pixel 2 can be configured by the transistors disposed in the own pixel 2 and the transistor disposed in another pixel 2 adjacent.

Charge accumulated in the pixel 2-2 is processed by the transistors and the regions disposed in a range 602 depicted in FIG. 72. The range 602 includes the first transfer transistor 52-2, the first FD portion 53-2, the second transfer transistor 54-2, the second FD portion 55-2, the third transfer transistor 56-2, the third FD portion 57-2, the reset transistor 58-2, the selection transistor 60-2, the VDD region 71, and the VSS region 73 which are disposed in the region of the pixel 2-2. Moreover, the range 602 includes the amplification transistor 59-1 and the VSS region 73-1 which are disposed in the region of the pixel 2-1.

As above, the configuration in which the transistor disposed in the region of the adjacent pixel 2 is used as the amplification transistor 59 is employed. The first FD portion 53-1 disposed in the region in the own pixel 2 and the amplification transistor 59 disposed in the region in the other pixel 2 are connected by an interconnect or the like disposed through the inter-pixel isolation portion 81. This makes a configuration in which a signal can be supplied from the first FD portion 53 to the amplification transistor 59. Further, the selection transistor 60-2 disposed in the region in the pixel 2-2 and the VDD region 71-1 connected to the amplification transistor 59-1 disposed in the region in the pixel 2-1 are connected by an interconnect or the like disposed through the inter-pixel isolation portion 81. This makes a configuration in which a signal from the amplification transistor 59-1 can be supplied to the selection transistor 60-2.

As with the eighteenth-1st embodiment, by shortening the distance between the amplification transistor 59 and the first FD portion 53, the D range during high conversion efficiency operation can be made high. In addition, high conversion efficiency is allowed, and improving the image quality at low illuminance is enabled.

Employing such a configuration eliminates the need for a Poly-shield of the gate electrode FDG, and can make the area of the gate electrode FDG small as depicted in FIG. 72. The reduction in the area of the gate electrode FDG makes it possible to prevent also voltage step-down during the P phase due to charge injection.

It becomes possible to simultaneously implement reduction in coupling between the amplification transistor 59 (AMP) and the second transfer transistor 54 (FDG) and high conversion efficiency.

### <Nineteenth-1st Embodiment>

Nineteenth embodiments are embodiments relating to connection between transistors, connection between a transistor and a predetermined region, connection between predetermined regions, and the like, and can be applied to any mode of the first to eighteenth embodiments. Here, a description is given of the case in which the nineteenth embodiments are applied to the pixel 2 of the eighteenth-2nd embodiment depicted in FIG. 71 by taking as an example the interconnect which connects the first FD portion 53-2 to the gate electrode AMP of the amplification transistor 59-1.

FIG. 73 is an enlarged view of the part of the first FD portion 53-2 and the amplification transistor 59-1, and is a view depicting the interconnect which connects them. The inter-pixel isolation portion 81 is disposed between the pixel 2-1 and the pixel 2-2. One sidewall of the gate electrode AMP of the amplification transistor 59-1 is located on the inter-pixel isolation portion 81, and the other sidewall is located on the element isolation portion 82.

A metal contact 701 disposed in the vertical direction in the diagram is connected to the gate electrode AMP. The metal contact 701 is connected to an interconnect 703. The interconnect 703 is an interconnect disposed in an M1 layer in the multilayer interconnect layer stacked on the semiconductor substrate 80. A metal contact 702 is also connected to the interconnect 703, and is connected to the first FD portion 53-2.

Connection which does not use such metal contacts 701 and 702 and an interconnect 703 is described with reference to FIGs. 74 and 75. FIG. 74 depicts a planar configuration example of the pixel 2 in a nineteenth-1st embodiment. FIG. 75 is an enlarged view of a sectional configuration example of the part of the amplification transistor 59.

The planar configuration example depicted in FIG. 74 depicts the pixel 2-1 and the pixel 2-2 which are adjacent as with the planar configuration example depicted in FIG. 71. The gate electrode AMP of the amplification transistor 59-1 disposed in the region of the pixel 2-1 depicted in FIG. 74 is disposed to extend to such a position as to be in contact with the first FD portion 53-2 of the adjacent pixel 2-2. The gate electrode AMP of the amplification transistor 59-1 is formed also on the inter-pixel isolation portion 81 and is further formed onto the first FD portion 53-1 ahead.

Referring to the sectional configuration example depicted in FIG. 75, the inter-pixel isolation portion 81 is disposed between the pixel 2-1 and the pixel 2-2. One sidewall of the gate electrode AMP of the amplification transistor 59-1 is located on the inter-pixel isolation portion 81, and the other sidewall is located on the first FD portion 53-2. The gate electrode AMP is formed from the inside of the pixel 2-1 to a position on the first FD portion 53-2 in the pixel 2-2 through over the inter-pixel isolation portion 81.

In the case in which the gate electrode AMP includes Poly-Si (polycrystalline silicon), the amplification transistor 59-1 and the first FD portion 53-1 are configured to be directly connected by the Poly-electrode.

Due to the application of the connection which does not use the metal contacts 701 and 702 and the interconnect 703 in such a manner, there is no need to consider the layout, the contact capacitance, and the like of the metal contacts 701 and 702 and the interconnect 703. Thus, design restrictions are reduced, and the conversion efficiency can be improved.

### <Nineteenth-2nd Embodiment>

FIG. 76 is a view depicting a sectional configuration example of the pixel 2 in a nineteenth-2nd embodiment. The configuration of the pixel 2 depicted in FIG. 76 depicts a configuration in the case in which side contact is made for connection between the amplification transistor 59-1 and the first FD portion 53-2.

The gate electrode AMP of the amplification transistor 59-1 has a trenched structure at a side surface of the first FD portion 53 of the pixel 2-2, and the trenched structure is filled with a material to form the gate electrode AMP, for example, Poly-Si. The gate electrode AMP is formed into a structure which makes contact in the semiconductor substrate 80 and at the side surface of the first FD portion 53-2.

The structure of the gate electrode AMP depicted in FIG. 76 is formed into a structure in which one side of the gate electrode AMP is located on the element isolation portion 82-1 of the pixel 2-1 and the other side is located in the trenched structure made at the side surface of the first FD portion 53-1 of the semiconductor substrate 80 of the pixel 2-2 and the gate electrode AMP is in contact with the first FD portion 53-2 at the part of the trenched structure.

By employing the structure in which contact is made from the side surface of the first FD portion 53 (making of side contact) in such a manner, the flexibility of the layout of the gate electrode AMP of the amplification transistor 59, for example, an electrode including Poly-Si, can be increased. Thus, design with high flexibility also for design of the conversion efficiency and noise countermeasures is enabled.

### <Nineteenth-3rd Embodiment>

FIG. 77 is a view depicting a sectional configuration example of the pixel 2 in a nineteenth-3rd embodiment. The configuration of the pixel 2 depicted in FIG. 77 is another configuration in the case in which side contact is made for connection between the amplification transistor 59-1 and the first FD portion 53-2.

The gate electrode AMP of the amplification transistor 59-1 has a trenched structure in the inter-pixel isolation portion 81 on the side of the first FD portion 53-2 of the pixel 2-2, and the trenched structure is filled with a material to form the gate electrode AMP, for example, Poly-Si. The gate electrode AMP is formed into a structure in contact with a side surface of the first FD portion 53-2 in the inter-pixel isolation portion 81.

The structure of the gate electrode AMP depicted in FIG. 77 is formed into a structure in which one side of the gate electrode AMP is located on the element isolation portion 82-1 of the pixel 2-1 and the other side is located in the trenched structure made in a side surface of the inter-pixel isolation portion 81 of the pixel 2-2 and the gate electrode AMP is in contact with the side surface of the first FD portion 53-2 at the part of the trenched structure.

By employing the structure in which contact is made from the side surface of the first FD portion 53 (making of side contact) in such a manner, the flexibility of the layout of the gate electrode AMP of the amplification transistor 59 can be increased. Thus, design with high flexibility also for design of the conversion efficiency and noise countermeasures is enabled.

### <Nineteenth-4th Embodiment>

FIG. 78 is a view depicting a sectional configuration example of the pixel 2 in a nineteenth-4th embodiment. The configuration of the pixel 2 depicted in FIG. 78 depicts another configuration in the case in which side contact is made for connection between the amplification transistor 59 and the first FD portion 53.

The structure depicted in FIG. 78 can be applied to, for example, the pixel 2 depicted in FIG. 70. The pixel 2 depicted in FIG. 70 has a structure in which the amplification transistor 59 is disposed on the lower side of the first FD portion 53 in the diagram in plan view and the first FD portion 53 and the amplification transistor 59 are connected. A description is given of the case in which the connection in the nineteenth-4th embodiment is applied to the first FD portion 53 and the amplification transistor 59 disposed in such one pixel 2.

The gate electrode AMP of the amplification transistor 59 has a trenched structure in part of the element isolation portion 82 existing between the first FD portion 53 and the amplification transistor 59 or a side surface of the element isolation portion 82, and has a structure in which the trenched structure is filled with a material to form the gate electrode AMP, for example, Poly-Si.

One side (left side in the diagram) of the gate electrode AMP is located on the inter-pixel isolation portion 81, and the other side is formed into a structure in contact with the first FD portion 53 at the part of the trenched structure. The gate electrode AMP is formed into a structure in contact with a side surface of the first FD portion 53.

By employing the structure in which contact is made from the side surface of the first FD portion 53 (making of side contact) in such a manner, the flexibility of the layout of the gate electrode AMP of the amplification transistor 59 can be increased. Thus, design with high flexibility also for design of the conversion efficiency and noise countermeasures is enabled.

### <Nineteenth-5th Embodiment>

FIG. 79 is a view depicting a sectional configuration example of the pixel 2 in a nineteenth-5th embodiment. The configuration of the pixel 2 depicted in FIG. 79 has a structure in which a contact 711 including a predetermined material is used for connection between the amplification transistor 59-1 and the first FD portion 53-2.

The inter-pixel isolation portion 81 is disposed between the pixel 2-1 and the pixel 2-2. One sidewall of the gate electrode AMP of the amplification transistor 59-1 is located on the inter-pixel isolation portion 81, and the other sidewall is located on the element isolation portion 82. The contact 711 is formed to cover part (in the diagram, approximately half) of an upper portion of the gate electrode AMP, cover an upper portion of the sidewall disposed on the inter-pixel isolation portion 81, and cover a range to an upper portion of the first FD portion 53-2 disposed in the pixel 2-2.

The contact 711 includes, for example, Poly-Si (polysilicon). In this case, the gate electrode AMP has, for example, the configuration described with reference to FIG. 73, and the contact 711 which establishes connection from such a gate electrode AMP to the first FD portion 53 is formed. It is also possible to employ the configuration in which such a contact 711 is disposed.

As with the nineteenth-1st embodiment, also in the nineteenth-5th embodiment, there is no need to consider the layout, the contact capacitance, and the like of the metal contacts 701 and 702 and the interconnect 703. Thus, design restrictions are reduced, and the conversion efficiency can be improved.

### <Nineteenth-6th Embodiment>

FIG. 80 is a view depicting a sectional configuration example of the pixel 2 in a nineteenth-6th embodiment. The configuration of the pixel 2 depicted in FIG. 80 is a configuration in the case in which side contact is made for the contact 711 depicted in FIG. 79.

A contact 713 depicted in FIG. 80 has a trenched structure at a side surface of the first FD portion 53 of the pixel 2-2, and the trenched structure is filled with a material to form the contact 713, for example, Poly-Si. One side of the contact 713 depicted in FIG. 80 is located on the gate electrode AMP of the amplification transistor 59-1 of the pixel 2-1. The other side is formed into a structure which is located in the trenched structure made on the side surface side of the first FD portion 53-2 of the pixel 2-2 and is in contact with the side surface of the first FD portion 53-2 at the part of the trenched structure.

By employing the structure in which contact is made from the side surface of the first FD portion 53 (making of side contact) in such a manner, the flexibility of the layout of the gate electrode AMP of the amplification transistor 59 can be increased. Thus, design with high flexibility also for design of the conversion efficiency and noise countermeasures is enabled.

According to the nineteenth embodiments, it is also possible to make a structure which reduces the Source/Drain (S/D) concentration of the FD portion, which is a cause of electric field increase contributing to a white spot in the FD portion, by combining making of side contact and making of Poly-contact.

It is possible to carry out the nineteenth embodiments in combination with any of the first to eighteenth embodiments. Further, it is also possible to employ a configuration in which, in one pixel 2, the transistors and the regions are connected by applying any one or a plurality of embodiments among the nineteenth-1st to nineteenth-6th embodiments. Moreover, it is also possible to employ a configuration in which, in adjacent two pixels 2, the transistors and the regions are connected by applying any one or a plurality of embodiments among the nineteenth-1st to nineteenth-6th embodiments.

### <Twentieth-1st Embodiment>

FIG. 81 is a view depicting a planar configuration example of the pixel 2 in a twentieth-1st embodiment. FIG. 81 is a view depicting the planar configuration example of the pixel 2 in the case in which the twentieth-1st embodiment is applied to the pixel 2 in the first embodiment depicted in FIG. 5. It is possible to apply the twentieth embodiments to be described below in combination with any or a plurality of embodiments among the first to nineteenth embodiments. Here, the description is continued by taking as an example the case in which the twentieth embodiments are combined with the first embodiment.

The pixels 2 in the twentieth embodiments have contacts. For example, in the case in which the interconnect coupling between FD portions is high, by making contacts to dispose a plurality of walls based on the contacts, the influence from an adjacent portion is reduced and the coupling is reduced.

In the pixel 2 depicted in FIG. 81, contacts 731-1 to 731-10 are disposed. The contacts 731 are disposed to, for example, penetrate the multilayer interconnect layer in the vertical direction from the semiconductor substrate 80 like the metal contact 701 depicted in FIG. 73, and include a predetermined material, for example, a material such as Poly-Si or a metal.

The contact 731-1 is disposed at one end portion of the gate electrode FDG of the second transfer transistor 54, and the contact 731-2 is disposed at the other end portion. The contact 731-3 is disposed at one end portion of the gate electrode FCG of the third transfer transistor 56, and the contact 731-4 is disposed at the other end portion. The contact 731-5 is disposed at one end portion of the gate electrode RST of the reset transistor 58, and the contact 731-6 is disposed at the other end portion (lower right corner portion in the diagram).

The contact 731-7 is disposed at one end portion of the gate electrode AMP of the amplification transistor 59, and the contact 731-8 is disposed at the other end portion. The contact 731-9 is disposed at one end portion of the gate electrode SEL of the selection transistor 60, and the contact 731-10 is disposed at the other end portion.

In such a manner, the contacts 731 are disposed at both ends of each gate electrode. This provides a structure in which the influence from a region adjacent to the gate electrode, for example, a region adjacent in the own pixel 2 or a region in the adjacent pixel 2, can be prevented by the contact 731 disposed at the end portion of the gate electrode.

The contacts 731-1 to 731-10 may be configured to be connected to, for example, the interconnect 703 disposed in the M1 layer depicted in FIG. 73. Further, the contact 731 which is not connected to the interconnect 703 (hereinafter, referred to as dummy contact 732) may be included. FIG. 82 is a view depicting a planar configuration example of the pixel 2 in the case in which the dummy contacts 732 are included.

The contact 731-1 is disposed at one end portion of the gate electrode FDG of the second transfer transistor 54, and a dummy contact 732-1 is disposed at the other end portion. A dummy contact 732-2 is disposed at one end portion of the gate electrode FCG of the third transfer transistor 56, and the contact 731-4 is disposed at the other end portion. A dummy contact 732-3 is disposed at one end portion of the gate electrode RST of the reset transistor 58, and the contact 731-6 is disposed at the other end portion (lower right corner portion in the diagram).

A dummy contact 732-4 is disposed at one end portion of the gate electrode AMP of the amplification transistor 59, and the contact 731-8 is disposed at the other end portion. A dummy contact 732-5 is disposed at one end portion of the gate electrode SEL of the selection transistor 60, and the contact 731-10 is disposed at the other end portion.

The arrangement of the contacts 731 and the dummy contacts 732 is not limited to the arrangements depicted in FIGs. 81 and 82, and another arrangement may be applied. For example, on a predetermined gate electrode, only the dummy contacts 732 may be disposed or only the contacts 731 may be disposed. Moreover, the gate electrode on which neither the contact 731 nor the dummy contact 732 is disposed may exist in the pixel 2.

Also in the case in which the dummy contacts 732 which are not connected to an interconnect are disposed as above, a structure is provided in which, for example, the influence from a region adjacent in the own pixel 2 or a region in the adjacent pixel 2 can be prevented by the contact 731 disposed at the end portion of the gate electrode.

### <Twentieth-2nd Embodiment>

FIG. 83 depicts a planar configuration example of the pixel 2 in a twentieth-2nd embodiment. FIG. 84 depicts a sectional configuration example of the pixel 2 along line segment B-B' in FIG. 83. The planar configuration example of the pixel 2 depicted in FIG. 83 is a planar configuration example of the pixel 2 in the case in which the twentieth-2nd embodiment is applied to the pixel 2 in the first embodiment depicted in FIG. 5.

In the pixel 2 depicted in FIG. 83, the dummy contacts 732 are disposed on the inter-pixel isolation portion 81. In the example depicted in FIG. 83, a dummy contact 732-11 is disposed at an upper left corner portion of the pixel 2 in the diagram. A dummy contact 732-12 is disposed at a lower left corner portion in the diagram. A dummy contact 732-13 is disposed at a lower right corner portion in the diagram.

In the example depicted in FIG. 83, an example is depicted in which the dummy contact 732 is not disposed at an upper right corner portion in the diagram because the gate electrode RST of the reset transistor 58 is formed thereat. For example, the twentieth-1st embodiment may be applied to the reset transistor 58 to allow the contacts 731-5 and 731-6 (FIG. 81) to be disposed on the reset transistor 58. Alternatively, the twentieth-1st embodiment may be applied to the reset transistor 58 to allow the dummy contact 732-3 and the contact 731-6 (FIG. 81) to be disposed on the reset transistor 58.

The twentieth-2nd embodiment can be applied in combination with the twentieth-1st embodiment.

FIG. 84 is a view depicting the sectional configuration example of the pixel 2 along line segment B-B' in FIG. 83. The sectional configuration example depicted in FIG. 84 is a configuration basically similar to the sectional configuration example of FIG. 20, and is different in that the dummy contact 732-13 is disposed on the inter-pixel isolation portion 81.

The dummy contact 732 disposed on the inter-pixel isolation portion 81 may be configured to be fixed at GND. It is to be noted that, although here the description has been given by taking as an example the case in which the dummy contact 732 is disposed on the inter-pixel isolation portion 81, it is also possible to employ a configuration in which the dummy contact 732 is disposed on the element isolation portion 82 or a configuration in which the dummy contact 732 is disposed on the inter-pixel isolation portion 81 and the element isolation portion 82.

### <Twentieth-3rd Embodiment>

FIG. 85 depicts a planar configuration example of the pixel 2 in a twentieth-3rd embodiment. FIG. 86 depicts a sectional configuration example of the pixel 2 along line segment B-B' in FIG. 85.

The pixel 2 in the twentieth-3rd embodiment is formed into a configuration obtained by adding Poly-contacts 741 to the pixel 2 in the twentieth-2nd embodiment (FIGs. 83 and 84).

In the pixel 2 depicted in FIGs. 85 and 86, the Poly-contacts 741 including Poly-Si are formed with predetermined size and thickness on the inter-pixel isolation portion 81, and the dummy contacts 732 are connected to the Poly-contacts 741. For example, referring to the sectional configuration example of FIG. 86, a Poly-contact 741-1 is formed on the inter-pixel isolation portion 81, and the dummy contact 732-11 is connected onto the Poly-contact 741-1.

Referring to the planar configuration example of FIG. 85, the Poly-contact 741-1 and the dummy contact 732-11 are disposed at an upper left corner portion of the pixel 2 in the diagram. A Poly-contact 741-2 and the dummy contact 732-12 are disposed at a lower left corner portion in the diagram. A Poly-contact 741-3 and the dummy contact 732-13 are disposed at a lower right corner portion in the diagram.

The twentieth-3rd embodiment can be applied in combination with either one of or both of the twentieth-1st embodiment and the twentieth-2nd embodiment.

It is also possible to employ a configuration in which the Poly-contact 741 and the dummy contact 732 disposed over the inter-pixel isolation portion 81 are fixed at GND. It is also possible to employ a configuration in which the Poly-contact 741 and the dummy contact 732 are disposed also over the element isolation portion 82.

### <Twentieth-4th Embodiment>

FIG. 87 depicts a planar configuration example of the pixel 2 in a twentieth-4th embodiment. FIG. 88 depicts a sectional configuration example of the pixel 2 along line segment B-B' in FIG. 87.

The pixel 2 in the twentieth-4th embodiment is formed into a configuration obtained by adding an interconnect 751 to the pixel 2 in the twentieth-4th embodiment (FIGs. 85 and 86).

In the pixel 2 depicted in FIGs. 87 and 88, the Poly-contacts 741 including Poly-Si are formed with predetermined size and thickness on the inter-pixel isolation portion 81. The dummy contacts 732 are connected to the Poly-contacts 741. The interconnect 751 is connected to the dummy contacts 732. For example, referring to the sectional configuration example of FIG. 88, the Poly-contact 741-1 is formed on the inter-pixel isolation portion 81. In addition, the dummy contact 732-11 is connected onto the Poly-contact 741-1, and the interconnect 751 is connected to the dummy contact 732-11.

Referring to the planar configuration example of FIG. 87, the interconnect 751 is wired to connect the dummy contact 732-11 disposed at an upper left corner portion of the pixel 2 in the diagram, the dummy contact 732-12 disposed at a lower left corner portion in the diagram, and the dummy contact 732-13 disposed at a lower right corner portion in the diagram. Further, the interconnect 751 is wired also onto the second FD portion 55.

In the case in which the interconnect 751 is disposed in such a manner, it is also possible to employ a configuration in which the interconnect 751 is used as part of the second FD portion 55 or the third FD portion 57 to increase the capacitance of the second FD portion 55 or the third FD portion 57.

The interconnect 751 may be disposed in the multilayer interconnect layer stacked on the semiconductor substrate 80, or be formed on the surface (layer) on which the transistors are formed in the semiconductor substrate 80.

The twentieth-4th embodiment can be applied in combination with any or a plurality of embodiments among the twentieth-1st embodiment to the twentieth-3rd embodiment.

### <Examples of Application to Electronic Equipment>

The present technology can be applied to overall pieces of electronic equipment using an imaging element for an image capturing section (photoelectric conversion section), such as imaging apparatuses including digital still cameras, video cameras, and the like, portable terminal apparatuses having an imaging function, and copy machines using an imaging element for an image reading section. The imaging element may have a form formed as one chip, or may have a module-like form which is obtained by integrally packaging an imaging section and a signal processing section or an optical system and has an imaging function.

FIG. 89 is a block diagram depicting a configuration example of an imaging apparatus as electronic equipment to which the present technology is applied.

An imaging element 1000 of FIG. 89 includes an optical section 1001 including a lens group and the like, an imaging element (imaging device) 1002, and a DSP (Digital Signal Processor) circuit 1003 which is a camera signal processing circuit. Further, the imaging element 1000 includes also a frame memory 1004, a display section 1005, a recording section 1006, an operation section 1007, and a power supply section 1008. The DSP circuit 1003, the frame memory 1004, the display section 1005, the recording section 1006, the operation section 1007, and the power supply section 1008 are mutually connected through a bus line 1009.

The optical section 1001 captures incident light (image light) from a subject and forms an image on an imaging surface of the imaging element 1002. The imaging element 1002 converts the light amount of the incident light from which the image is formed on the imaging surface by the optical section 1001 to an electrical signal in units of pixel, and outputs the electrical signal as a pixel signal.

The display section 1005 includes, for example, a thin display such as an LCD (Liquid Crystal Display) or an organic EL (Electro Luminescence) display, and displays a moving image or a still image picked up by the imaging element 1002. The recording section 1006 records the moving image or the still image picked up by the imaging element 1002 in a recording medium such as a hard disk or a semiconductor memory.

The operation section 1007 issues an operation command regarding various functions which the imaging element 1000 has, under operation by a user. The power supply section 1008 provides various power supplies which serve as operation power supplies for the DSP circuit 1003, the frame memory 1004, the display section 1005, the recording section 1006, and the operation section 1007 to these provision targets as appropriate.

The imaging apparatus 1 in the first to ninth embodiments can be applied to part of the imaging apparatus depicted in FIG. 89.

### <Example of Application to Endoscopic Surgery System>

The technology according to an embodiment of the present disclosure (present technology) can be applied to various products. For example, the technology according to an embodiment of the present disclosure may be applied to an endoscopic surgery system.

FIG. 90 is a view depicting an example of a schematic configuration of an endoscopic surgery system to which the technology according to an embodiment of the present disclosure (present technology) can be applied.

In FIG. 90, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrowband light and/or excitation light suitable for special light observation as described above.

FIG. 91 is a block diagram depicting an example of a functional configuration of the camera head 11102 and the CCU 11201 depicted in FIG. 90.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

### <Example of Application to Mobile Body>

The technology according to an embodiment of the present disclosure (present technology) can be applied to various products. For example, the technology according to an embodiment of the present disclosure may be implemented as an apparatus mounted in any kind of mobile body such as an automobile, an electric automobile, a hybrid electric automobile, a motorcycle, a bicycle, a personal mobility vehicle, an airplane, a drone, a ship, or a robot.

FIG. 92 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 92, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 92, an audio speaker 12061, a display section 12062, and an instrument panel 12063 are illustrated as the output device. The display section 12062 may, for example, include at least one of an on-board display and a head-up display.

FIG. 93 is a diagram depicting an example of the installation position of the imaging section 12031.

In FIG. 93, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 93 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

In the present specification, the system represents the whole of an apparatus including a plurality of apparatuses.

It is to be noted that effects described in the present specification are merely examples and are not limited and other effects may exist.

It is to be noted that embodiments of the present technology are not limited to the above-described embodiments and various changes are possible within such a range as not to depart from the gist of the present technology.

It is to be noted that the present technology can also take the following configurations.
(1) An imaging element including:
   a photoelectric conversion portion that converts light to charge;
   an accumulation portion that temporarily accumulates the charge;
   a transfer portion that transfers charge to the accumulation portion;
   an inter-pixel isolation portion that establishes isolation between pixels;
   an element isolation portion that isolates elements; and
   a plurality of transistors disposed to surround the transfer portion in plan view, in which,
   in plan view, in each of the plurality of transistors, a region in which at least one side overlaps with the inter-pixel isolation portion exists and a side opposite the one side includes a region overlapping with the element isolation portion.
(2) The imaging element according to (1) above, in which
   the imaging element includes a plurality of accumulation portions and a plurality of transfer portions which each transfer charge to the plurality of accumulation portions, and
   a second transfer portion other than a first transfer portion that transfers charge from the photoelectric conversion portion to the accumulation portion is disposed around the first transfer portion.
(3) The imaging element according to (1) or (2) above, in which
   part of the element isolation portion is in contact with the inter-pixel isolation portion.
(4) The imaging element according to any one of (1) to (3) above, in which
   the element isolation portion includes an oxide film or a region formed by ion implantation.
(5) The imaging element according to any one of (1) to (4) above, in which
   the plurality of accumulation portions are connected in series, and
   the plurality of accumulation portions accumulate charge transferred from the photoelectric conversion portion and charge that has overflowed from the photoelectric conversion portion.
(6) The imaging element according to any one of (1) to (5) above, in which
   the element isolation portion adjacent to the accumulation portion is formed to a position deeper than the element isolation portion that is not adjacent to the accumulation portion.
(7) The imaging element according to (6) above, in which
   the imaging element includes a plurality of accumulation portions, and at least one of the element isolation portions adjacent to each of the plurality of accumulation portions is formed to be deeper than the other element isolation portions.
(8) The imaging element according to (6) or (7) above, in which
   a depth of the element isolation portion adjacent to the accumulation portion is set to a depth 1.2 to 2.0 times depth of the element isolation portion that is not adjacent to the accumulation portion.
(9) The imaging element according to any one of (6) to (8) above, in which
   a depth of the element isolation portion adjacent to the accumulation portion is a depth depending on a voltage applied to the accumulation portion adjacent and magnitude of capacitance of the accumulation portion.
(10) The imaging element according to any one of (1) to (9) above, further including:
   a control line that controls step-down or step-up of a voltage applied to the accumulation portion.
(11) The imaging element according to (10) above, in which
   the control line executes control to step down the voltage applied to the accumulation portion in an accumulation period of the photoelectric conversion portion.
(12) The imaging element according to (10) or (11) above, in which
   the control line executes control to step up the voltage applied to the accumulation portion in a readout period of a signal from the accumulation portion.
(13) The imaging element according to any one of (10) to (12) above, in which
   the imaging element includes a plurality of accumulation portions, and the control line is connected to at least one or more of the plurality of accumulation portions.
(14) The imaging element according to any one of (1) to (13) above, in which
   the inter-pixel isolation portion in a region in which the inter-pixel isolation portion is in contact with the element isolation portion has an expanded shape in plan view.
(15) The imaging element according to any one of (1) to (13) above, in which
   the element isolation portion in a region in which the inter-pixel isolation portion is in contact with the element isolation portion has an expanded shape in plan view.
(16) The imaging element according to any one of (1) to (15) above, in which
   the inter-pixel isolation portion includes a first layer including polysilicon or metal and a second layer of an oxide film stacked on the first layer.
(17) The imaging element according to (16) above, in which
   a supply voltage is connected to the first layer.
(18) The imaging element according to (2) above, further including:
   an overflow gate that transfers charge that has overflowed from the photoelectric conversion portion between one of the plurality of accumulation portions and the first transfer portion.
(19) The imaging element according to (2) above, further including:
   a region having a potential gradient between one of the plurality of accumulation portions and the first transfer portion.
(20) The imaging element according to any one of (1) to (19) above, in which
   an amplification transistor of a first pixel is connected to the accumulation portion of a second pixel adjacent to the first pixel.
(21) The imaging element according to any one of (1) to (19) above, in which
   an amplification transistor of a first pixel is connected to the accumulation portion of a second pixel adjacent to the first pixel by an interconnect disposed on the inter-pixel isolation portion disposed between the first pixel and the second pixel.
(22) The imaging element according to (21) above, in which
   the amplification transistor of the first pixel is connected to a selection transistor of the second pixel by an interconnect disposed on the inter-pixel isolation portion disposed between the first pixel and the second pixel.
(23) The imaging element according to any one of (1) to (22) above, in which
   a gate electrode of an amplification transistor of a first pixel is disposed to such a position as to connect to the accumulation portion of a second pixel adjacent to the first pixel through over the inter-pixel isolation portion disposed between the first pixel and the second pixel.
(24) The imaging element according to any one of (1) to (22) above, in which
   a gate electrode of an amplification transistor of a first pixel is connected to the accumulation portion of a second pixel adjacent to the first pixel by a contact including polysilicon disposed to such a position as to connect to the accumulation portion of the second pixel through over the inter-pixel isolation portion disposed between the first pixel and the second pixel.
(25) The imaging element according to (23) above, in which
   the gate electrode of the amplification transistor of the first pixel is connected to a side surface of the accumulation portion of the second pixel adjacent to the first pixel in a region obtained by trenching in the second pixel.
(26) The imaging element according to any one of (1) to (25) above, further including:
   a contact on a gate electrode of each of the plurality of transistors.
(27) The imaging element according to any one of (1) to (25) above, in which
   the imaging element includes a plurality of contacts on the inter-pixel isolation portion, and
   the plurality of contacts are connected to the accumulation portion.
(28) Electronic equipment including:
   an imaging element including
   a photoelectric conversion portion that converts light to charge,
   an accumulation portion that temporarily accumulates the charge,
   a transfer portion that transfers charge to the accumulation portion,
   an inter-pixel isolation portion that establishes isolation between pixels,
   an element isolation portion that isolates elements, and
   a plurality of transistors disposed to surround the transfer portion in plan view,
   in plan view, in each of the plurality of transistors, a region in which at least one side overlaps with the inter-pixel isolation portion exists and a side opposite the one side including a region overlapping with the element isolation portion; and
   a processing section that processes a signal from the imaging element.

### [Reference Signs List]

- 1:: Imaging apparatus
- 2:: Pixel
- 3:: Pixel array unit
- 4:: Vertical drive circuit
- 5:: Column signal processing circuit
- 6:: Horizontal drive circuit
- 7:: Output circuit
- 8:: Control circuit
- 9:: Vertical signal line
- 10:: Pixel drive line
- 11:: Horizontal signal line
- 13:: Input/output terminal
- 31:: Selection transistor
- 51:: Photoelectric conversion portion
- 52:: First transfer transistor
- 53:: First FD portion
- 54:: Second transfer transistor
- 55:: Second FD portion
- 56:: Third transfer transistor
- 57:: Third FD portion
- 58:: Reset transistor
- 59:: Amplification transistor
- 60:: Selection transistor
- 61:: Photoelectric conversion portion
- 71:: VDD region
- 72:: VSL region
- 73:: VSS region
- 80:: Semiconductor substrate
- 81:: Inter-pixel isolation portion
- 82:: Element isolation portion
- 101:: Semiconductor region
- 102:: Semiconductor region
- 104:: Channel
- 105:: Region
- 106:: Channel
- 107, 108, 109, 110:: Pinning film
- 111:: Region
- 112:: Region
- 131:: Element isolation portion
- 132:: Inter-pixel isolation portion
- 151:: Contact
- 201:: Overflow transistor
- 301,: 302, 303: Coupling line
- 311,: 312, 313: Capacitive element

## Claims

1. An imaging element comprising:
a photoelectric conversion portion that converts light to charge;
an accumulation portion that temporarily accumulates the charge;
a transfer portion that transfers charge to the accumulation portion;
an inter-pixel isolation portion that establishes isolation between pixels;
an element isolation portion that isolates elements; and
a plurality of transistors disposed to surround the transfer portion in plan view, wherein,
in plan view, in each of the plurality of transistors, a region in which at least one side overlaps with the inter-pixel isolation portion exists and a side opposite the one side includes a region overlapping with the element isolation portion.

2. The imaging element according to claim 1, wherein
the imaging element includes a plurality of accumulation portions and a plurality of transfer portions which each transfer charge to the plurality of accumulation portions, and
a second transfer portion other than a first transfer portion that transfers charge from the photoelectric conversion portion to the accumulation portion is disposed around the first transfer portion.

3. The imaging element according to claim 1, wherein
part of the element isolation portion is in contact with the inter-pixel isolation portion.

4. The imaging element according to claim 1, wherein
the element isolation portion includes an oxide film or a region formed by ion implantation.

5. The imaging element according to claim 1, wherein
the plurality of accumulation portions are connected in series, and
the plurality of accumulation portions accumulate charge transferred from the photoelectric conversion portion and charge that has overflowed from the photoelectric conversion portion.

6. The imaging element according to claim 1, wherein
the element isolation portion adjacent to the accumulation portion is formed to a position deeper than the element isolation portion that is not adjacent to the accumulation portion.

7. The imaging element according to claim 6, wherein
the imaging element includes a plurality of accumulation portions, and at least one of the element isolation portions adjacent to each of the plurality of accumulation portions is formed to be deeper than the other element isolation portions.

8. The imaging element according to claim 6, wherein
a depth of the element isolation portion adjacent to the accumulation portion is set to a depth 1.2 to 2.0 times depth of the element isolation portion that is not adjacent to the accumulation portion.

9. The imaging element according to claim 6, wherein
a depth of the element isolation portion adjacent to the accumulation portion is a depth depending on a voltage applied to the accumulation portion adjacent and magnitude of capacitance of the accumulation portion.

10. The imaging element according to claim 1, further comprising:
a control line that controls step-down or step-up of a voltage applied to the accumulation portion.

11. The imaging element according to claim 10, wherein
the control line executes control to step down the voltage applied to the accumulation portion in an accumulation period of the photoelectric conversion portion.

12. The imaging element according to claim 10, wherein
the control line executes control to step up the voltage applied to the accumulation portion in a readout period of a signal from the accumulation portion.

13. The imaging element according to claim 10, wherein
the imaging element includes a plurality of accumulation portions, and the control line is connected to at least one or more of the plurality of accumulation portions.

14. The imaging element according to claim 1, wherein
the inter-pixel isolation portion in a region in which the inter-pixel isolation portion is in contact with the element isolation portion has an expanded shape in plan view.

15. The imaging element according to claim 1, wherein
the element isolation portion in a region in which the inter-pixel isolation portion is in contact with the element isolation portion has an expanded shape in plan view.

16. The imaging element according to claim 1, wherein
the inter-pixel isolation portion includes a first layer including polysilicon or metal and a second layer of an oxide film stacked on the first layer.

17. The imaging element according to claim 16, wherein
a supply voltage is connected to the first layer.

18. The imaging element according to claim 2, further comprising:
an overflow gate that transfers charge that has overflowed from the photoelectric conversion portion between one of the plurality of accumulation portions and the first transfer portion.

19. The imaging element according to claim 2, further comprising:
a region having a potential gradient between one of the plurality of accumulation portions and the first transfer portion.

20. The imaging element according to claim 1, wherein
an amplification transistor of a first pixel is connected to the accumulation portion of a second pixel adjacent to the first pixel.

21. The imaging element according to claim 1, wherein
an amplification transistor of a first pixel is connected to the accumulation portion of a second pixel adjacent to the first pixel by an interconnect disposed on the inter-pixel isolation portion disposed between the first pixel and the second pixel.

22. The imaging element according to claim 21, wherein
the amplification transistor of the first pixel is connected to a selection transistor of the second pixel by an interconnect disposed on the inter-pixel isolation portion disposed between the first pixel and the second pixel.

23. The imaging element according to claim 1, wherein
a gate electrode of an amplification transistor of a first pixel is disposed to such a position as to connect to the accumulation portion of a second pixel adjacent to the first pixel through over the inter-pixel isolation portion disposed between the first pixel and the second pixel.

24. The imaging element according to claim 1, wherein
a gate electrode of an amplification transistor of a first pixel is connected to the accumulation portion of a second pixel adjacent to the first pixel by a contact including polysilicon disposed to such a position as to connect to the accumulation portion of the second pixel through over the inter-pixel isolation portion disposed between the first pixel and the second pixel.

25. The imaging element according to claim 23, wherein
the gate electrode of the amplification transistor of the first pixel is connected to a side surface of the accumulation portion of the second pixel adjacent to the first pixel in a region obtained by trenching in the second pixel.

26. The imaging element according to claim 1, further comprising:
a contact on a gate electrode of each of the plurality of transistors.

27. The imaging element according to claim 1, wherein
the imaging element includes a plurality of contacts on the inter-pixel isolation portion, and
the plurality of contacts are connected to the accumulation portion.

28. Electronic equipment comprising:
an imaging element including
a photoelectric conversion portion that converts light to charge,
an accumulation portion that temporarily accumulates the charge,
a transfer portion that transfers charge to the accumulation portion,
an inter-pixel isolation portion that establishes isolation between pixels,
an element isolation portion that isolates elements, and a plurality of transistors disposed to surround the transfer portion in plan view, wherein,
in plan view, in each of the plurality of transistors, a region in which at least one side overlaps with the inter-pixel isolation portion exists and a side opposite the one side including a region overlapping with the element isolation portion; and
a processing section that processes a signal from the imaging element.
